# EUROPEAN PATENT APPLICATION

(11) **EP 1 693 704 A2**
(43) Date of publication of application: **23.08.2006**
(21) Application number: 06001970.0
(22) Date of filing: 31.01.2006
(51) Int. Cl.: G03F 7/004, G03F 7/038, G03F 7/039

(54) **Resist composition and pattern forming method using the same**

(30) Priority: 02.02.2005 JP 2005026780
(71) Applicant: FUJI PHOTO FILM CO., LTD., Minami-Ashigara-shi, Kanagawa-ken (JP)
(72) Inventor: Mizutani, Kazuyoshi, Yoshida-cho Haibara-gun Shizuoka (JP)
(74) Representative: HOFFMANN EITLE

(57) **Abstract**

A resist composition comprising (A) an acid generator represented by formula (1): 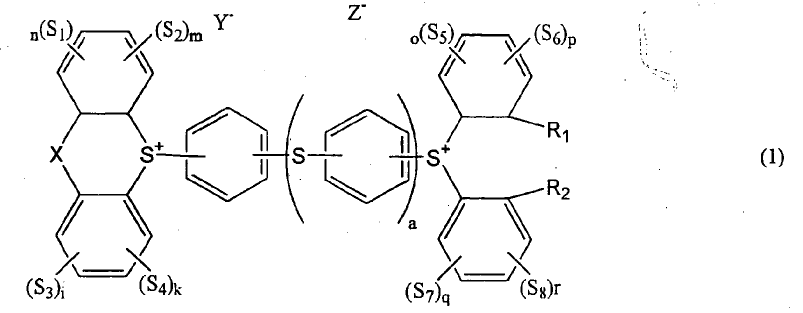 wherein S₁ to S₈ each independently represents a substituent; a, n, m, l, k, o, p, q and r each independently represents an integer of 0 to 2; X represents a single bond or a divalent linking group; R₁ and R₂ each independently represents a hydrogen atom or a substituent, and R₁ and R₂ may combine with each other to represent a single bond or a divalent linking group; and Y⁻ and Z⁻ each independently represents an organic sulfonate anion.

## Description

### Background of the Invention

### 1. Field of the Invention

The present invention relates to a resist composition suitably used in the ultramicrolithography process such as production of VLSI or high-capacity microchip or in other photofabrication processes. More specifically, the present invention relates to a positive resist composition and a negative resist composition, which can form a highly refined pattern with use of an electron beam, EUV or an X-ray.

### 2. Description of the Related Art

Recently, the integration degree of an integrated circuit is increasing and formation of an ultrafine pattern having a line width of half-micron or less is required in the production of a semiconductor substrate such as VLSI. To meet this requirement, the wavelength used in an exposure apparatus employed for photolithography becomes shorter and shorter. At present, far ultraviolet light or excimer laser light (e.g., XeCl, KrF, ArF) is being studied. Furthermore, studies on the formation of a finer pattern by an electron beam or an X-ray are also proceeding.

The electron beam lithography is positioned as a pattern formation technique of the next generation or next-next generation, and development of a positive resist and a negative resist which can attain high sensitivity, high resolution and rectangular profile shape is keenly demanded.

According to the electron beam lithography, in the course of an accelerated electron beam causing collision scattering with the atoms constituting a resist material, an energy is supplied to the compound to bring about a reaction of the resist material and thereby form an image. Use of a highly accelerated electron beam yields increase in the straight-going property and decrease in the effect of electron scattering, and a high-resolution rectangular pattern with good edge roughness can be formed, but on the other hand, the electron beam transmissivity is elevated and the sensitivity is lowered. In this way, there is a trade-off relationship in the sensitivity, resolution-resist shape, dissolution contrast and edge roughness, and it is a problem to be solved how these can be satisfied at the same time. The lithography using EUV or an X-ray also has the same problems.

With respect to the positive resist for use with an electron beam or an X-ray, a resist technique for a KrF excimer laser has been heretofore mainly used and studied. On the other hand, as for the negative resist, an alkali-soluble resin has been proposed. Furthermore, various compounds capable of generating an acid by the effect of an electron beam or an X-ray have been conventionally proposed. An iodonium salt and a sulfonium salt are disclosed, for example, in JP-A-6-199770 (the term "JP-A" as used herein means an "unexamined published Japanese patent application"), a diazodisulfone compound and a diazosulfone compound are disclosed in JP-A-4-210960 and JP-A-4-217249, and a sulfonate compound is disclosed, for example, in JP-A-3-87746. Also, in recent years, a compound capable of generating an acid is described, for example, in JP-A-2004-101645.

Particularly, in the case of irradiating a high-energy ray such as EUV light, the outgas problem that the compound in the resist film is destroyed by fragmentation and volatizes as a low molecular component during exposure to contaminate the environment in the exposure apparatus, becomes prominent and at the same time, the development defect increases. The outgas degree is compared by the percentage variation of the resist film thickness between before and after exposure.

In this way, the conventionally known resist can hardly possess various performances at the same time, such as sufficiently high sensitivity and high resolution, reduction in the outgas (vaporized product from the resist film during exposure), and surface roughness of the resist pattern (roughness on the surface of the resist pattern top after development). It is strongly demanded to satisfy all of these performances.

### Summary of the Invention

An object of the present invention is to solve the technical problem of enhancing the performance in the fine processing of a semiconductor device and provide a resist composition satisfying all the requirements regarding sufficiently high sensitivity and high resolution, reduction in the outgas (vaporized product from the resist film during exposure) and surface roughness of the resist pattern (roughness on the surface of the resist pattern top after development).

As a result of intensive investigations, the present inventors have found that the above-described object can be attained by a resist composition containing a specific acid generator. The present invention has been accomplished based on this finding.

That is, the present invention is attained by the following constitutions.
(1) A resist composition comprising (A) an acid generator represented by formula (1): 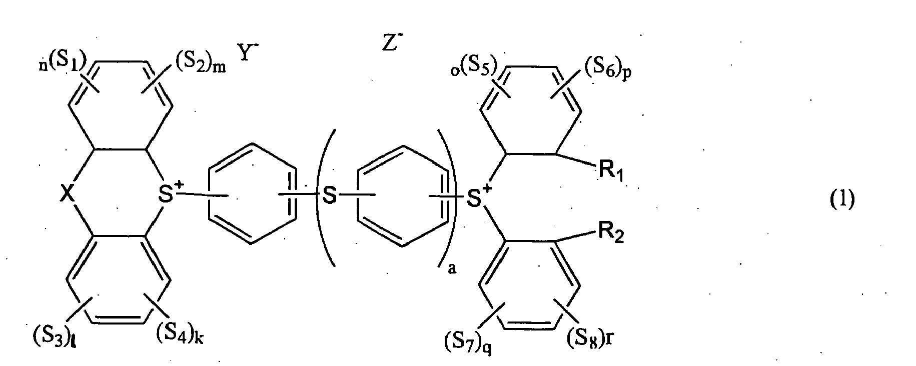 wherein S₁ to S₈ each independently represents a substituent;
   a, n, m, 1, k, o, p, q and r each independently represents an integer of 0 to 2;
   X represents a single bond or a divalent linking group;
   R₁ and R₂ each independently represents a hydrogen atom or a substituent, and R₁ and R₂ may combine with each other to represent a single bond or a divalent linking group; and
   Y⁻ and Z⁻ each independently represents an organic sulfonate anion.
(2) The resist composition as described in (1) above, which is a positive resist composition, and the resist composition further comprising (BP) a polymer which is insoluble or sparingly soluble in an aqueous alkali solution but becomes soluble in an aqueous alkali solution under an action of an acid.
(3) The resist composition as described in (1) above, which is a negative resist composition, and the resist composition further comprising: (BN) an alkali-soluble resin; and (C) a crosslinking agent capable of crosslinking by an effect of an acid.
(4) The resist composition as described in any of (1) to (3) above, further comprising (A2) a compound having a structure represented by one of formulae (I) to (III), which generates an acid upon irradiation with one of an actinic ray and radiation: 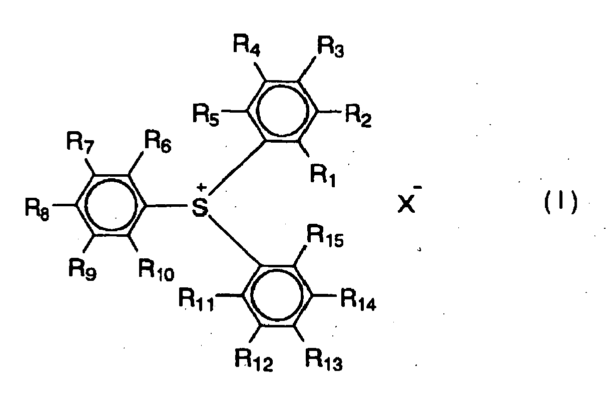 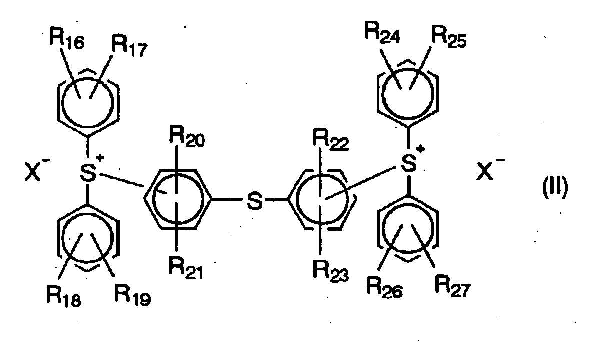 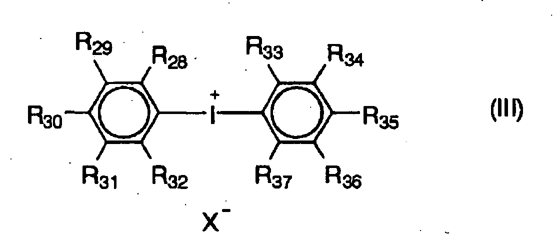 wherein R₁ to R₃₇, which may be the same or different, each independently represents a hydrogen atom, an alkyl group, an alkoxy group, a hydroxyl group, a halogen atom or an -S-R₃₈ group, and wherein R₃₈ represents an alkyl group or an aryl group; and
   X⁻ represents an alkylsulfonate, a benzenesulfonate, a naphthalenesulfonate or an anthracenesulfonate anion each having at least one selected from the group consisting of
   at least one fluorine atom,
   an alkyl group substituted with at least one fluorine atom,
   an alkoxy group substituted with at least one fluorine atom,
   an acyl group substituted with at least one fluorine atom,
   an acyloxy group substituted with at least one fluorine atom,
   a sulfonyl group substituted with at least one fluorine atom,
   a sulfonyloxy group substituted with at least one fluorine atom,
   a sulfonylamino group substituted with at least one fluorine atom,
   an aryl group substituted with at least one fluorine atom,
   an aralkyl group substituted with at least one fluorine atom, and
   an alkoxycarbonyl group substituted with at least one fluorine atom.
(5) The resist composition as described in any of (2) to (4) above, further comprising at least one of (A3) a compound capable of generating a fluorine-containing carboxylic acid upon irradiation with one of an actinic ray and radiation and (A4) a compound capable of generating a fluorine-free carboxylic acid upon irradiation with one of an actinic ray and radiation.
(6) The resist composition as described in any of (1) to (5) above, which is utilized with an electron beam, EUV or an X-ray.
(7) A pattern forming method comprising:
   forming a resist film from a resist composition as described in any of (1) to (6) above; and
   exposing and developing the resist film.

### Detailed Description of the Invention

The present invention is described in detail below.

In the present invention, when a group (atomic group) is denoted without specifying whether substituted or unsubstituted, the group includes a group having no substituent and a group having a substituent. For example, an "alkyl group" includes not only an alkyl group having no substituent (unsubstituted alkyl group) but also an alkyl group having a substituent (substituted alkyl group).

### (A1) Acid Generator Represented by Formula (1)

In the present invention, a compound represented by formula (1) is used as the compound capable of generating an acid upon irradiation of actinic rays or radiation (sometimes referred to as a "component (A1)" or "compound of (A1)"). 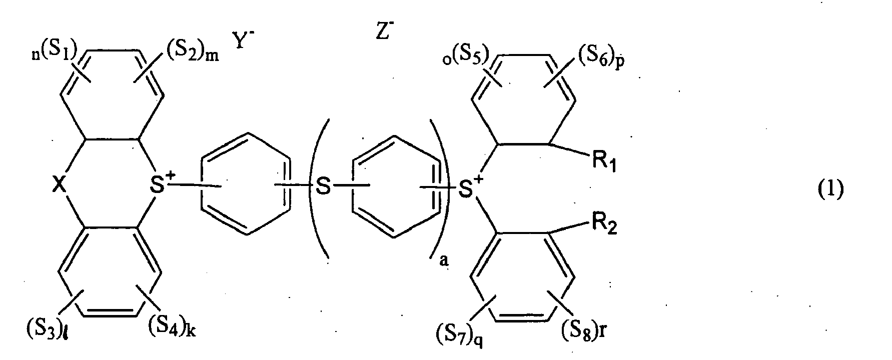 wherein
S₁ to S₈ each independently represents a substituent,
a, n, m,1, k, o, p, q and r each independently represents an integer of 0 to 2,
X represents a single bond or a divalent linking group,
R₁ and R₂ each independently represents a hydrogen atom or a substituent, and R₁ and R₂ may combine with each other to represent a single bond or a divalent linking group, and
Y⁻ and Z⁻ each independently represents an organic sulfonate anion.

Examples of the group represented by R₁, R₂ and S₁ to S₈ include an aryl group, an alkyl group, a cycloalkyl group, an alkoxyl group, a carboxyl group, a hydroxyl group, a halogen atom (e.g., fluorine, chlorine, bromine, iodine), a cyano group, a nitro group, an arylcarbonyl group and an alkylcarbonyl group.

The alkyl group is, for example, an alkyl group having a carbon number of 1 to 30, and specific examples thereof include a methyl group, an ethyl group, a propyl group, an isopropyl group, an n-butyl group, an isobutyl group, a sec-butyl group, a pentyl group, a neopentyl group, a hexyl group, a heptyl group, an octyl group, a nonyl group, a decyl group, an undecyl group, a dodecyl group, a tridecyl group, a tetradecyl group, a pentadecyl group, a hexadecyl group, a heptadecyl group, an octadecyl group, a nonadecyl group and an eicosyl group.

The cycloalkyl group is, for example, a cycloalkyl group having a carbon number of 3 to 30, and specific examples thereof include a cyclopropyl group, a cyclopentyl group, a cyclohexyl group, an adamantyl group, a norbornyl group and a boronyl group.

The aryl group includes, for example, a phenyl group, a naphthyl group and an anthracenyl group.

These groups each may further have a substituent, and examples of the substituent which each group may further have include a halogen atom, an alkyl group having a carbon number of 1 to 8, an alkoxy group having a carbon number of 1 to 8, a nitro group, a cyano group, an alkylcarbonyl group having a carbon number of 2 to 8, an arylcarbonyl group having a carbon number of 7 to 11, and a carboxylic acid ester group having a carbon number of 2 to 10. Among these substituents, preferred is an alkyl group having a carbon number of 1 to 8, and more preferred are a methyl group, an ethyl group, an i-propyl group, an n-propyl group, a tert-butyl group, an i-butyl group, an n-butyl group, a tert-amyl group, a cyclopentyl group, an n-hexyl group, a cyclohexyl group, an n-octyl group and a 2-ethylhexyl group.

The divalent linking group represented by X and the divalent linking group which may be formed by combining R₁ and R₂ each is preferably an alkylene group, an oxygen atom or a sulfur atom. X is preferably a single bond or a sulfur atom.

Examples of the organic sulfonate anion of Y⁻ and Z⁻ include an aliphatic sulfonate anion, an aromatic sulfonate anion and a camphorsulfonate anion.

The aliphatic group in the aliphatic sulfonate anion is preferably an alkyl group having a carbon number of 1 to 30, and examples thereof include a methyl group, an ethyl group, a propyl group, an isopropyl group, an n-butyl group, an isobutyl group, a sec-butyl group, a pentyl group, a neopentyl group, a hexyl group, a heptyl group, an octyl group, a nonyl group, a decyl group, an undecyl group, a dodecyl group, a tridecyl group, a tetradecyl group, a pentadecyl group, a hexadecyl group, a heptadecyl group, an octadecyl group, a nonadecyl group, an eicosyl group, a cyclopropyl group, a cyclopentyl group, a cyclohexyl group, an adamantyl group, a norbornyl group and a boronyl group.

The aromatic group in the aromatic sulfonate anion is preferably an aryl group having a carbon number of 6 to 14, and examples thereof include a phenyl group, a tolyl group and a naphthyl group.

The aliphatic group and aromatic group in the aliphatic sulfonate anion and aromatic sulfonate anion each may have a substituent.

Examples of the substituent include a halogen atom, an alkyl group, an alkoxy group and an alkylthio group.

Examples of the halogen atom include a chlorine atom, a bromine atom, a fluorine atom and an iodine atom.

The alkyl group is preferably, for example, an alkyl group having a carbon number of 1 to 15, and examples thereof include a methyl group, an ethyl group, a propyl group, an isopropyl group, an n-butyl group, an isobutyl group, a sec-butyl group, a pentyl group, a neopentyl group, a hexyl group, a heptyl group, an octyl group, a nonyl group, a decyl group, an undecyl group, a dodecyl group, a tridecyl group, a tetradecyl group, a pentadecyl group, a hexadecyl group, a heptadecyl group, an octadecyl group, a nonadecyl group and an eicosyl group.

The alkoxy group is preferably, for example, an alkoxy group having a carbon number of 1 to 5, and examples thereof include a methoxy group, an ethoxy group, a propoxy group and a butoxy group.

The alkylthio group is preferably, for example, an alkylthio group having a carbon number of 1 to 15, and examples thereof include a methylthio group, an ethylthio group, a propylthio group, an isopropylthio group, an n-butylthio group, an isobutylthio group, a secbutylthio group, a pentylthio group, a neopentylthio group, a hexylthio group, a heptylthio group, an octylthio group, a nonylthio group, a decylthio group, an undecylthio group, a dodecylthio group, a tridecylthio group, a tetradecylthio group, a pentadecylthio group, a hexadecylthio group, a heptadecylthio group, an octadecylthio group, a nonadecylthio group and an eicosylthio group. The alkyl group, alkoxy group and allcylthio group each may be further substituted with a halogen atom (preferably a fluorine atom).

The organic sulfonate anion of Y⁻ is preferably a sulfonic acid substituted with fluorine at the 1-position, more preferably a perfluoroalkanesulfonic acid.

A benzenesulfonic acid substituted with a fluorine atom or a substituent having a fluorine atom is also preferred as the organic sulfonate anion of Y.

These groups each may further have a substituent, and examples of the substituent which each group may further have include an aryl group, an alkyl group, a cycloalkyl group, an alkoxy group, a carboxyl group, a hydroxyl group, a halogen atom (e.g., fluorine, chlorine, bromine, iodine), a cyano group, a nitro group, an arylcarbonyl group and an alkylcarbonyl group. In view of reduction potential, the substituent which Y may have is preferably an electron-withdrawing substituent, that is, a halogen atom (e.g., fluorine, chlorine, bromine, iodine), a cyano group, a nitro group, an arylcarbonyl group or an alkylcarbonyl group.

Specific examples of the compound represented by formula (1) are set forth below, but the present invention is not limited thereto.

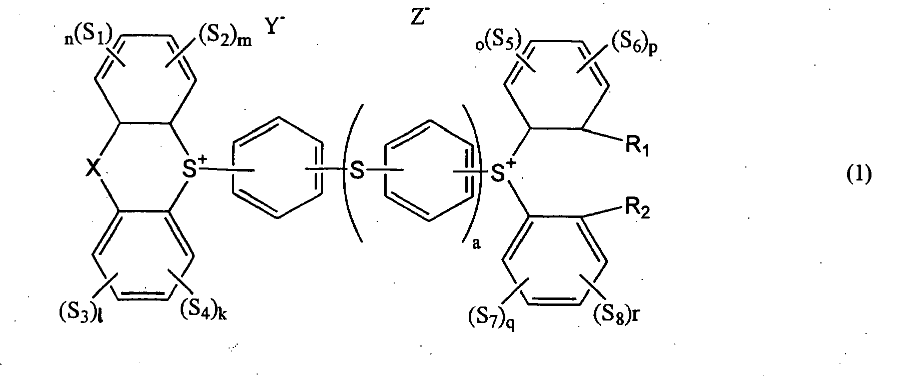

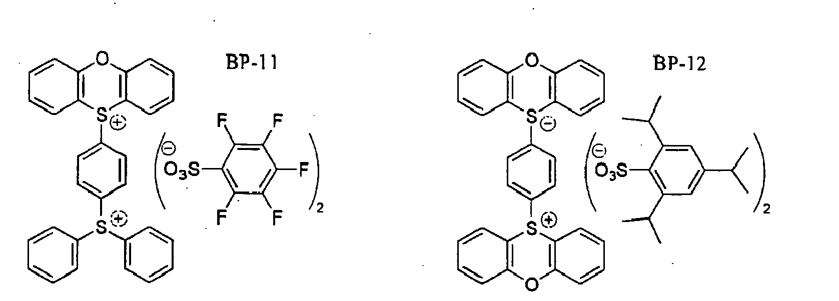

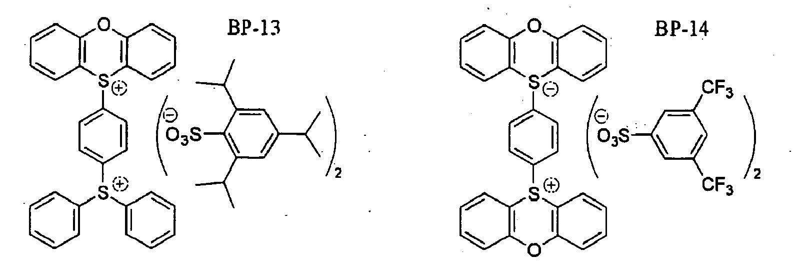

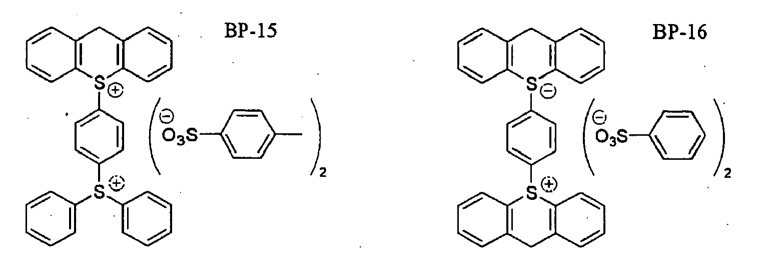

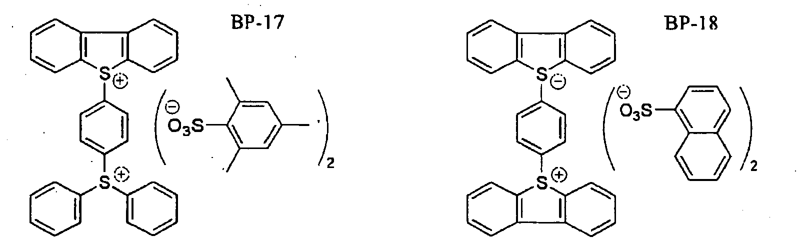

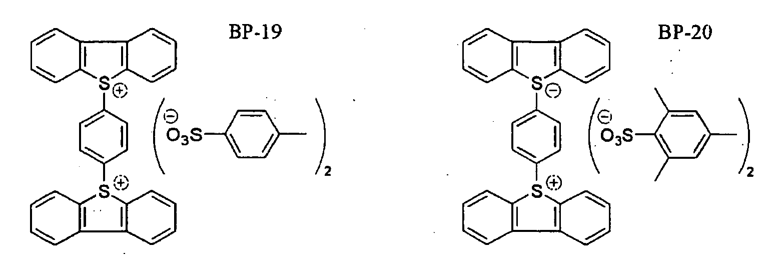

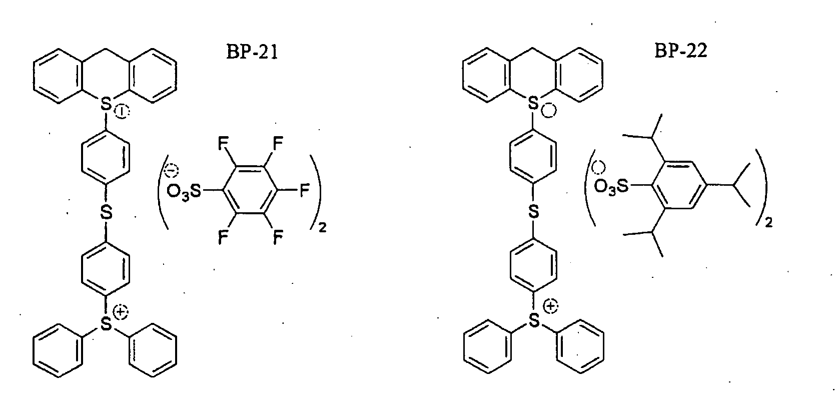

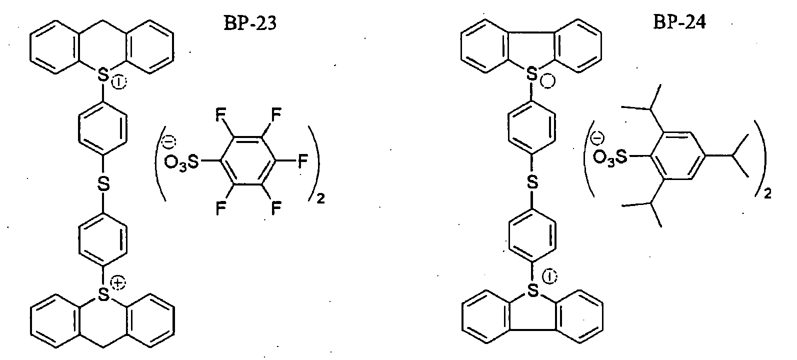

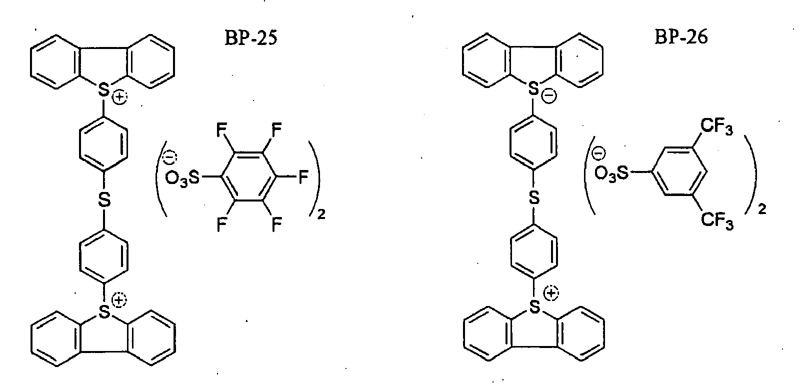

In the present invention, the compound represented by formula (1) can be synthesized by reacting benzothiophene oxide with a magnesium bromide form (Grignard's reagent) derived from p-dibromobenzene.

In the present invention, the content of the compound represented by formula (1) in the composition is suitably from 0.5 to 20 mass%, preferably from 1 to 15 mass%, more preferably from 2 to 10 mass%, based on the solid content of the entire resist composition. (In this specification, mass% and parts by mass are equal to weight% and parts by weight, respectively.)

### (A2) Compound having a structure represented by any one of formulae (I) to (III), which generates an acid upon irradiation of actinic rays or radiation (sometimes referred to as a "component (A2)" or a "compound of (A2)")

The resist composition of the present invention may further contain a compound of (A2) as the acid generator.

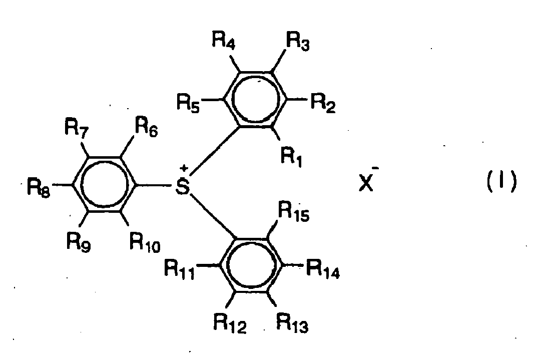

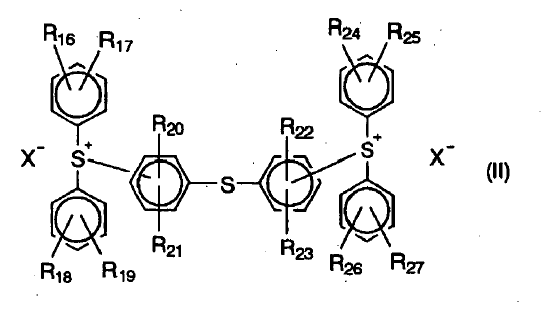

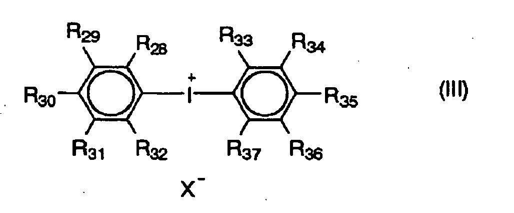

In formulae (I) to (III), R₁ to R₃₇, which may be the same or different, each represents a hydrogen atom, an alkyl group, a cycloalkyl group, an alkoxy group, a hydroxyl group, a halogen atom or an -S-R₃₈ group (wherein R₃₈ represents an alkyl group or an aryl group).

The alkyl group of R₁ to R₃₈ may be either linear or branched and includes an alkyl group having a carbon number of 1 to 4, which may have a substituent, such as methyl group, ethyl group, propyl group, n-butyl group, sec-butyl group and tert-butyl group.

The cycloalkyl group of R₁ to R₃₈ includes a cycloalkyl group having a carbon number of 3 to 8, which may have a substituent, such as cyclopropyl group, cyclopentyl group and cyclohexyl group.

The alkoxy group of R₁ to R₃₇ may be linear, branched or cyclic, and the linear or branched alkyl group includes, for example, an alkoxy group having a carbon number of 1 to 8, such as methoxy group, ethoxy group, hydroxyethoxy group, propoxy group, n-butoxy group, isobutoxy group, sec-butoxy group, tert-butoxy group and octyloxy group, which groups each may further have a substituent. The cyclic alkoxy group includes, for example, a cyclopentyloxy group and a cyclohexyloxy group, which groups each may further have a substituent.

The halogen atom of R₁ to R₃₇ includes a fluorine atom, a chlorine atom, a bromine atom and an iodine atom.

The aryl group of R₃₈ includes, for example, an aryl group having a carbon number of 6 to 14, which may have a substituent, such as phenyl group, tolyl group, methoxyphenyl group and naphthyl group.

Preferred examples of the substituent for these groups include an alkyl group, a cycloalkyl group, an alkoxy group having a carbon number of 1 to 4, a halogen atom (e.g., fluorine, chlorine, iodine), an aryl group having a carbon number of 6 to 10, an alkenyl group having a carbon number of 2 to 6, a cyano group, a hydroxy group, a carboxy group, an alkoxycarbonyl group and a nitro group.

In formulae (I) to (III), X is an alkylsulfonate, benzenesulfonate, naphthalenesulfonate or anthracenesulfonate anion each having at least one species selected from the groups shown below:
at least one fluorine atom,
an alkyl group substituted with at least one fluorine atom,
an alkoxy group substituted with at least one fluorine atom,
an acyl group substituted with at least one fluorine atom,
an acyloxy group substituted with at least one fluorine atom,
a sulfonyl group substituted with at least one fluorine atom,
a sulfonyloxy group substituted with at least one fluorine atom,
a sulfonylamino group substituted with at least one fluorine atom,
an aryl group substituted with at least one fluorine atom,
an aralkyl group substituted with at least one fluorine atom, and
an alkoxycarbonyl group substituted with at least one fluorine atom.

The alkyl group in X⁻ may be linear, branched or cyclic and is preferably an alkyl group having a carbon number of 1 to 12 and being substituted with 1 to 25 fluorine atoms.

Specific examples thereof include a trifluoromethyl group, a pentafluoroethyl group, a 2,2,2-trifluoroethyl group, a heptafluoropropyl group, a heptafluoroisopropyl group, a perfluorobutyl group, a perfluorooctyl group, a perfluorododecyl group and a perfluorocyclohexyl group. Among these, a perfluoroalkyl group having a carbon number of 1 to 4, in which all hydrogen atoms are substituted with fluorine, is preferred, and a perfluorobutyl group is more preferred.

The alkoxyl group in X⁻ may be linear, branched or cyclic and is preferably an alkoxy group having a carbon number of 1 to 12 and being substituted with 1 to 25 fluorine atoms.

Specific examples thereof include a trifluoromethoxy group, a pentafluoroethoxy group, a heptafluoroisopropyloxy group, a perfluorobutoxy group, a perfluorooctyloxy group, a perfluorododecyloxy group and a perfluorocyclohexyloxy group. Among these, a perfluoroalkoxy group having a carbon number of 1 to 4, in which all hydrogen atoms are substituted with fluorine, is preferred.

The acyl group in X⁻ is preferably an acyl group having a carbon number of 2 to 12 and being substituted with 1 to 23 fluorine atoms. Specific examples thereof include a trifluoroacetyl group, a fluoroacetyl group, a pentafluoropropionyl group and a pentafluorobenzoyl group.

The acyloxy group in X is preferably an acyloxy group having a carbon number of 2 to 12 and being substituted with 1 to 23 fluorine atoms. Specific examples thereof include a trifluoroacetoxy group, a fluoroacetoxy group, a pentafluoropropionyloxy group and a pentafluorobenzoyloxy group.

The sulfonyl group in X⁻ is preferably a sulfonyl group having a carbon number of 1 to 12 and being substituted with 1 to 25 fluorine atoms. Specific examples thereof include a trifluoromethanesulfonyl group, a pentafluoroethanesulfonyl group, a perfluorobutanesulfonyl group, a perfluorooctanesulfonyl group, a pentafluorobenzenesulfonyl group and a 4-trifluoromethylbenzenesulfonyl group.

The sulfonyloxy group in X⁻ is preferably a sulfonyloxy group having a carbon number of 1 to 12 and being substituted with 1 to 25 fluorine atoms. Specific examples thereof include a trifluoromethanesulfonyloxy group, a perfluorobutanesulfonyloxy group and a 4-trifluoromethylbenzenesulfonyloxy group.

The sulfonylamino group in X⁻ is preferably a sulfonylamino group having a carbon number of 1 to 12 and being substituted with 1 to 25 fluorine atoms. Specific examples thereof include a trifluoromethanesulfonylamino group, a perfluorobutanesulfonylamino group, a perfluorooctanesulfonylamino group and a pentafluorobenzenesulfonylamino group.

The aryl group in X⁻ is preferably an aryl group having a carbon number of 6 to 14 and being substituted with 1 to 9 fluorine atoms. Specific examples thereof include a pentafluorophenyl group, a 4-trifluoromethylphenyl group, a heptafluoronaphthyl group, a nonafluoroanthranyl group, a 4-fluorophenyl group and a 2,4-difluorophenyl group.

The aralkyl group in X⁻ is preferably an aralkyl group having a carbon number of 7 to 10 and being substituted with 1 to 15 fluorine atoms. Specific examples thereof include a pentafluorophenylmethyl group, a pentafluorophenylethyl group, a perfluorobenzyl group and a perfluorophenethyl group.

The alkoxycarbonyl group in X- is preferably an alkoxycarbonyl group having a carbon number of 2 to 13 and being substituted with 1 to 25 fluorine atoms. Specific examples thereof include a trifluoromethoxycarbonyl group, a pentafluoroethoxycarbonyl group, a pentafluorophenoxycarbonyl group, a perfluorobutoxycarbonyl group and a perfluorooctyloxycarbonyl group.

X⁻ is preferably a fluorine-substituted benzenesulfonate anion, more preferably a pentafluorobenzenesulfonate anion.

The alkylsulfonic acid, benzenesulfonic acid, naphthalenesulfonic acid or anthracenesulfonic acid having such a fluorine-containing substituent may be further substituted with, for example, a linear, branched or cyclic alkoxyl group, an acyl group, an acyloxy group, a sulfonyl group, a sulfonyloxy group, a sulfonylamino group, an aryl group, an aralkyl group, an alkoxycarbonyl group (the carbon number range of each of these groups is the same as that described above), a halogen (excluding fluorine), a hydroxyl group or a nitro group.

Specific examples of the compounds represented by formulae (I) to (III) are set forth below, but the present invention is not limited thereto.

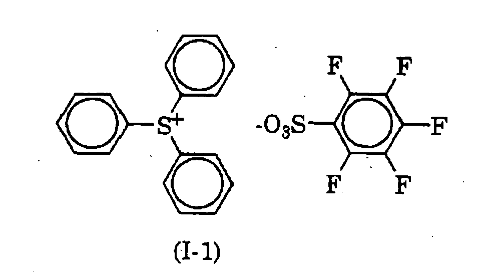

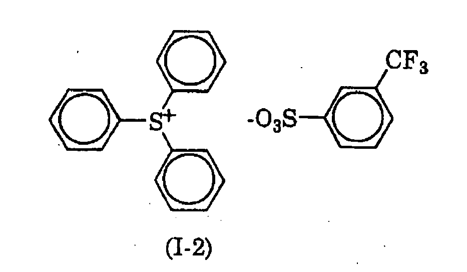

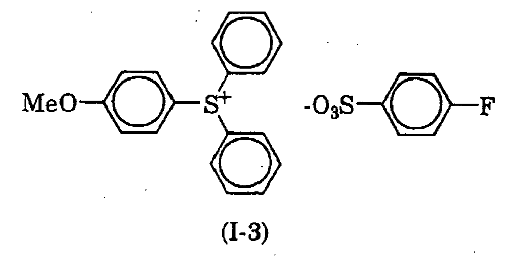

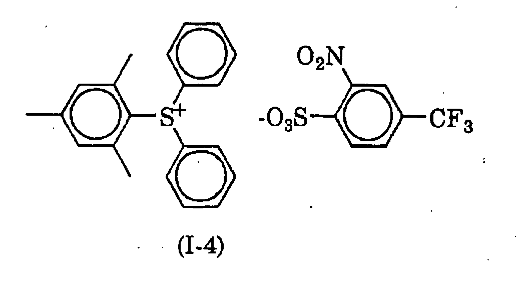

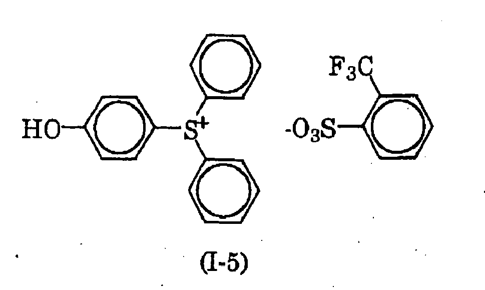

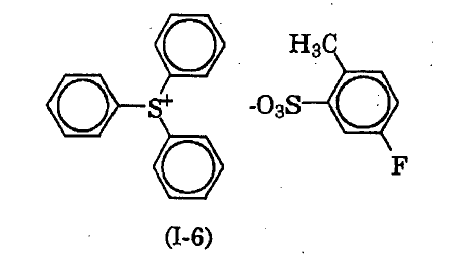

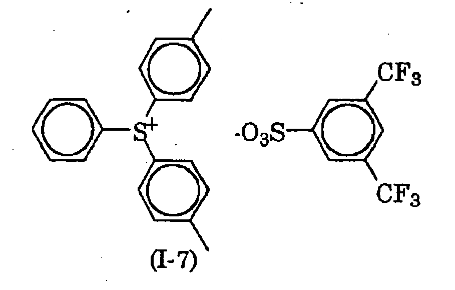

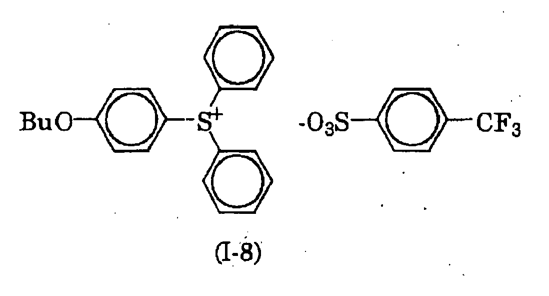

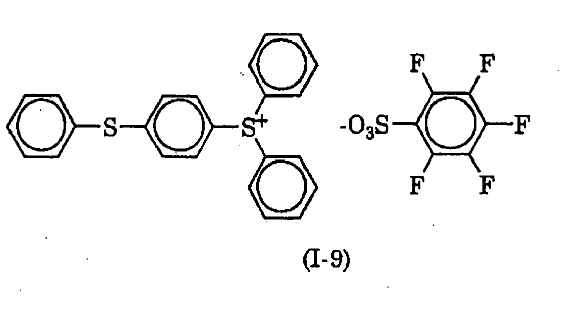

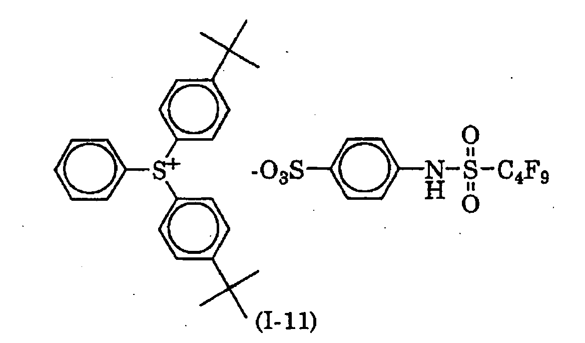

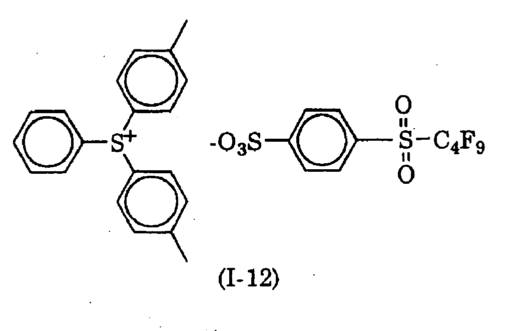

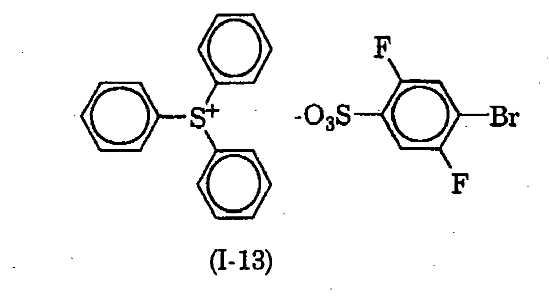

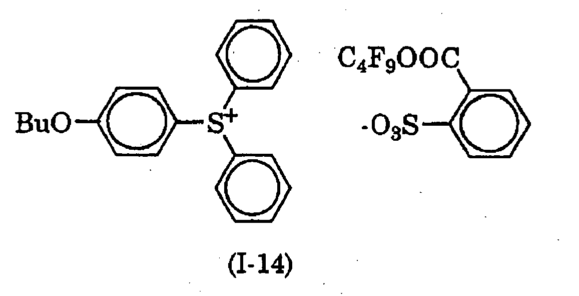

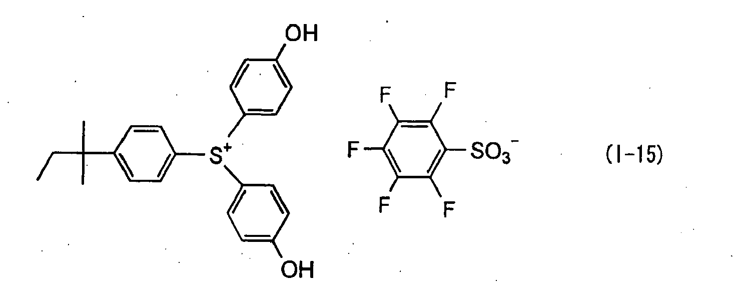

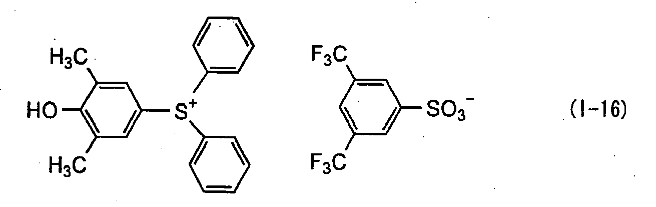

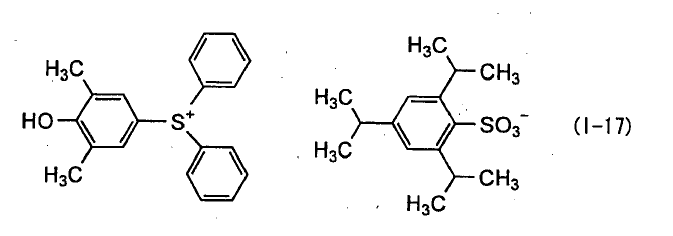

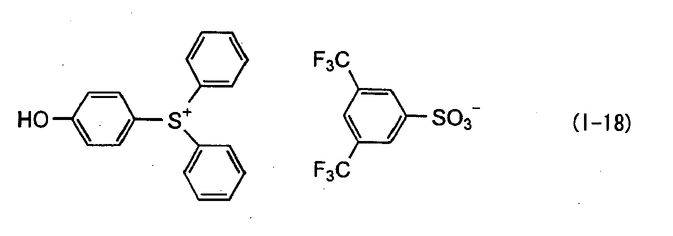

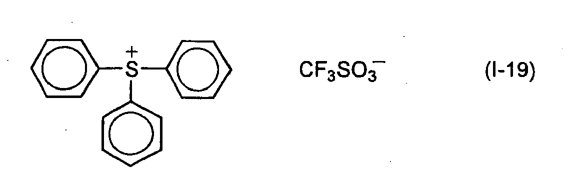

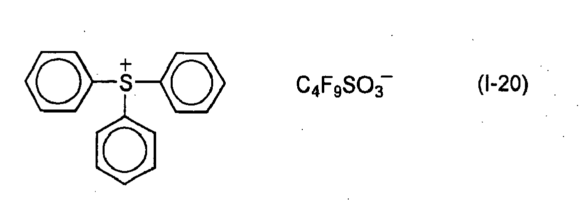

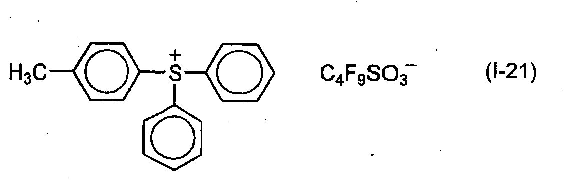

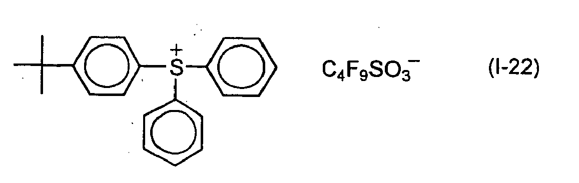

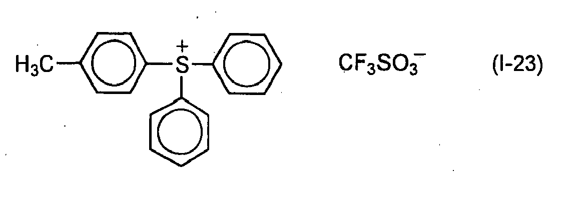

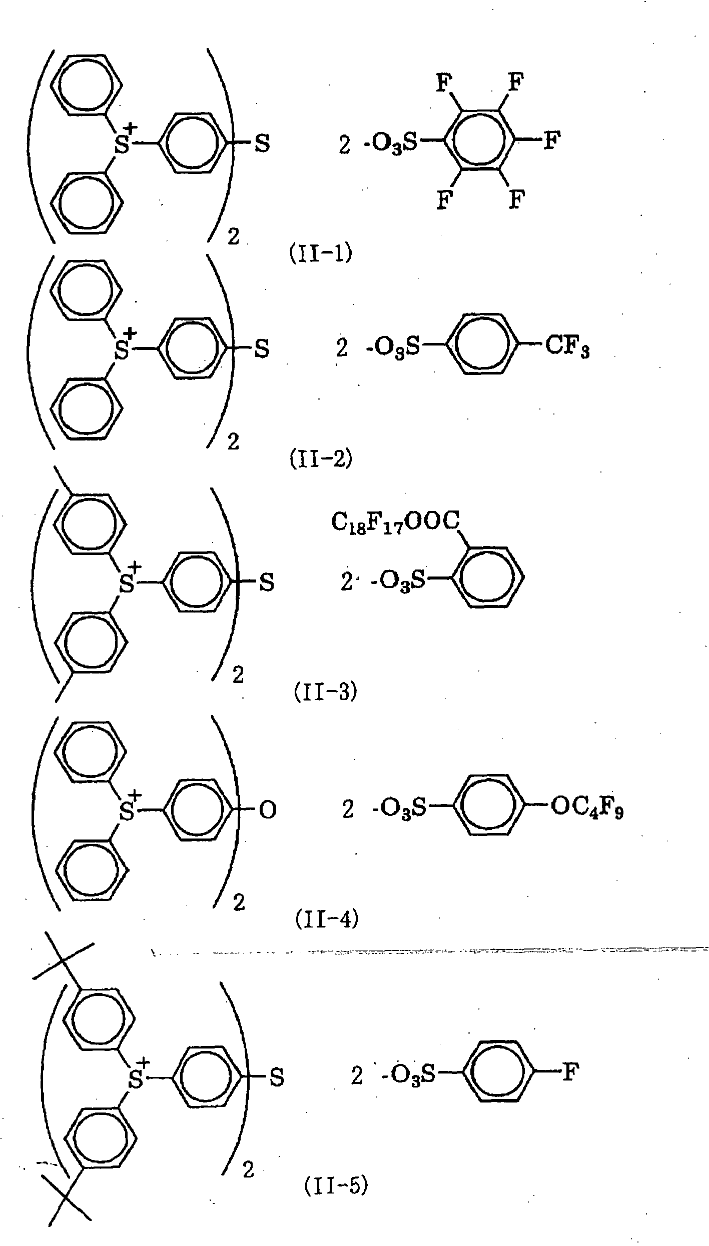

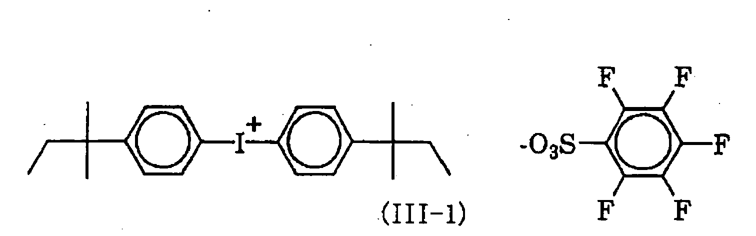

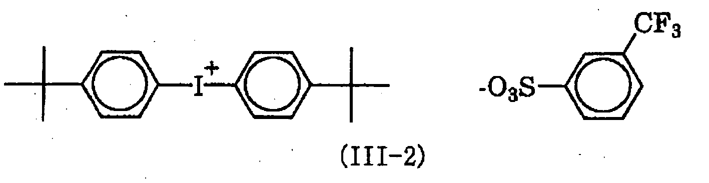

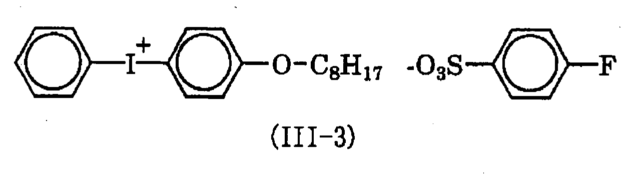

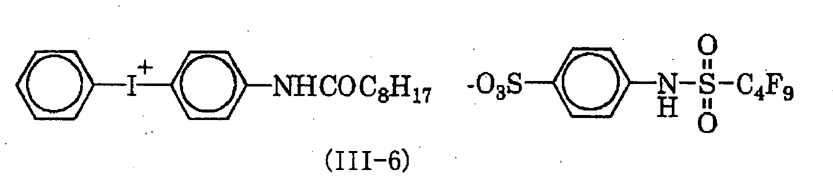

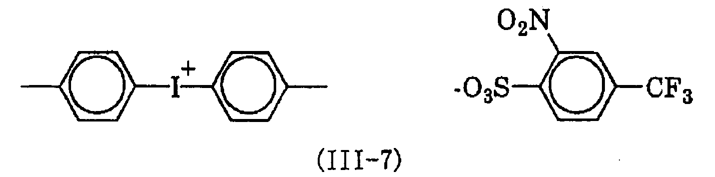

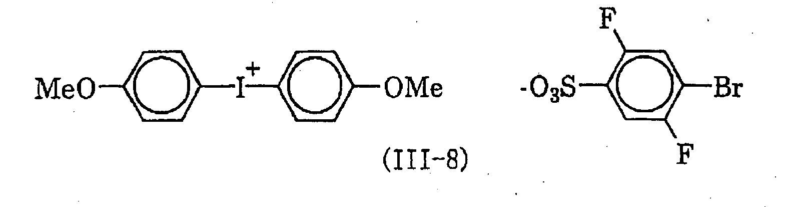

The compounds represented by formulae (I) and (II) can be synthesized, for example, by a method of reacting an aryl Grignard's reagent such as aryl magnesium bromide with a substituted or unsubstituted phenylsulfoxide, and salt-exchanging the obtained triarylsulfonium halide with a corresponding sulfonic acid; a method of condensing and salt-exchanging a substituted or unsubstituted phenylsulfoxide and a corresponding aromatic compound by using an acid catalyst such as methanesulfonic acid/diphosphorus pentoxide or aluminum chloride; or a method of condensing and salt-exchanging a diaryl iodonium salt and diaryl sulfide by using a catalyst such as copper acetate.

The compound of formula (III) can be synthesized through salt-exchange of reacting an aromatic compound by using a periodate.

In the present invention, the compound of (A1) and the compound of (A2) can be used in combination at the following ratio. The ratio of compound of (A1)/compound of (A2) is, in terms of the molar ratio, from 100/0 to 10/90, preferably from 90/10 to 30/70, more preferably from 80/20 to 40/60.

### (A3) Compound capable of generating a fluorine-containing carboxylic acid upon irradiation of actinic rays or radiation (hereinafter sometimes referred to as a "compound of (A3))

The resist composition of the present invention may further contain a compound of (A3) as the acid generator.

Examples of the fluorine-containing carboxylic acid include a fluorine-substituted aliphatic carboxylic acid and a fluorine-substituted aromatic carboxylic acid.

Examples of the fluorine-substituted aliphatic carboxylic acid include a fluorine-substitution product of an aliphatic carboxylic acid such as acetic acid, propionic acid, n-butyric acid, isobutyric acid, valerianic acid, trimethylacetic acid, caproic acid, heptanoic acid, caprylic acid, pelargonic acid, capric acid, lauric acid, myristic acid, palmitic acid, stearic acid, undecanoic acid and tridecanoic acid. These carboxylic acids each may have a hydroxyl group, an alkoxy group or a halogen atom (excluding a fluorine atom) as the substituent. Also, the aliphatic chain thereof may contain a linking group such as oxygen atom, sulfur atom, carbonyl group, ester group and sulfonyl group.

Preferred examples of the fluorine-substituted aliphatic carboxylic acid include an aliphatic carboxylic acid represented by the following formula:

L-(CH₂)ₚ(CF₂)_{q}(CH₂)ᵣ-COOH

wherein L represents a hydrogen atom or a fluorine atom, p and r each independently represents an integer of 0 to 15 and q represents an integer of 1 to 15. The hydrogen atom or fluorine atom of the alkyl chain in this formula may be substituted with an alkyl group (preferably having a carbon number of 1 to 5) which may be substituted with a fluorine atom, an alkoxy group (preferably having a carbon number of 1 to 5) which may be substituted with a fluorine atom, or a hydroxyl group.

The fluorine-substituted aliphatic carboxylic acid is preferably a fluorine-substitution product of a saturated aliphatic carboxylic acid having a carbon number of 2 to 20, more preferably from 4 to 20. By having a carbon number of 4 or more, diffusibility of the carboxylic acid generated decreases and the change in line width due to aging after exposure until heating can be more suppressed. In particular, a fluorine-substitution product of a linear or branched saturated aliphatic carboxylic acid having a carbon number of 4 to 18 is preferred.

The fluorine-substituted aromatic carboxylic acid is preferably a fluorine-substitution product of an aromatic carboxylic acid having a carbon number of 7 to 20, more preferably from 7 to 15, still more preferably from 7 to 11. Specific examples thereof include a fluorine-substitution product of an aromatic carboxylic acid such as benzoic acid, substituted benzoic acid, naphthoic acid, substituted naphthoic acid, anthracenecarboxylic acid and substituted anthracenecarboxylic acid (examples of the substituent include an alkyl group, an alkoxy group, a hydroxyl group, a halogen atom, an aryl group, an acyl group, an acyloxy group, a nitro group, an alkylthio group and an arylthio group). Among these, a fluorine-substitution product of benzoic acid or substituted benzoic acid is preferred.

The fluorine atom-substituted aliphatic or aromatic carboxylic acid is an aliphatic or aromatic carboxylic acid where one or more hydrogen atom present in the skeleton except for the carboxyl group is substituted with a fluorine atom, preferably an aliphatic or aromatic carboxylic acid where all hydrogen atoms present in the skeleton except for the carboxyl group are substituted with a fluorine atom (that is, a perfluoro saturated aliphatic carboxylic acid or a perfluoro aromatic carboxylic acid). By this constitution, more excellent sensitivity is obtained.

Preferred examples of the compound of (A3) include an onium salt compound (e.g., sulfonium salt, iodonium salt) having, as the counter anion, an anion of the above-described fluorine atom-substituted aliphatic or aromatic carboxylic acid, an imidocarboxylate compound having a carboxylic acid ester group, and a nitrobenzyl ester compound.

The compound of (A3) is more preferably a compound represented by the following formula (IF), (IIF) or (IIIF).

By using such a compound, the sensitivity, resolution and exposure margin are more enhanced. This compound generates a saturated aliphatic or aromatic carboxylic acid substituted with at least one fluorine atom, corresponding to X⁻ of formulae (IF) to (IIIF), upon irradiation of actinic rays or radiation and functions as an acid generator. 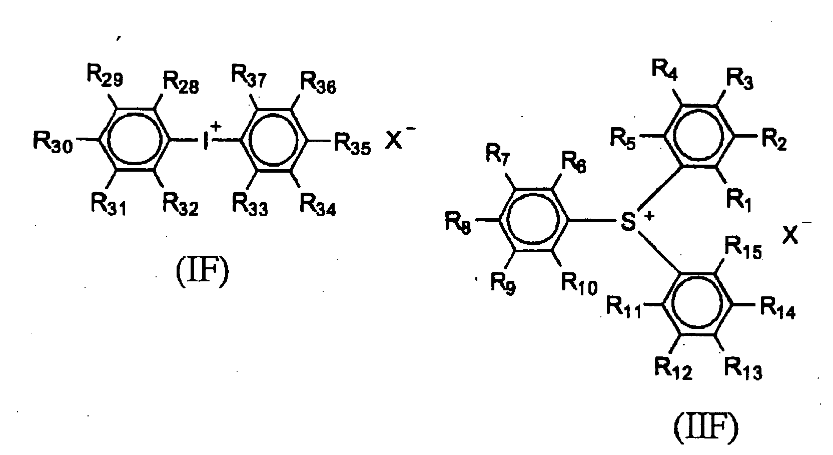 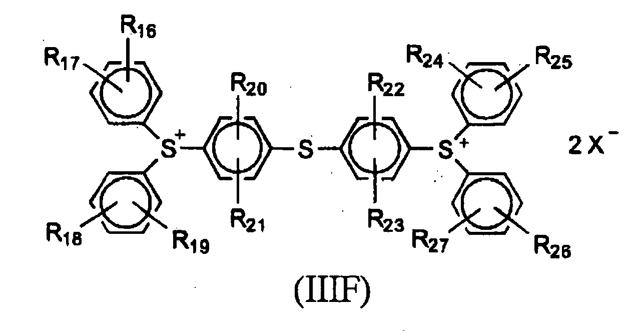 (wherein R₁ to R₃₇ each independently represents a hydrogen atom, a linear, branched or cyclic alkyl group, a linear, branched or cyclic alkoxy group, a hydroxy group, a halogen atom or an - S-R₃₈ group, R₃₈ represents a linear, branched or cyclic alkyl group or an aryl group, and X⁻ represents an anion of an aliphatic or aromatic carboxylic acid substituted with at least one fluorine atom).

X is preferably an anion of a perfluoro-aliphatic or aromatic carboxylic acid, more preferably an anion of a fluorine-substituted alkylcarboxylic acid having a carbon number of 4 or more.

In formulae (IF) to (IIIF), the linear or branched alkyl group of R₁ to R₃₈ includes a linear or branched alkyl group having a carbon number of 1 to 4, which may have a substituent, such as methyl group, ethyl group, propyl group, n-butyl group, sec-butyl group and tert-butyl group. The cyclic alkyl group includes a cyclic alkyl group having a carbon number of 3 to 8, which may have a substituent, such as cyclopropyl group, cyclopentyl group and cyclohexyl group.

The alkoxy group of R₁ to R₃₇ includes an alkoxy group having a carbon number of 1 to 4, which may have a substituent, such as methoxy group, ethoxy group, hydroxyethoxy group, propoxy group, n-butoxy group, isobutoxy group, sec-butoxy group and tert-butoxy group.

The halogen atom of R₁ to R₃₇ includes a fluorine atom, a chlorine atom, a bromine atom and an iodine atom.

The aryl group of R₃₈ includes an aryl group having a carbon number of 6 to 14, such as phenyl group, tolyl group, methoxyphenyl group and naphthyl group. The aryl group may have a substituent.

Preferred examples of the substituent include an alkoxy group having a carbon number of 1 to 4, a halogen atom (e.g., fluorine; chlorine, iodine), an aryl group having a carbon number of 6 to 10, an alkenyl group having a carbon number of 2 to 6, a cyano group, a hydroxy group, a carboxy group, an alkoxycarbonyl group and a nitro group.

The iodonium or sulfonium compound represented by formulae (IF) to (IIIF) for use in the present invention has, as the counter anion X⁻, an anion of a saturated aliphatic or aromatic carboxylic acid substituted with at least one fluorine atom. This anion is an anion (-COO⁻) resulting from desorption of a hydrogen atom of the carboxylic acid (-COOH).

Specific examples of these compounds are set forth below, but the present invention is not limited thereto.
Specific Examples (I-1f) to (I-36f) of Acid Generator Represented by Formula (IF): 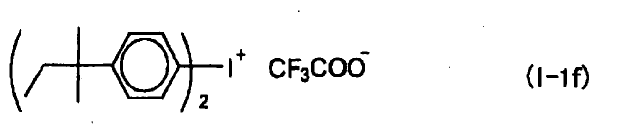 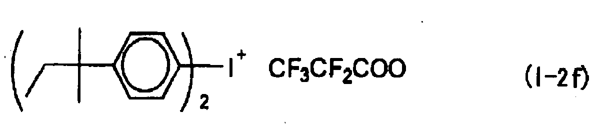 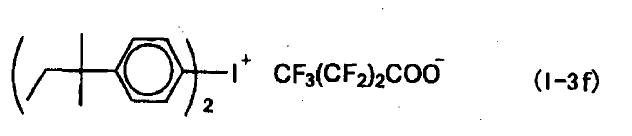 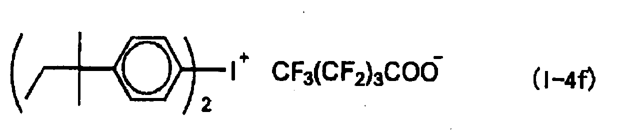 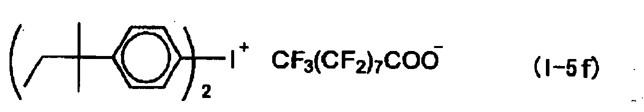 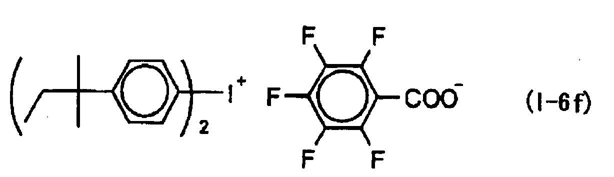 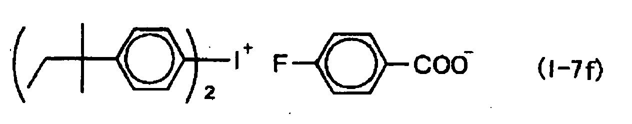 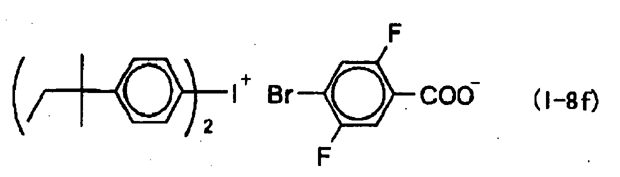 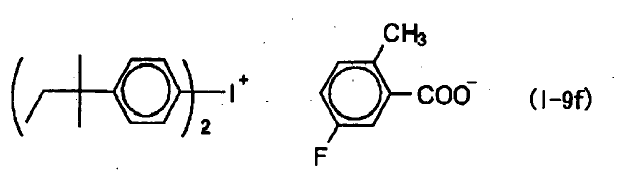 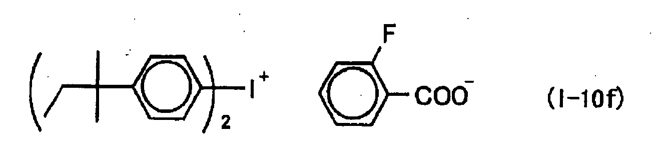 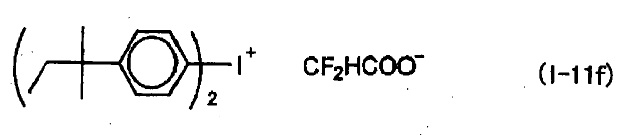 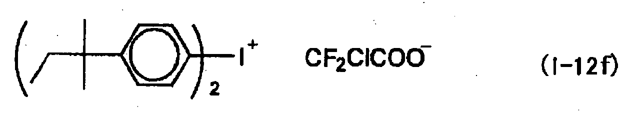 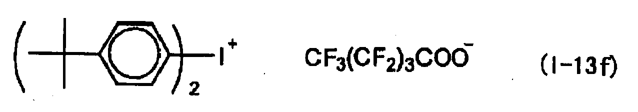 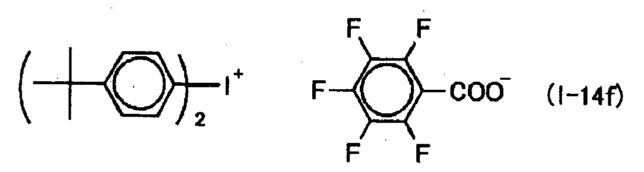 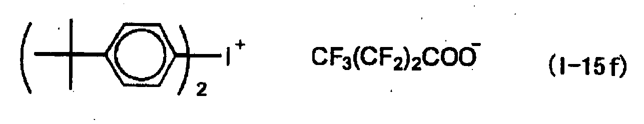 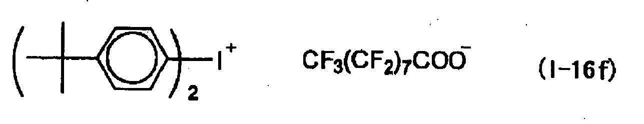 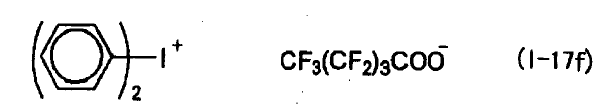 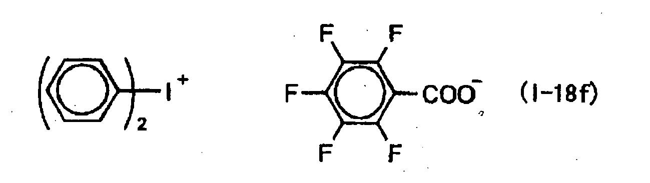 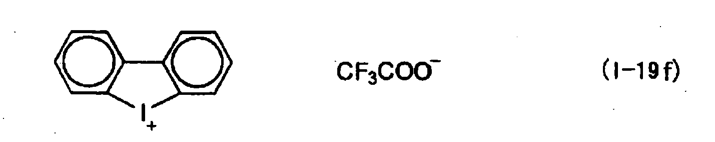 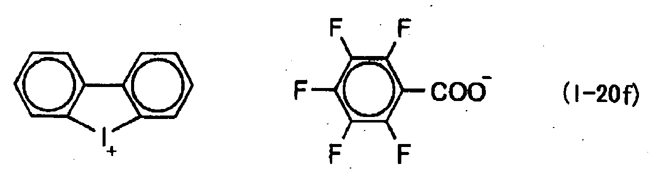 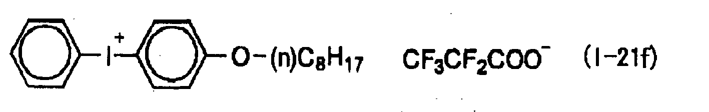 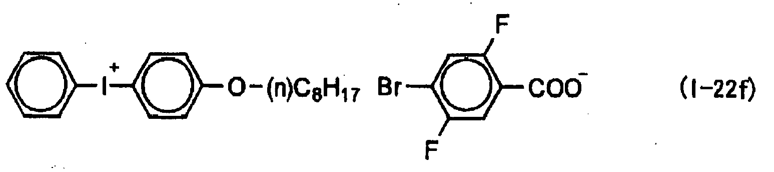 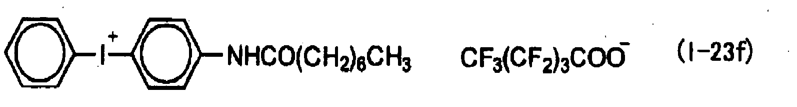 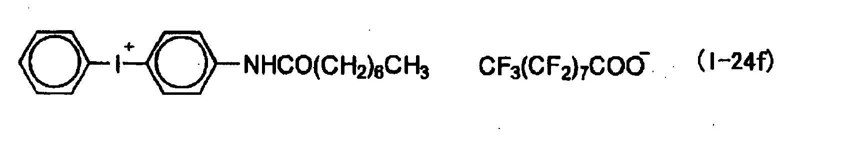 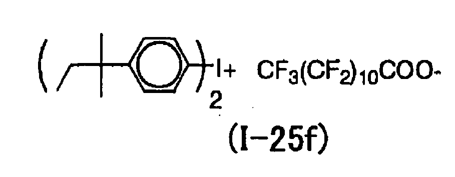 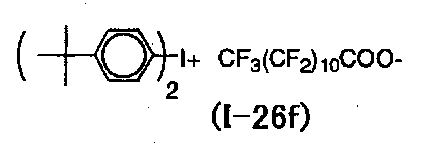 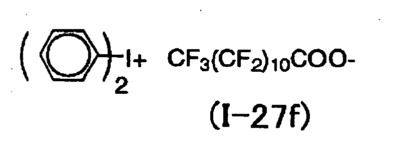 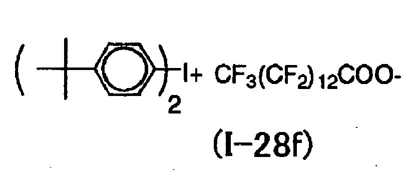 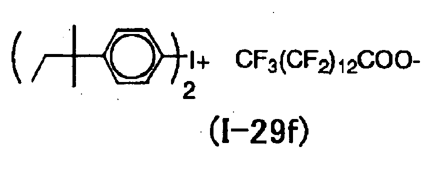 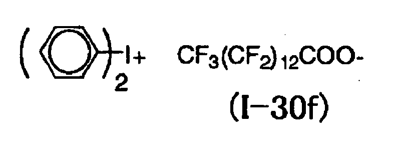 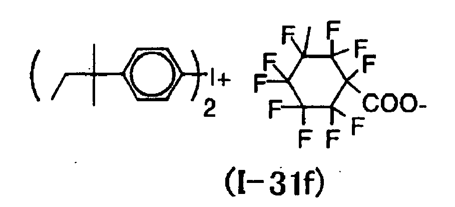 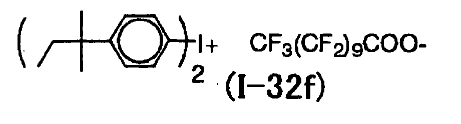 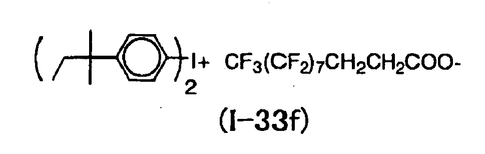 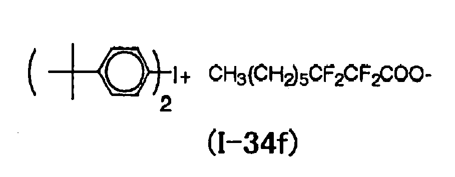 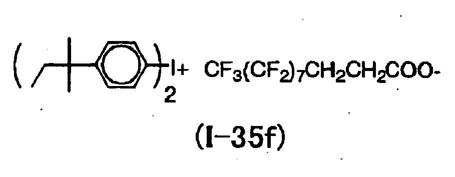 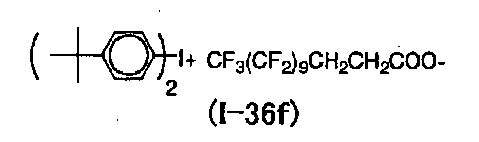 Specific Examples (II-1f) to (II-67f) of Acid Generator Represented by Formula (IIF): 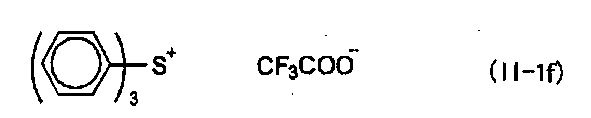 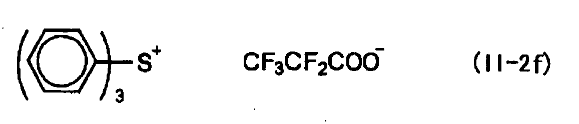 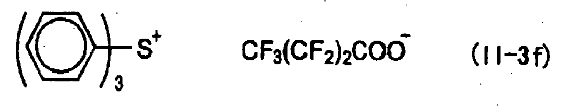 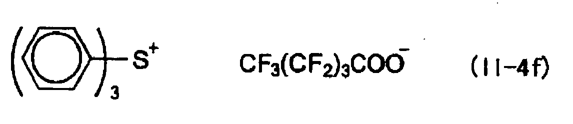 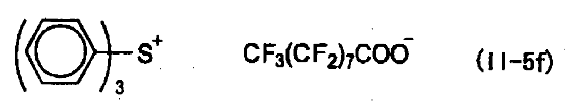 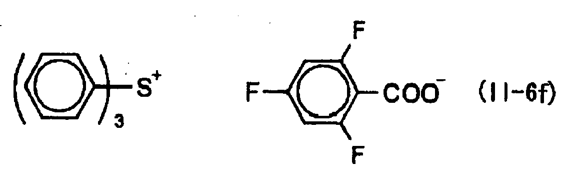 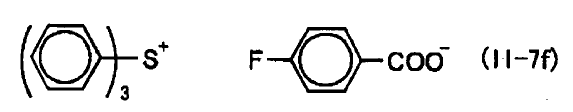 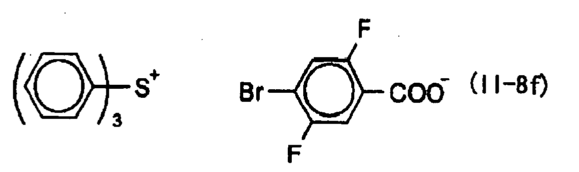 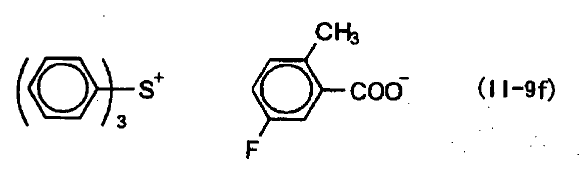 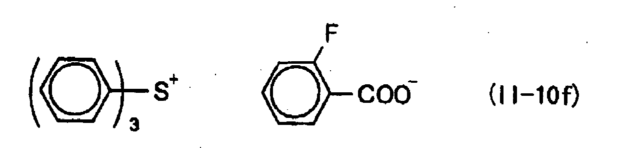 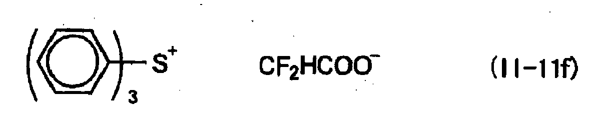 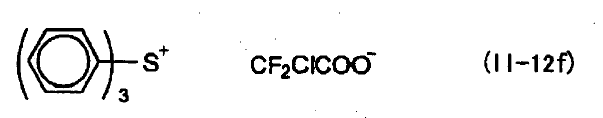 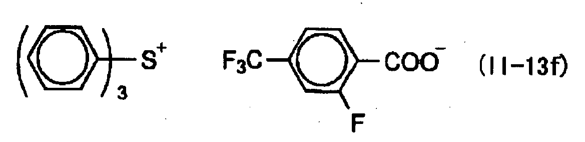 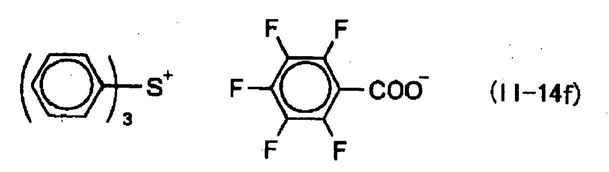 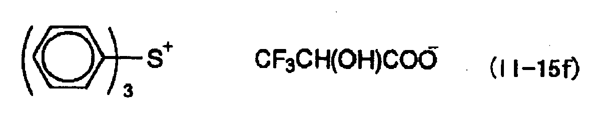 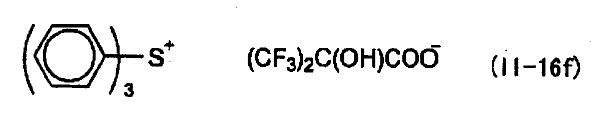 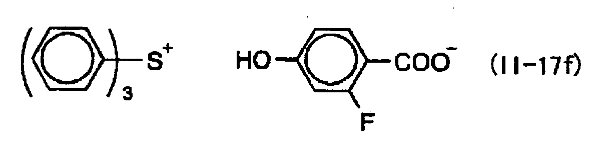 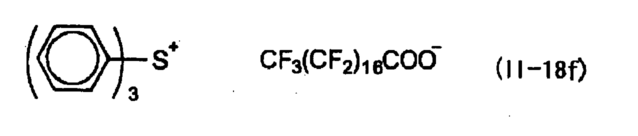 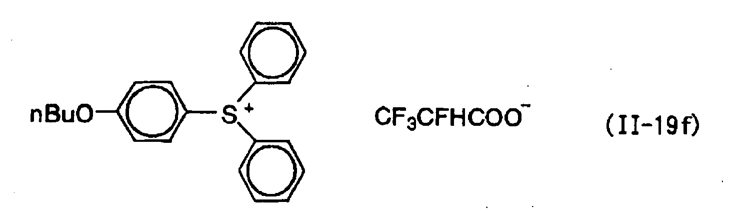 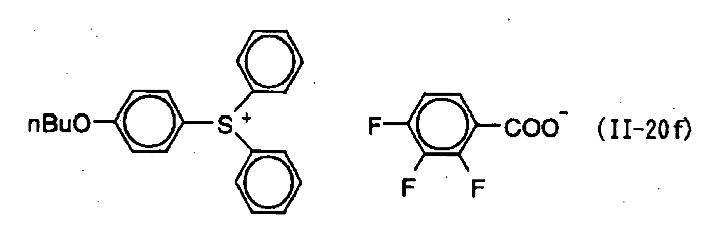 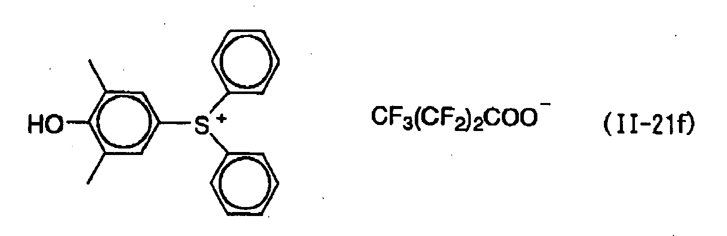 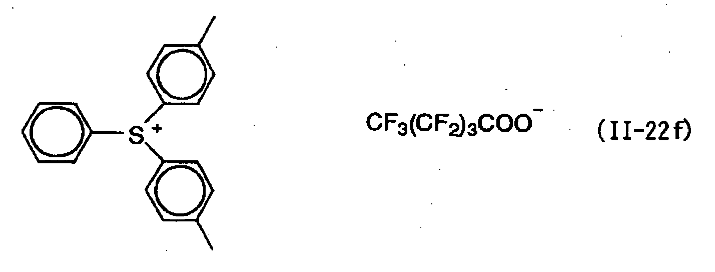 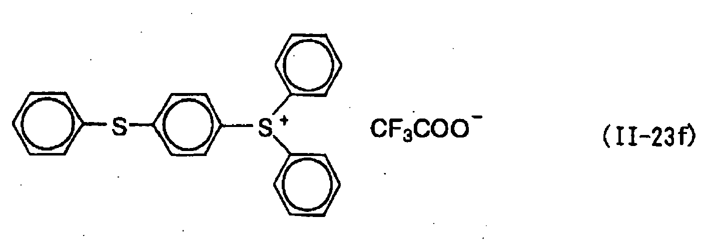 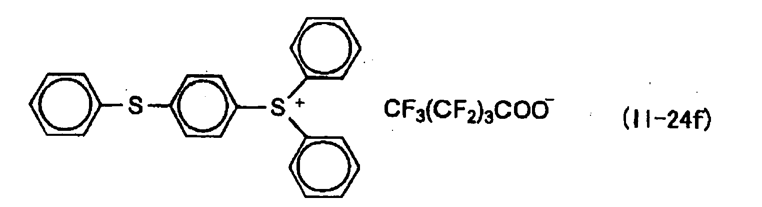 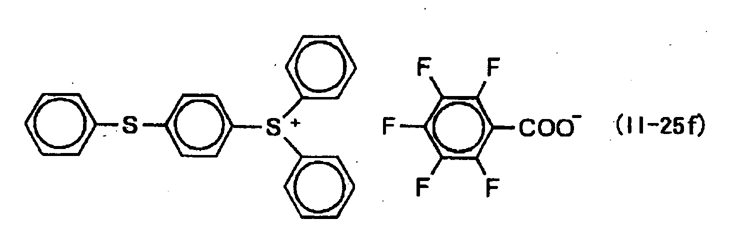 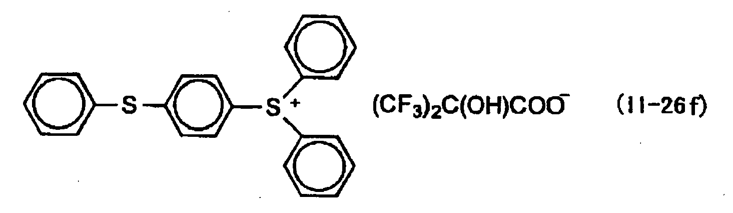 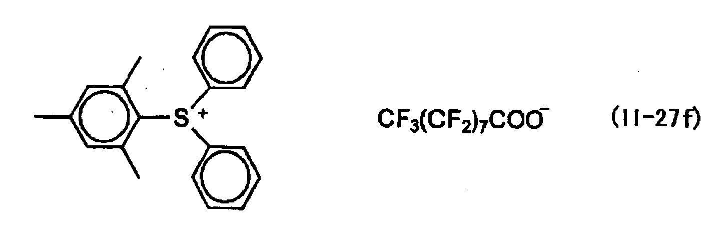 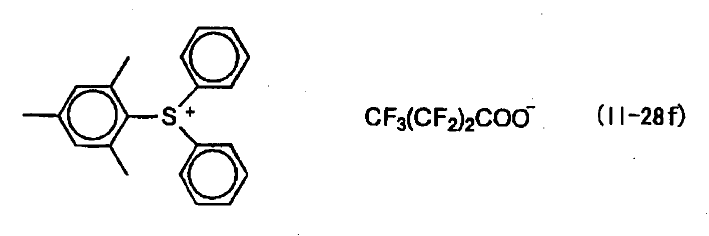 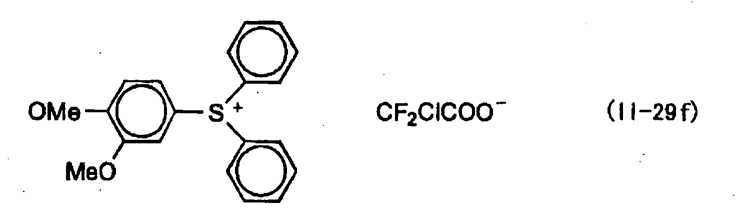 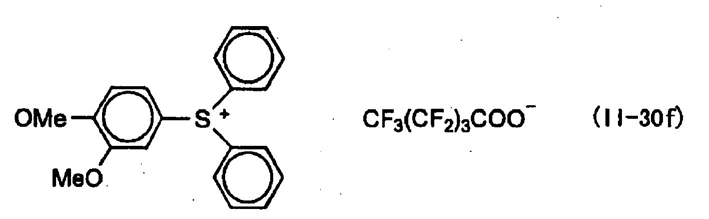 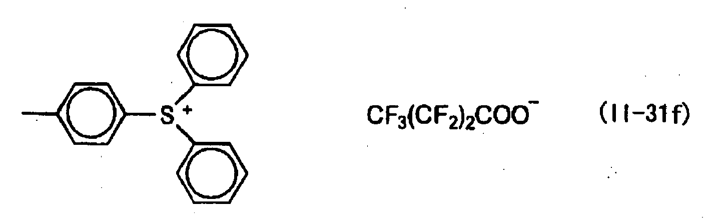 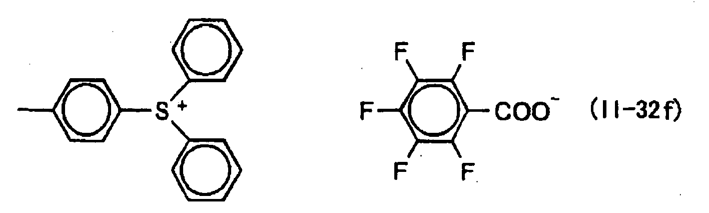 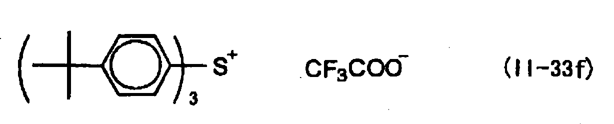 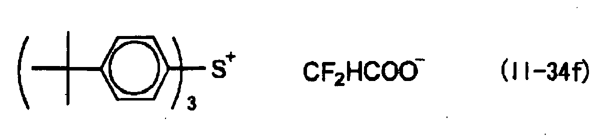 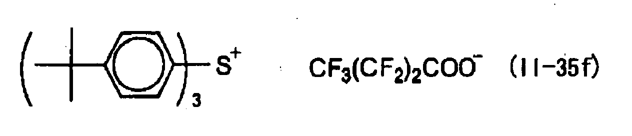 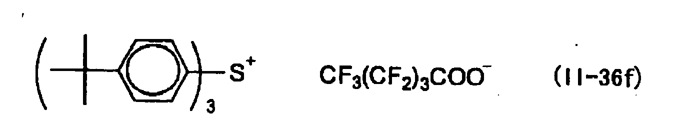 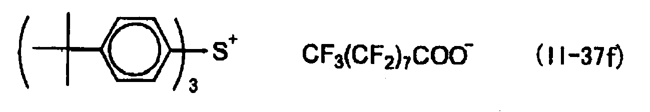 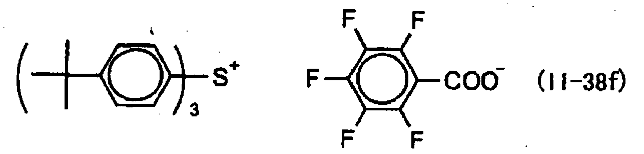 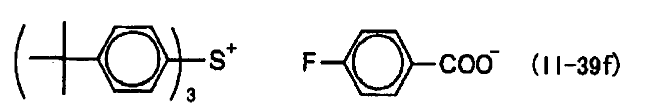 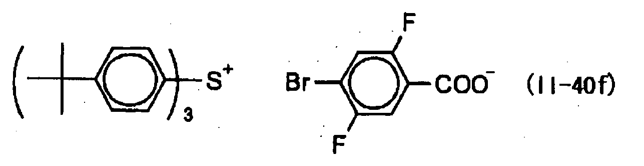 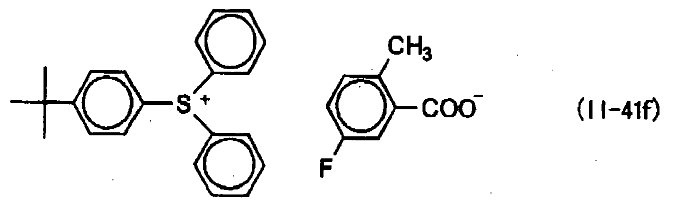 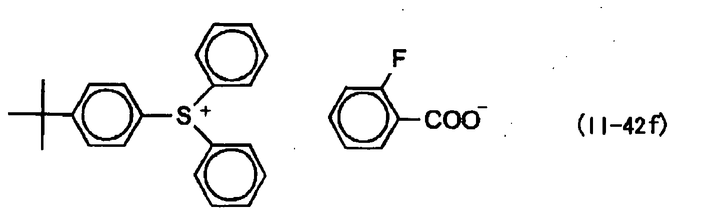 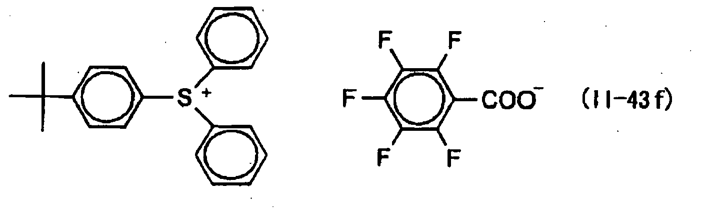 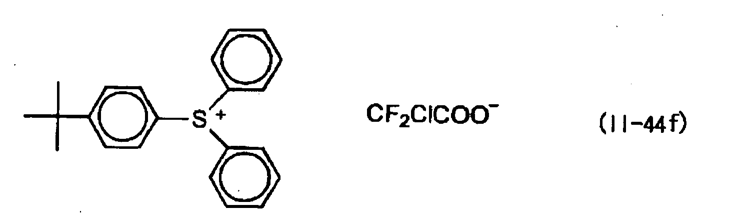 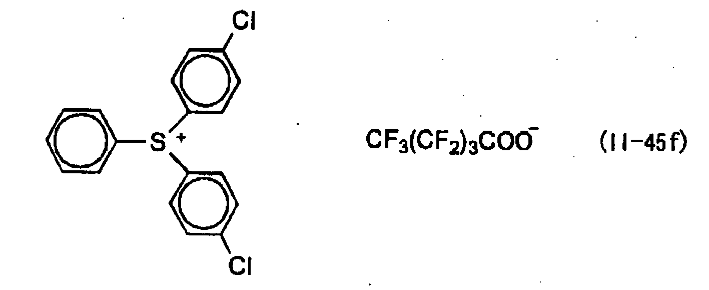 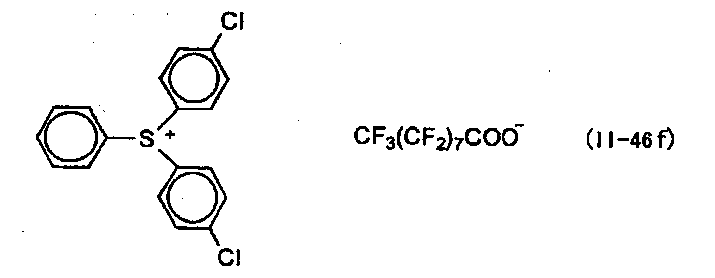 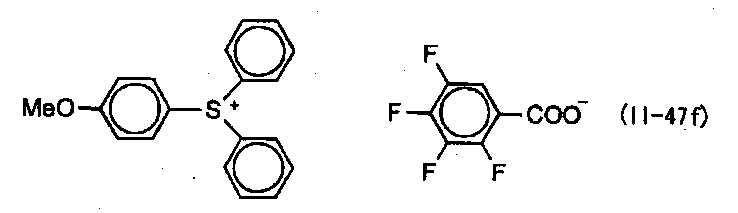 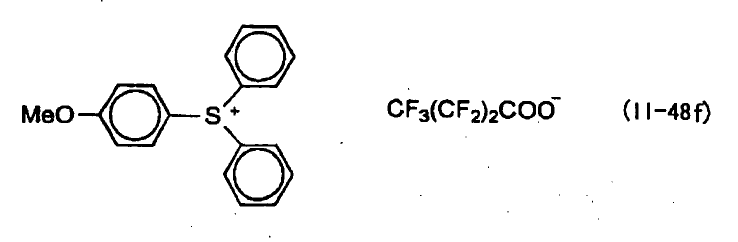 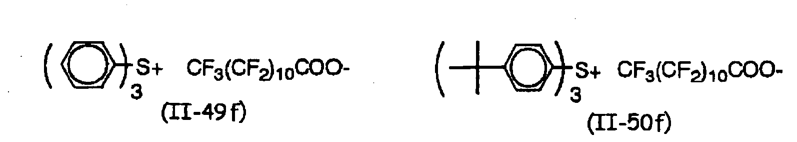 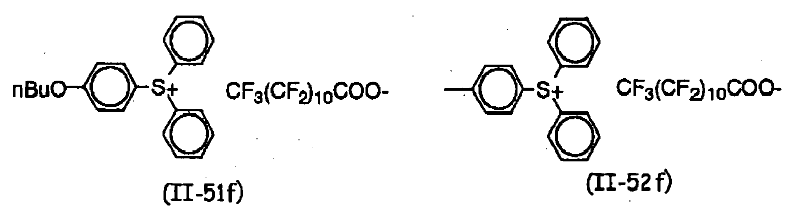 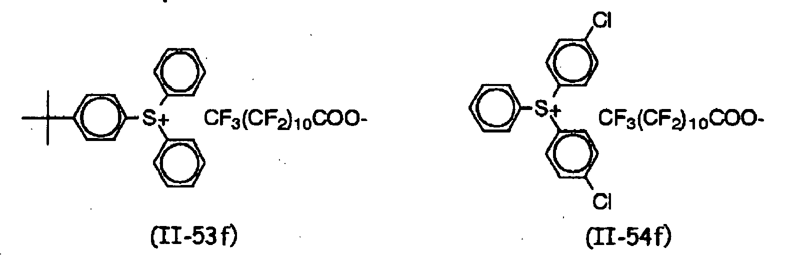 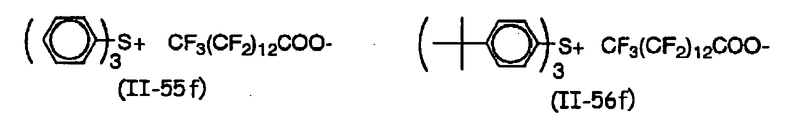 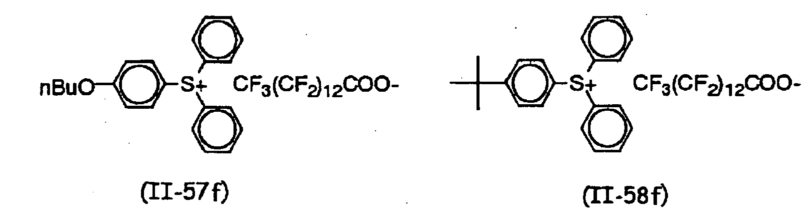 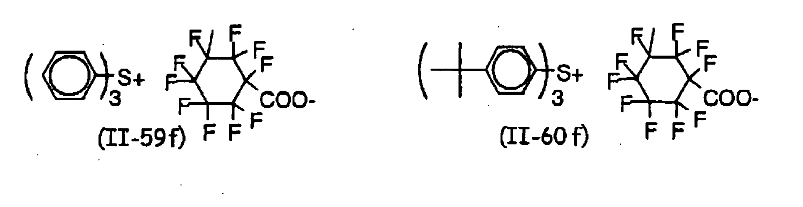 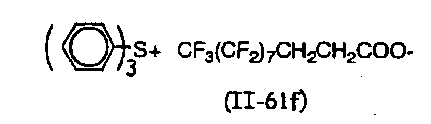 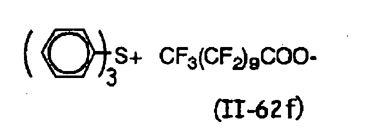 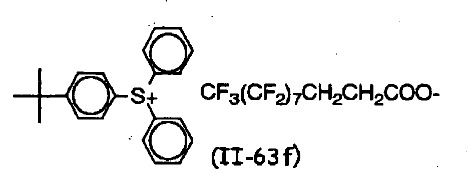 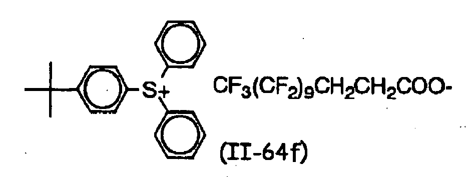 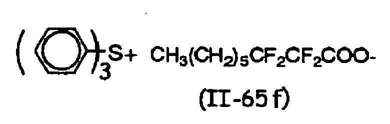 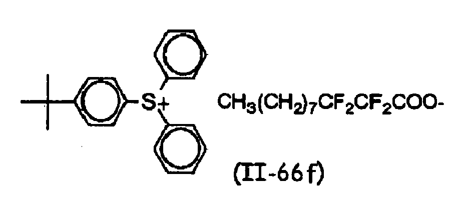 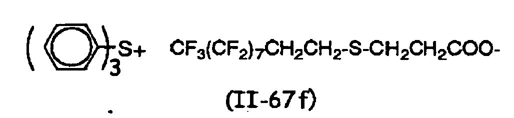 Specific Examples (III-1f) to (III-4f) of Acid Generator Represented by Formula (IIIF): 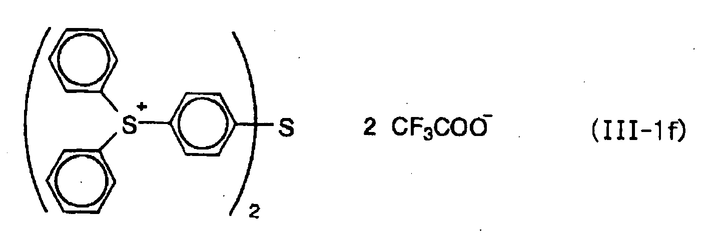 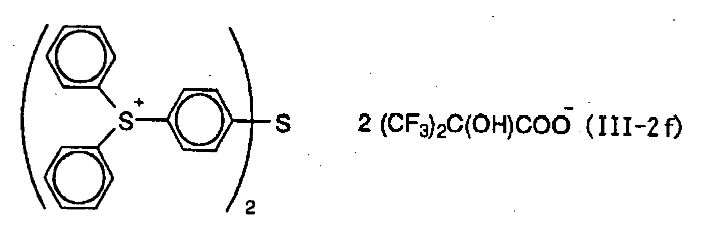 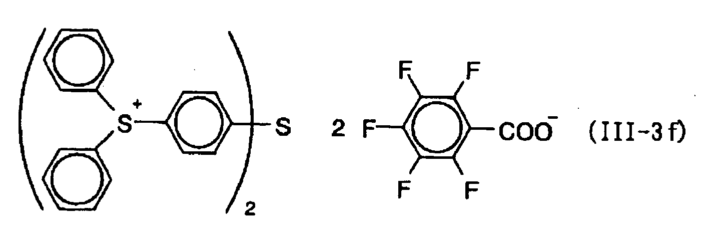 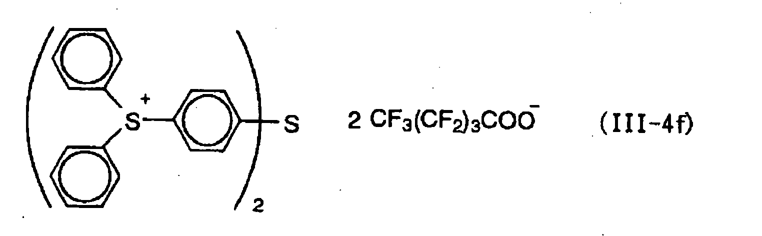 Specific Examples (IV-1f) to (V-4f) of Other Acid Generators:

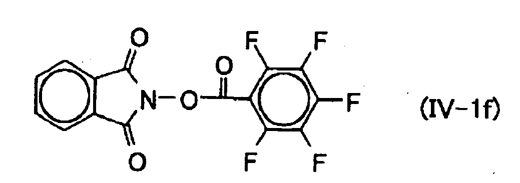

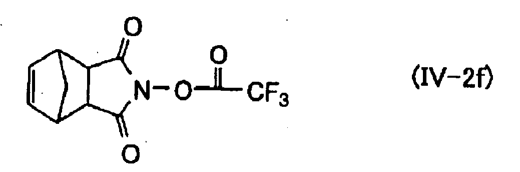

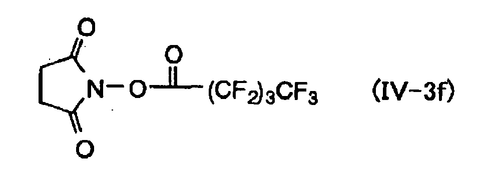

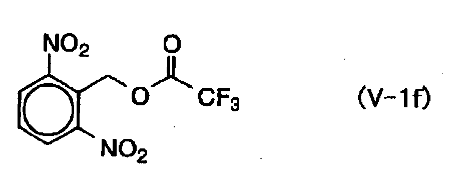

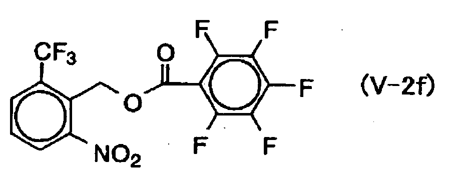

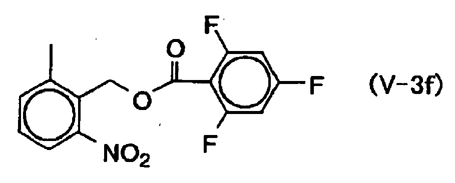

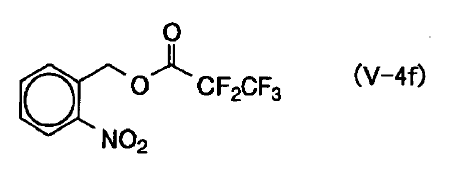

The compound represented by formula (IF) can be synthesized by reacting an aromatic compound with use of a periodate, and salt-exchanging the obtained iodonium salt with a corresponding carboxylic acid.

The compounds represented by formulae (IIF) and (IIIF) can be synthesized, for example, by a method of reacting an aryl Grignard's reagent such as aryl magnesium bromide with a substituted or unsubstituted phenylsulfoxide, and salt-exchanging the obtained triarylsulfonium halide with a corresponding carboxylic acid. These compounds can also be synthesized by a method of condensing and salt-exchanging a substituted or unsubstituted phenylsulfoxide and a corresponding aromatic compound with use of an acid catalyst such as methanesulfonic acid/diphosphorus pentoxide or aluminum chloride, or a method of condensing and salt-exchanging a diaryl iodonium salt and diaryl sulfide with use of a catalyst such as copper acetate.

The salt-exchange can be performed by once synthesizing a halide salt and converting it into a carboxylate with use of a silver reagent such as silver oxide, or by using an ion exchange resin. The carboxylic acid or carboxylate for use in the salt-exchange may be a commercially available product or may be obtained by the hydrolysis of a commercially available carboxylic acid halide.

With respect to the fluorine-substituted carboxylic acid as the anion moiety, a carboxylic acid derived from a fluoro-aliphatic compound produced by a telomerization process (also called a telomer process) or an oligomerization process (also called an oligomer process) is also preferred. The production process of this fluoro-aliphatic compound is described, for example, in Nobuo Ishikawa (supervisor), Fusso Kagobutsu no Gosei to Kino (Synthesis and Function of Fluorine Compounds), CMC, pp. 117-118 (1987), and Milos Hudlicky and Attila E. Pavlath, Chemistry of Organic Fluorine Compounds II, Monograph 187, pp. 747-752, American Chemical Society (1995). The telomerization process is a method of radical-polymerizing a fluorine-containing vinyl compound such as tetrafluoroethylene by using, as the telogen, an alkyl halide having a large chain transfer constant, such as iodide, to synthesize a telomer. By the synthesis according to the telomer process, a mixture containing a plurality of compounds differing in the carbon chain length is obtained. This mixture may be used as it is or may be purified before use.

In the present invention, the compound of (A1) and the compound of (A3) can be used in combination at the following ratio. The ratio of compound of (A1)/compound of (A3) is, in terms of the molar ratio, from 100/0 to 10/90, preferably from 90/10 to 30/70, more preferably from 80/20 to 40/60.

### (A4) Compound capable of generating a fluorine-free carboxylic acid upon irradiation of actinic rays or radiation (hereinafter sometimes referred to as a "compound of (A4)")

The resist composition of the present invention may further contain a compound of (A4) as the acid generator.

Examples of the compound of (A4) include the compounds represented by the following formulae (AI) to (AV): 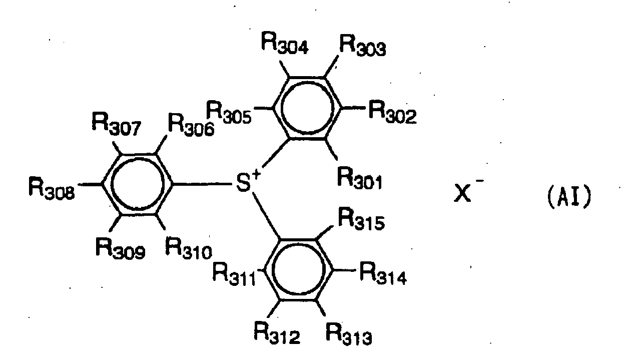 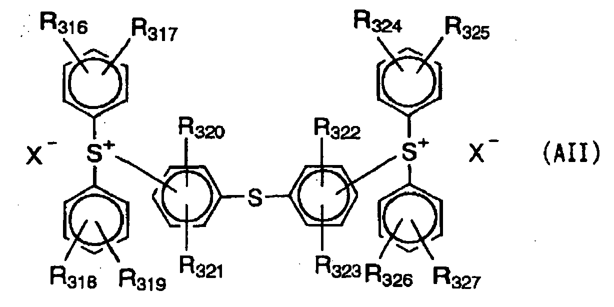 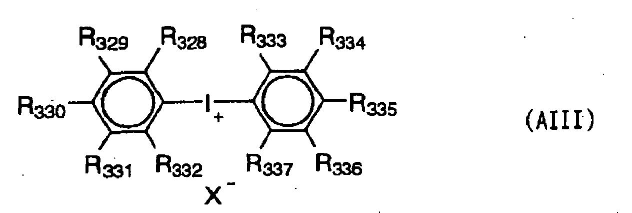 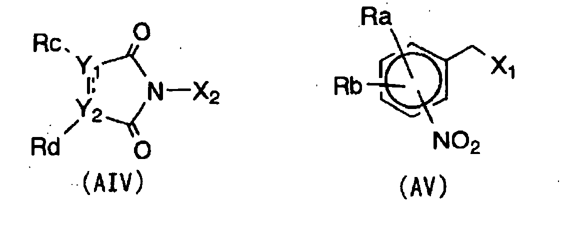 wherein R₃₀₁ to R₃₃₇ each independently represents a hydrogen atom, a linear, branched or cyclic alkyl group, a linear, branched or cyclic alkoxy group, a hydroxy group, a halogen atom or an - S-R₀ group, R₀ represents a linear, branched or cyclic alkyl group or an aryl group, Ra and Rb each independently represents a hydrogen atom, a nitro group, a halogen atom or an alkyl or alkoxy group which may have a substituent, Rc and Rd each independently represents a halogen atom or an alkyl or aryl group which may have a substituent, Rc and Rd may combine to form an aromatic ring or a monocyclic or polycyclic aliphatic hydrocarbon ring (the ring may contain an oxygen atom or a nitrogen atom), Y₁ and Y₂ each represents a carbon atom, the Y₁-Y₂ bond may be a single bond or a double bond, X⁻ represents an anion of a carboxylic acid compound represented by any one of the following formulae, and X₁ and X₂ each independently represents a group resulting from conversion of the carboxyl group moiety of a carboxylic acid compound represented by any one of the following formulae into an ester group:

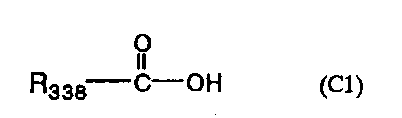

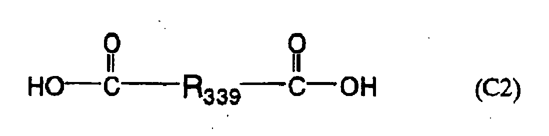

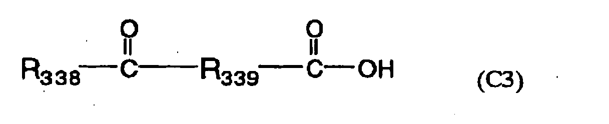

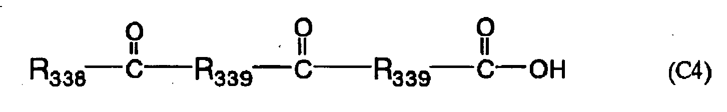

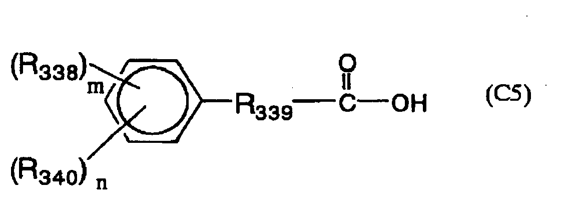

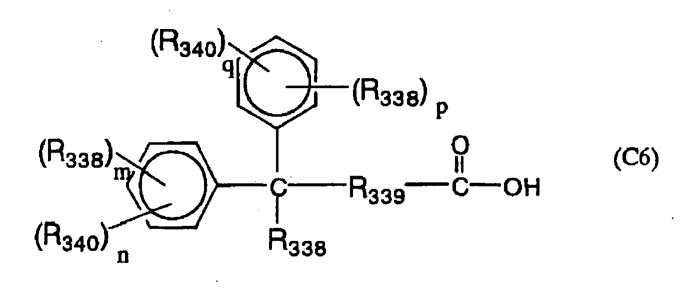

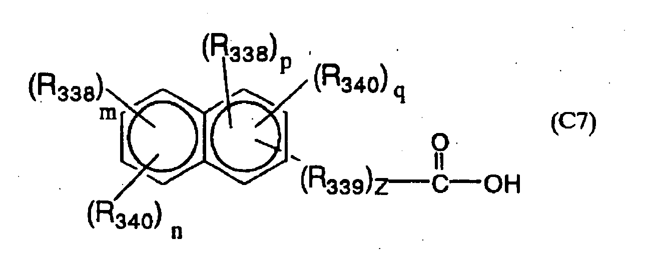

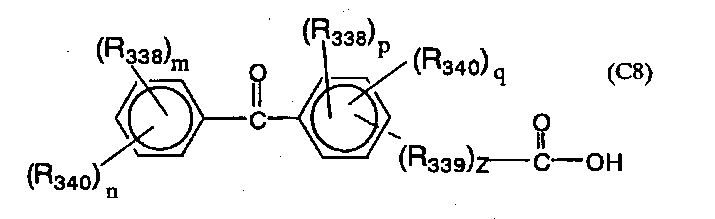

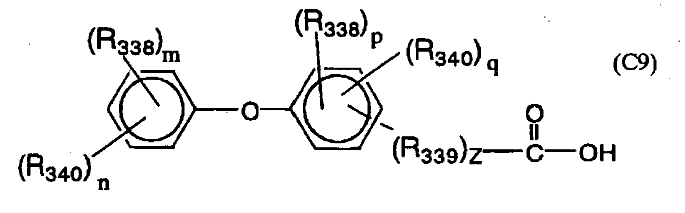

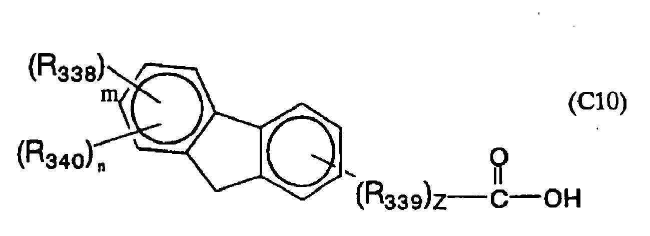

In these formulae, R₃₃₈ represents a linear, branched or cyclic alkyl group having a carbon number of 1 to 30 (the alkyl group may contain in the chain thereof an oxygen atom or a nitrogen atom), a linear, branched or cyclic alkenyl group having a carbon number of 2 to 20, a linear, branched or cyclic alkynyl group having a carbon number of 2 to 20, a linear, branched or cyclic alkoxyl group having a carbon number of 1 to 20, a group where at least a part of the hydrogen atom in the above-described alkyl group is substituted with a halogen atom and/or a hydroxyl group, a group where at least a part of the hydrogen atom in the above-described alkenyl group is substituted with a halogen atom and/or a hydroxyl group, or a substituted or unsubstituted aryl group having a carbon number of 6 to 20. Examples of the substituent for the aryl group include an alkyl group, a nitro group, a hydroxyl group, an alkoxy group, an acyl group, an alkoxycarbonyl group and a halogen atom).

R₃₃₉ represents a single bond, a linear, branched or cyclic alkylene group having a carbon number of 1 to 20 (the alkylene group may contain in the chain thereof an oxygen atom or a nitrogen atom), a linear, branched or cyclic alkenylene group having a carbon number of 2 to 20, a group where at least a part of the hydrogen atom in the above-described alkylene group is substituted with a halogen atom and/or a hydroxyl group, a group where at least a part of the hydrogen atom in the above-described alkenylene group is substituted with a halogen atom, or an alkoxyalkylene group having a carbon number of 2 to 20, and a plurality of R₃₃₈'s or a plurality of R₃₃₉'s may be the same or different.

R₃₄₀ represents a hydroxyl group or a halogen atom, and a plurality of R₃₄₀'s may be the same or different. m, n, p and q each independently represents an integer of 0 to 3, provided that m+n≤5 and p+q≤5, and z represents 0 or 1.

In formulae (AI) to (AV), the linear or branched alkyl group of R₃₀₁ to R₃₃₇, Ra, Rb, Rc, Rd and R₀ includes a linear or branched alkyl group having a carbon number of 1 to 4, which may have a substituent, such as methyl group, ethyl group, propyl group, n-butyl group, sec-butyl group and tert-butyl group. The cyclic alkyl group includes a cyclic alkyl group having a carbon number of 3 to 8, which may have a substituent, such as cyclopropyl group, cyclopentyl group and cyclohexyl group.

The alkoxy group of R₃₀₁ to R₃₃₇, Ra and Rb includes an alkoxy group having a carbon number of 1 to 4, such as methoxy group, ethoxy group, hydroxyethoxy group, propoxy group, n-butoxy group, isobutoxy group, sec-butoxy group and tert-butoxy group.

The halogen atom of R₃₀₁ to R₃₃₇, Ra, Rb, Rc and Rd includes a fluorine atom, a chlorine atom, a bromine atom and an iodine atom.

The aryl group of R₀, Rc and Rd includes an aryl group having a carbon number of 6 to 14, which may have a substituent, such as phenyl group, tolyl group, methoxyphenyl group and naphthyl group.

Preferred examples of the substituent include an alkoxy group having a carbon number of 1 to 4, a halogen atom (e.g., fluorine, chlorine, iodine), an aryl group having a carbon number of 6 to 10, an alkenyl group having a carbon number of 2 to 6, a cyano group, a hydroxy group, a carboxy group, an alkoxycarbonyl group and a nitro group.

Examples of the aromatic ring and the monocyclic or polycyclic hydrocarbon ring (these rings each may contain an oxygen atom or a nitrogen atom) formed by combining Rc and Rd include a benzene structure, a naphthalene structure, a cyclohexane structure, a norbornene structure and an oxabicyclo structure.

The sulfonium or iodonium compound represented by formulae (AI) to (AIII) for use in the present invention contains, as the counter anion X⁻, an anion (-COO⁻) formed from a carboxyl group (-COOH) of at least one compound out of the carboxylic acid compounds represented by formulae (C1) to (C10).

The compound represented by formula (AIV) or (AV) for use in the present invention contains, as the substituent X₁ or X₂, a substituent resulting from conversion of the carboxyl group (-COOH) of at least one compound out of the carboxylic acid compounds represented by formula (C1) to (C10) into an ester group (-COO-).

The linear, branched or cyclic alkyl group having a carbon number of 1 to 30 (the alkyl group may contain in the chain thereof an oxygen atom or a nitrogen atom) of R₃₃₈ includes, for example, methyl, ethyl, propyl, butyl, pentyl, hexyl, cyclohexyl, dodecyl, 1-ethoxyethyl and adamantyl.

The linear, branched or cyclic alkenyl group having a carbon number of 1 to 20 includes, for example, ethenyl, propenyl, isopropenyl and cyclohexene.

The linear, branched or cyclic alkynyl group having a carbon number of 2 to 20 includes, for example, acetylene and propenylene.

The linear, branched or cyclic alkoxy group having a carbon number of 1 to 20 includes, for example, methoxy, ethoxy, propyloxy, butoxy, cyclohexyloxy, isobutoxy and dodecyloxy.

The substituted or unsubstituted aryl group having a carbon number of 6 to 20 includes, for example, phenyl, naphthyl and anthranyl.

Examples of the substituent for the aryl group include an alkyl group, a nitro group, a hydroxyl group, an alkoxy group, an acyl group, an alkoxycarbonyl group and a halogen atom.

The linear, branched or cyclic alkylene group having a carbon number of 1 to 20 (the alkylene group may contain in the chain thereof an oxygen atom or a nitrogen atom) of R₃₃₉ includes, for example, methylene, ethylene, propylene, butylene, isobutylene; ethoxyethylene and cyclohexylene.

The linear, branched or cyclic alkenylene group having a carbon number of 2 to 20 includes, for example, vinylene and allylene.

Specific examples of these compounds are set forth below, but the present invention is not limited thereto.

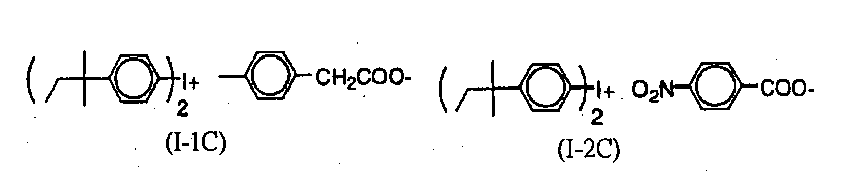

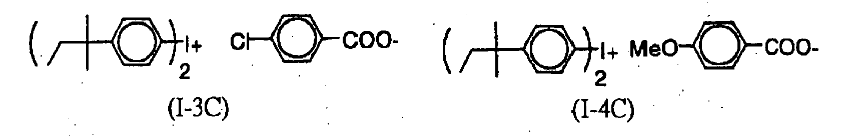

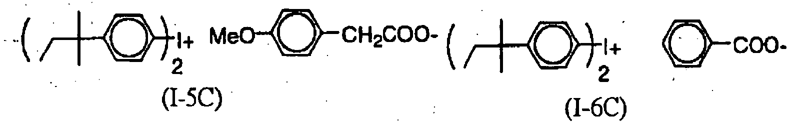

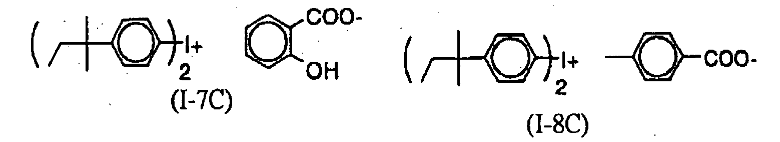

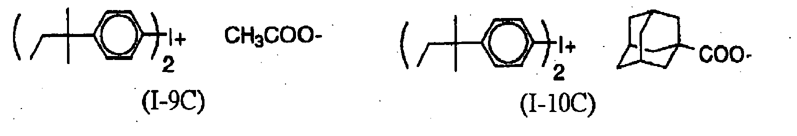

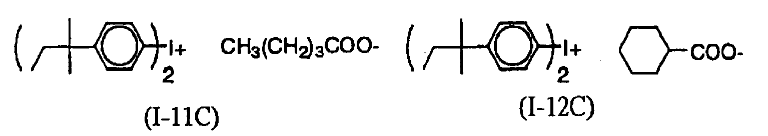

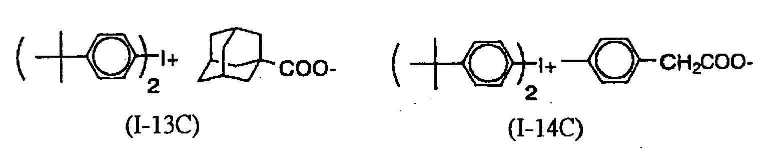

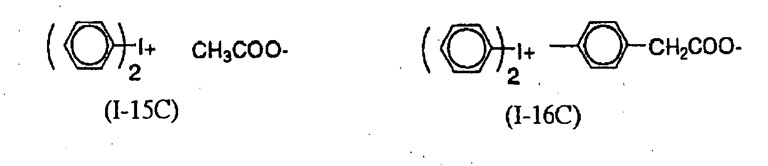

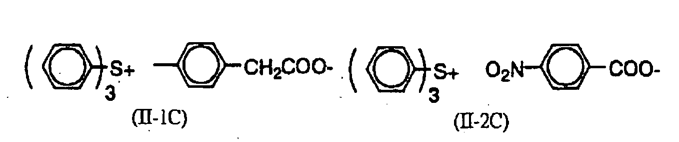

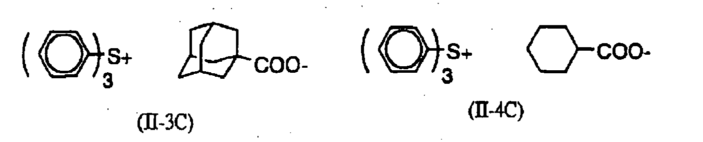

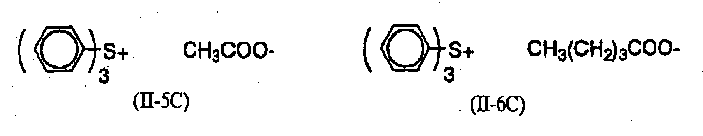

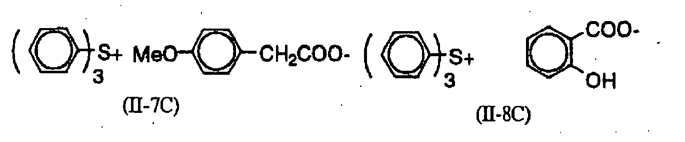

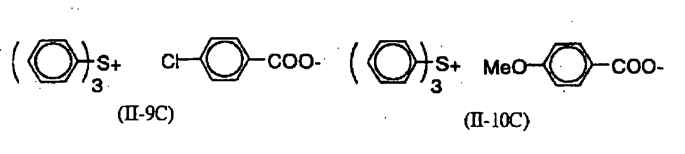

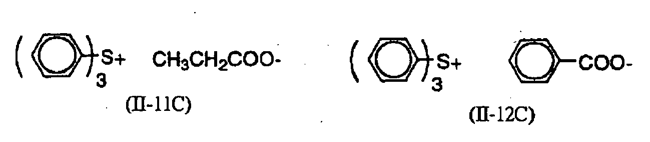

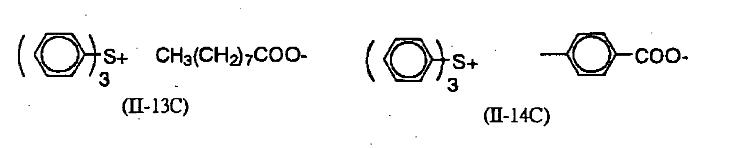

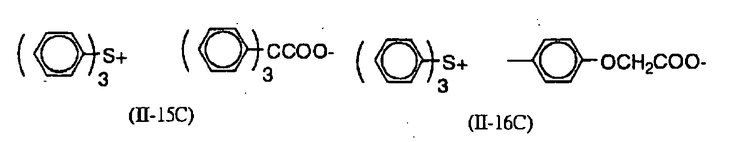

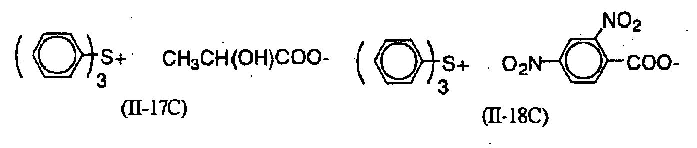

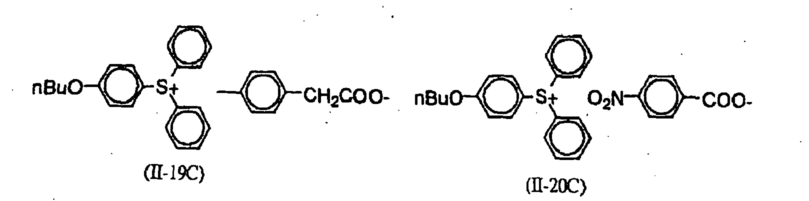

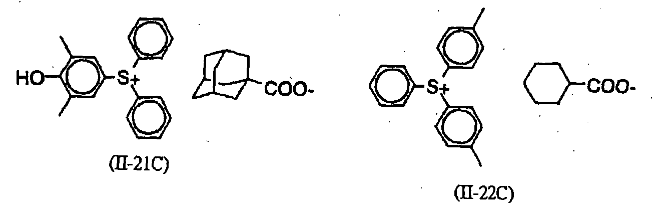

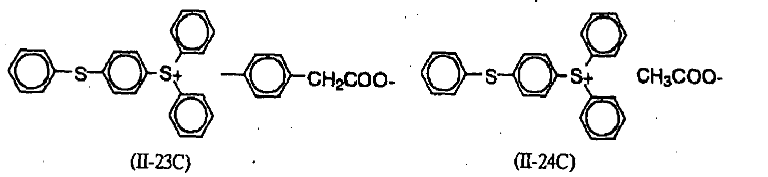

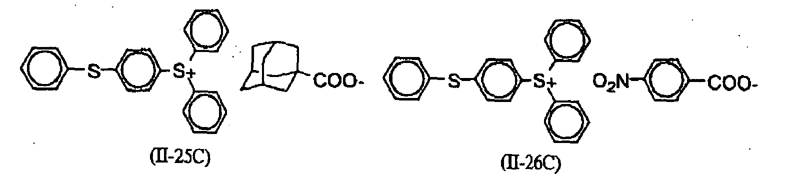

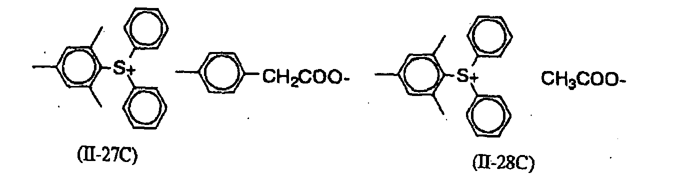

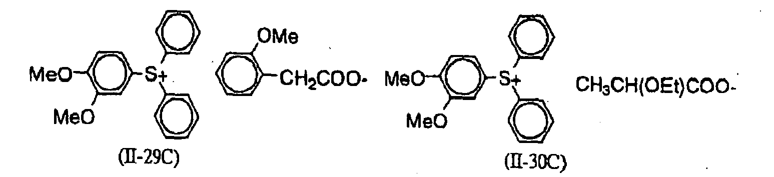

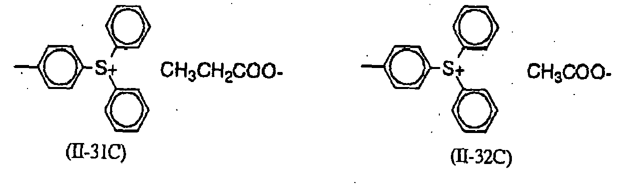

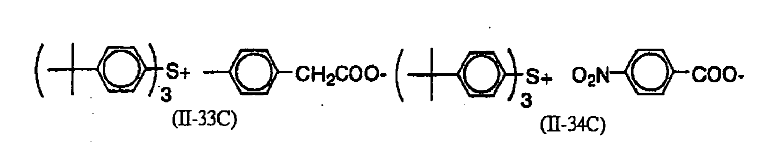

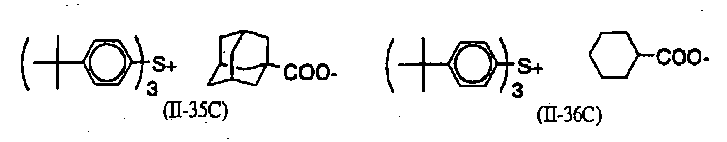

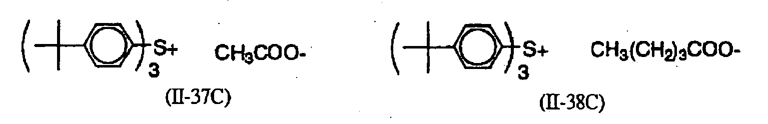

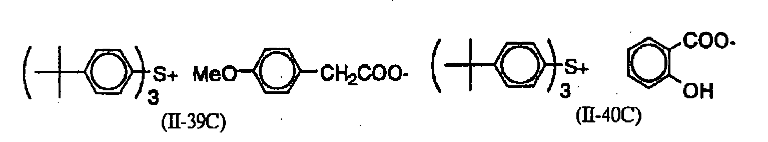

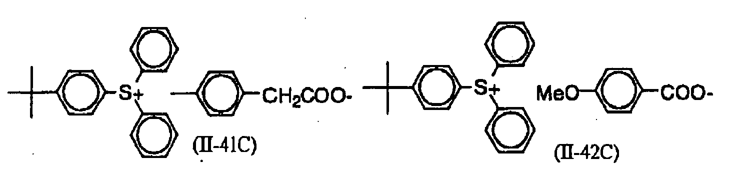

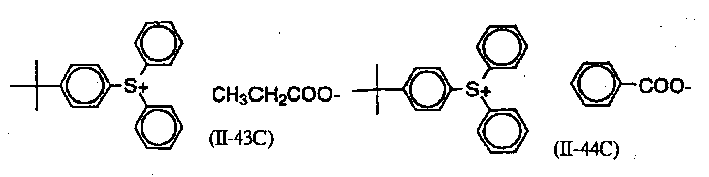

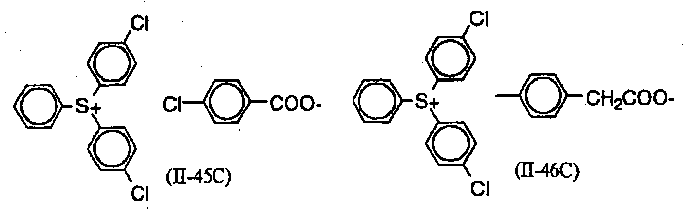

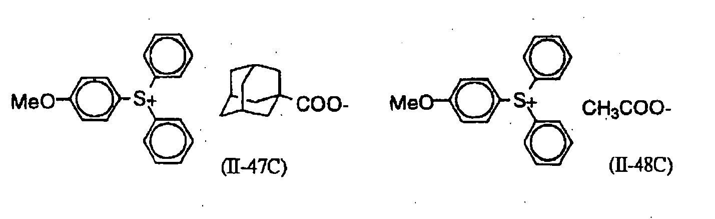

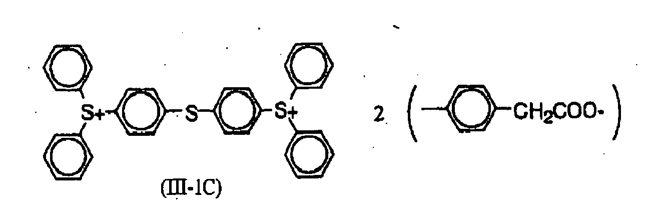

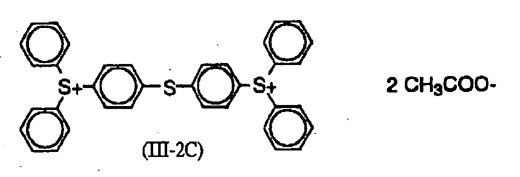

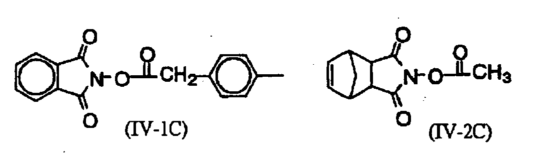

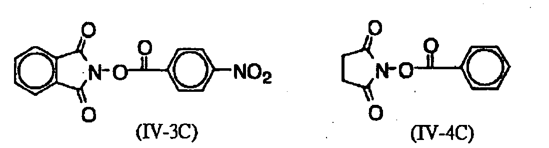

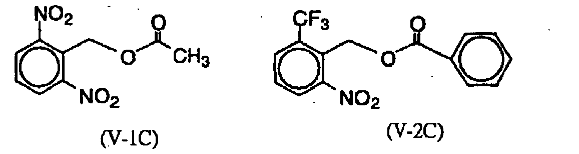

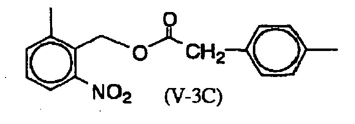

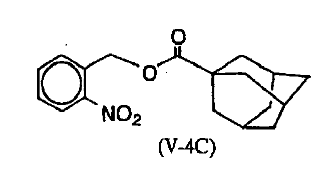

In the present invention, the compound of (A1) and the compound of (A4) can be used in combination at the following ratio. The ratio of compound of (A1)/compound of (A4) is, in terms of the molar ratio, from 100/0 to 10/90, preferably from 90/10 to 30/70, more preferably from 80/20 to 40/60.

### (Other Compounds Capable of Generating Acid upon Irradiation of Actinic Rays or Radiation)

Furthermore, a compound capable of generating an acid upon irradiation of radiation, other than the compounds of (A1), (A2), (A3) and (A4), may also be used in combination.

The ratio of the compounds (total amount) of (A1), (A2), (A3) and (A4) to the compound capable of generating an acid upon irradiation of radiation, which can be further used in combination, is, in terms of the molar ratio, from 100/0 to 10/90, preferably from 98/2 to 40/60, more preferably from 95/5 to 50/50.

Such a compound capable of generating an acid upon irradiation of actinic rays or radiation, which can be further used in combination, may be appropriately selected from a photoinitiator for cationic polymerization, a photoinitiator for photoradical polymerization, a photo-decoloring agent for coloring matters, a photo-discoloring agent, a compound capable of generating an acid upon irradiation of known light used for microresist or the like, and a mixture thereof.

Examples thereof include an onium salt such as diazonium salt described in S.I. Schlesinger, Photogr. Sci. Eng., 18, 387 (1974), and T.S. Bal et al., Polymer, 21, 423 (1980), ammonium salt described in U.S. Patents 4,069,055, 4,069,056 and Re27,992, and JP-A-3-140140, phosphonium salt described in D.C. Necker et al., Macromolecules, 17, 2468 (1984), C.S. Wen et al., Teh, Proc. Conf. Rad. Curing ASIA, p. 478, Tokyo, Oct. (1988), and U.S. Patents 4,069,055 and 4,069,056, iodonium salt described in J.V. Crivello et al., Macromolecules, 10 (6), 1307 (1977), Chem. & Eng. News, Nov. 28, page 31 (1988), European Patents 104,143, 339,049 and 410,201, JP-A-2-150848, and JP-A-2-296514, sulfonium salt described in J.V. Crivello et al., Polymer J., 17, 73 (1985), J.V. Crivello et al., J. Org. Chem., 43, 3055 (1978), W.R. Watt et al., J. Polymer Sci., Polymer Chem. Ed., 22, 1789 (1984), J.V. Crivello et al., Polymer Bull., 14, 279 (1985), J.V. Crivello et al., Macromolecules, 14 (5), 1141 (1981), J.V. Crivello et al., J. Polymer Sci., Polymer Chem. Ed., 17, 2877 (1979), European Patents 370,693, 161,811, 410,201, 339,049, 233,567, 297,443 and 297,442, U.S. Patents 3,902,114, 4,933,377, 4,760,013, 4,734,444 and 2,833,827, German Patents 2,904,626, 3,604,580 and 3,604,581, selenonium salt described in J.V. Crivello et al., Macromolecules, 10 (6), 1307 (1977), J.V. Crivello et al., J. Polymer Sci., Polymer Chem. Ed., 17, 1047 (1979), and arsonium salt described in C.S. Wen et al., Teh, Proc. Conf. Rad. Curing ASIA, p. 478, Tokyo, Oct. (1988); an organic halogen compound described in U.S. Patent 3,905,815, JP-B-46-4605 (the term "JP-B" as used herein means an "examined Japanese patent publication"), JP-A-48-36281, JP-A-55-32070, JP-A-60-239736, JP-A-61-169835, JP-A-61-169837, JP-A-62-58241, JP-A-62-212401, JP-A-63-70243 and JP-A-63-298339; an organic metal/an organic halide described in K. Meier et al., J. Rad. Curing, 13 (4), 26 (1986), T.P. Gill et al., Inorg. Chem., 19, 3007 (1980), D. Astruc, Acc. Chem. Res., 19 (12), 377 (1896) and JP-A-2-161445; a photoacid generator having an o-nitrobenzyl type protective group described in S. Hayase et al., J. Polymer Sci., 25, 753 (1987), E. Reichmanis et al., J. Polymer Sci., Polymer Chem. Ed., 23, 1 (1985), Q.Q. Zhu et al., J. Photochem., 36, 85, 39, 317 (1987), B. Amit et al., Tetrahedron Lett., (24) 2205 (1973), D.H.R. Barton et al., J. Chem. Soc., 3571 (1965), P.M. Collins et al., J. Chem. Soc., Perkin I, 1695 (1975), M. Rudinstein et al., Tetrahedron Lett., (17), 1445 (1975), J.W. Walker et al., J. Am. Chem. Soc., 110, 7170 (1988), S.C. Busman et al., J. Imaging Technol., 11 (4), 191 (1985), H.M. Houlihan et al., Macromolecules, 21, 2001 (1988), P.M. Collins et al., J. Chem. Commun., 532 (1972), S. Hayase et al., Macromolecules, 18, 1799 (1985), E. Reichmanis et al., J. Electrochem. Soc., Solid State Sci. Technol., 130 (6), F.M. Houlihan et al., Macromolecules, 21, 2001 (1988), European Patents 0,290,750, 046,083, 156,535, 271,851 and 0,388,343, U.S. Patents 3,901,710 and 4,181,531, JP-A-60-198538 and JP-A-53-133022; a compound capable of photochemically decomposing to generate a sulfonic acid, as represented by iminosulfonate, described in M. TUNOOKA et al., Polymer Preprints Japan, 35 (8), G. Bemer et al., J. Rad. Curing, 13 (4), W.J. Mijs et al., Coating Technol., 55 (697), 45 (1983), Akzo, H. Adachi et al., Polymer Preprints, Japan, 37 (3), European Patents 0,199,672, 84,515, 044,115, 618,564 and 0,101,122, U.S. Patents 4,371,605 and 4,431,774, JP-A-64-18143, JP-A-2-245756 and JP-A-3-140109; and a disulfone compound described in JP-A-61-166544.

Furthermore, a compound obtained by incorporating such a group or compound capable of generating an acid by the effect of light into the main or side chain of a polymer can be used, and examples thereof include the compounds described in M.E. Woodhouse et al., J. Am. Chem. Soc., 104, 5586 (1982), S.P. Pappas et al., J. Imaging Sci., 30 (5), 218 (1986), S. Kondo et al., Makromol. Chem., Rapid Commun., 9, 625 (1988), Y. Yamada et al., Makromol. Chem., 152, 153, 163 (1972), J.V. Crivello et al., J. Polymer Sci., Polymer Chem. Ed., 17, 3845 (1979), U.S. Patent 3,849,137, German Patent 3,914,407, JP-A-63-26653, JP-A-55-164824, JP-A-62-69263, JP-A-63-146038, JP-A-63-163452, JP-A-62-153853 and JP-A-63-146029.

Also, a compound capable of generating an acid by the effect of light described, for example, in V.N.R. Pillai, Synthesis, (1), 1 (1980), A. Abad et al., Tetrahedron Lett., (47) 4555 (1971), D.H.R. Barton et al., J. Chem. Soc., (C), 329 (1970), U.S. Patent 3,779,778 and European Patent 126,712 may be used.

### (BP) Polymer which is insoluble or sparingly soluble in an aqueous alkali solution but becomes soluble in an aqueous alkali solution under the action of an acid (sometimes referred to as a "component (BP)")

The component (BP) for use in the positive resist composition of the present invention is a resin having a group capable of decomposing under the action of an acid, in the main or side chain or both main and side chains of the resin. A resin having a group capable of decomposing under the action of an acid, in the side chain is preferred.

Preferred examples of the group capable of decomposing under the action of an acid include a -COOA⁰ group and a -0-B⁰ group.

A⁰ represents -C(R⁰¹)(R⁰²)(R⁰³), -Si(R⁰¹)(R⁰²)(R⁰³) or -C(R⁰⁴)(R⁰⁵)-O-R⁰⁶, and B⁰ represents A° or a -CO-O-A⁰ group. R⁰¹ to R⁰⁶, which may be the same or different, each represents an alkyl group which may have a substituent, a cycloalkyl group which may have a substituent, an alkenyl group which may have a substituent, an aralkyl group which may have a substituent, or an aryl group which may have a substituent.

Preferred examples of the acid-decomposable group include a silyl ether group, a cumyl ester group, an acetal group, a tetrahydropyranyl ether group, an enol ether group, an enol ester group, a tertiary alkyl ether group, a tertiary alkyl ester group and a tertiary alkyl carbonate group. Among these, more preferred are a tertiary alkyl ester group, a tertiary alkyl carbonate group, a cumyl ester group, an acetal group and a tetrahydropyranyl ether group, and still more preferred is a tert-butoxycarbonyl group.

In the case where such a group capable of decomposing under the action of an acid is bonded as a side chain, the matrix resin is an alkali-soluble resin having a -OH or -COOH group in the side chain. Examples thereof include alkali-soluble resins which are described later.

The alkali-soluble resin preferably has an alkali dissolution rate of 170 A/sec or more, more preferably 330 A/sec or more (A is angstrom), as measured (23°C) with 0.261 N tetramethylammonium hydroxide (TMAH).

From this standpoint, preferred alkali-soluble resins are an o-, m- or p-(hydroxystyrene) copolymer, a hydrogenated poly(hydroxystyrene), a halogen- or alkylsubstituted poly(hydroxystyrene), a partially O-alkylated or O-acylated poly(hydroxystyrene), a styrene-hydroxystyrene copolymer, an α-methylstyrene-hydroxystyrene copolymer and a hydrogenated novolak resin.

As for the component (BP), a resin having a structural unit containing a group represented by formula (X1) or (X2) is also preferred.

In formula (X1), R_{1b} and R_{2b}, which may be the same or different, each represents a hydrogen atom or an alkyl group. R_{3b} and R_{4b}, which may be the same or different, each represents a hydrogen atom, an alkyl group which may have a substituent, or a cycloalkyl group which may have a substituent. R_{5b} represents an alkyl group which may have a substituent, a cycloalkyl group which may have a substituent, an aryl group which may have a substituent, or an aralkyl group which may have a substituent. m represents an integer of 0 to 20, and n represents an integer of 0 to 5.

In formula (X2), R_{6b} and R_{7b}, which may be the same or different, each represents a hydrogen atom or an alkyl group. W represents a divalent organic group. R_{8b} represents an alkyl group which may have a substituent, a cycloalkyl group which may have a substituent, an aryl group which may have a substituent, or an aralkyl group which may have a substituent.

The alkyl group of R⁰¹ to R⁰⁶ and R_{1b} to R_{8b} may be either linear or branched and is preferably an alkyl group having a carbon number of 1 to 4, which may have a substituent, such as methyl group, ethyl group, propyl group, n-butyl group, sec-butyl group and tert-butyl group.

The cycloalkyl group of R⁰¹ to R⁰⁶, R_{3b} to R_{5b} and R_{8b} is preferably a cycloalkyl group having a carbon number of 3 to 8, which may have a substituent, such as cyclopropyl group, cyclopentyl group and cyclohexyl group.

The alkenyl group of R⁰¹ to R⁰⁶ is preferably an alkenyl group having a carbon number of 2 to 8, and examples thereof include a vinyl group, an allyl group, a butenyl group and a cyclohexenyl group.

The aralkyl group of R⁰¹ to R⁰⁶, R_{5b} and R_{8b} is preferably an aralkyl group having a carbon number of 7 to 12, and examples thereof include a benzyl group, a phenethyl group and a naphthylmethyl group.

The aryl group of R⁰¹ to R⁰⁶, R_{5b} and R_{8b} is preferably an aryl group having a carbon number of 6 to 15, and examples thereof include a phenyl group, a tolyl group, a naphthyl group and an anthryl group.

Examples of the further substituent in the above-described alkyl group, cycloalkyl group, alkenyl group, aralkyl group and aryl group include a carboxyl group, an acyloxy group, a cyano group, an aryl group, an alkyl group, a cycloalkyl group, a halogen atom, a hydroxyl group, an alkoxy group, an acetylamide group, an alkoxycarbonyl group and an acyl group.

The divalent organic group in W is preferably a linear, branched or cyclic alkylene group, arylene group, heteroarylene group or aralkylene group which may have a substituent, - S-, -C(=O)-, -N(R_{4c})-, -SO-, -SO₂- -CO₂-, -N(R_{4c})SO₂-, or a divalent group comprising a combination of two or more of these groups. R_{4c} represents a hydrogen atom or an alkyl group (specific examples of the alkyl group are the same as those described for R⁰¹ and the like).

The component (BP) for use in the present invention can be obtained by reacting a precursor of a group capable of decomposing under the action of an acid with an alkali-soluble resin or by copolymerizing an alkali-soluble resin monomer having bonded thereto a group capable of decomposing under the action of an acid with various monomers, and this is disclosed, for example, in European Patent 254,853, JP-A-2-25850, JP-A-3-223860 and JP-A-4-251259.

Specific examples of the component (BP) for use in the present invention are set forth below, but the present invention is not limited thereto.

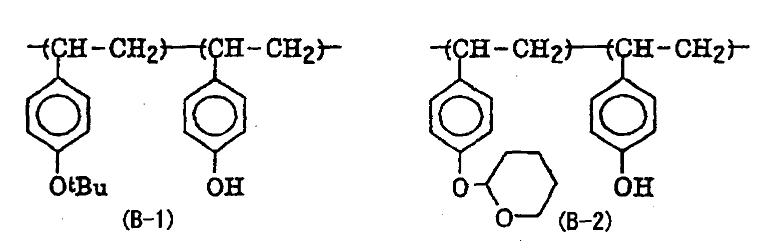

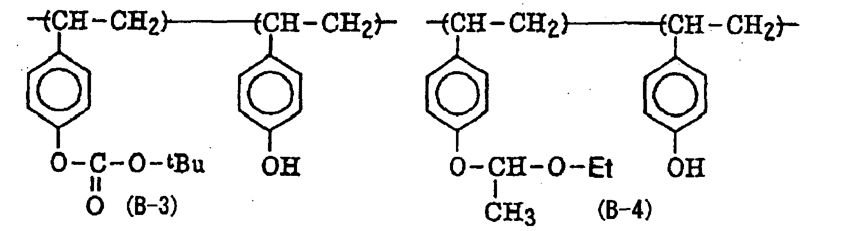

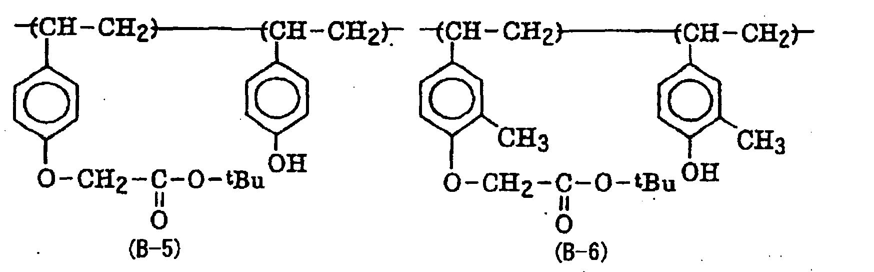

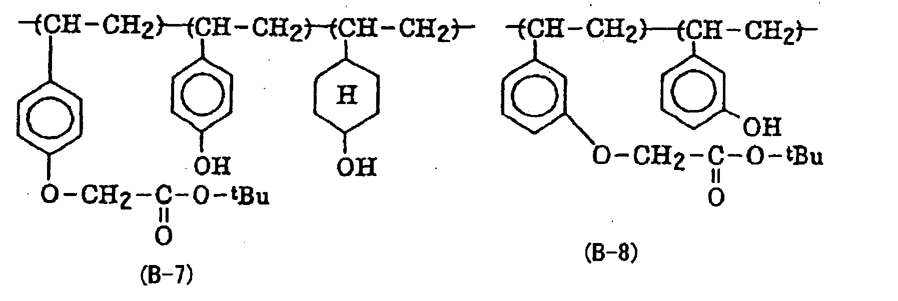

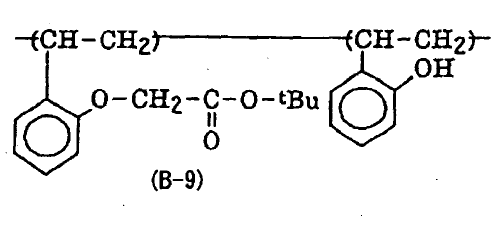

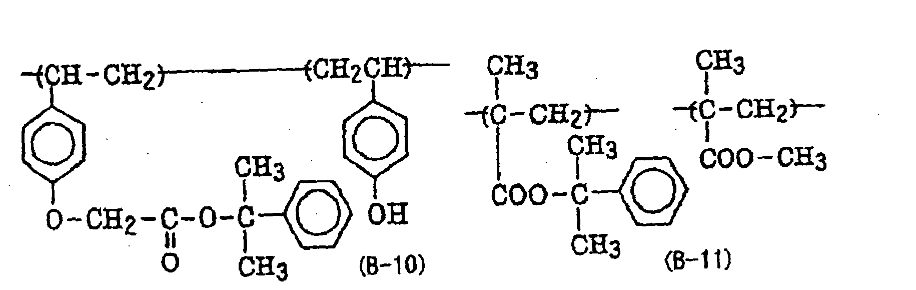

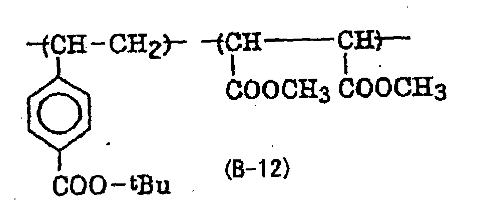

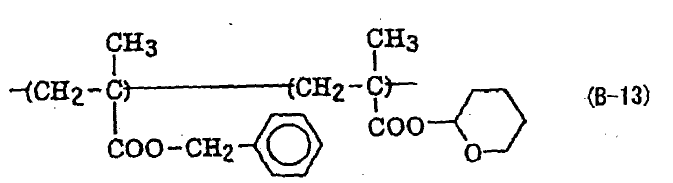

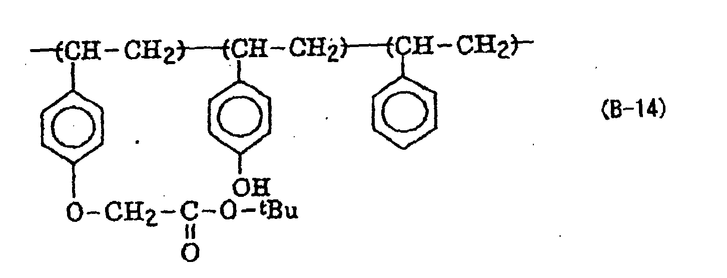

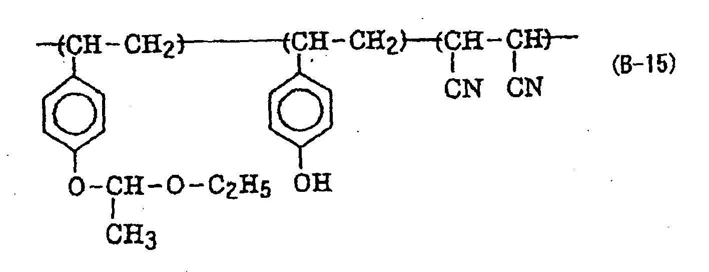

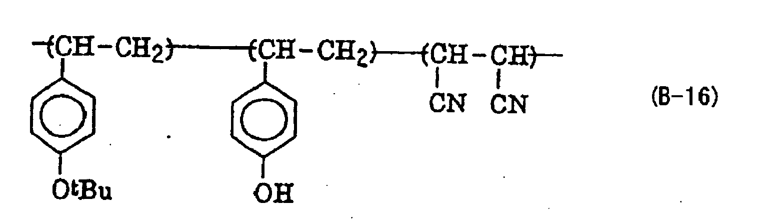

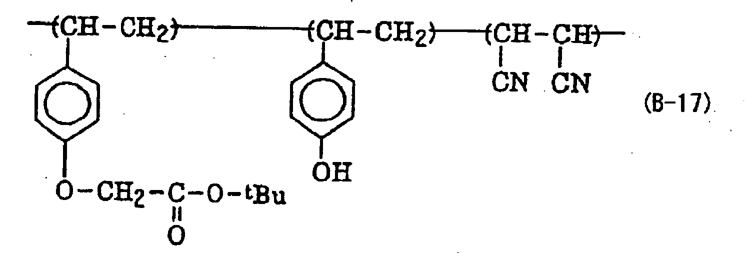

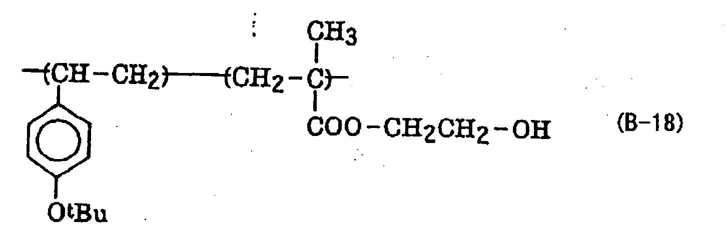

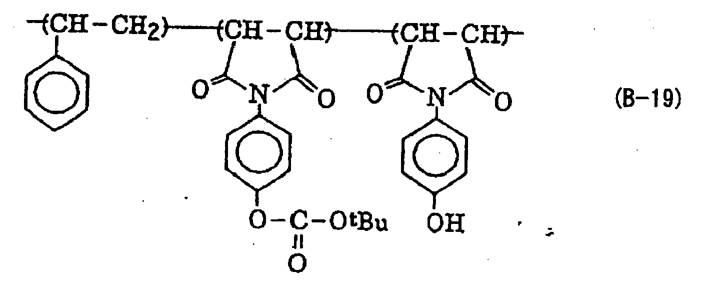

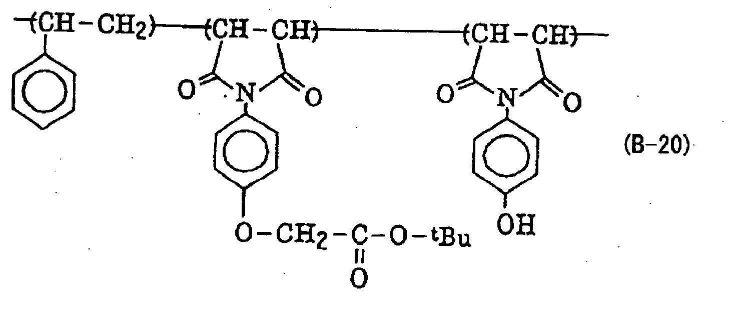

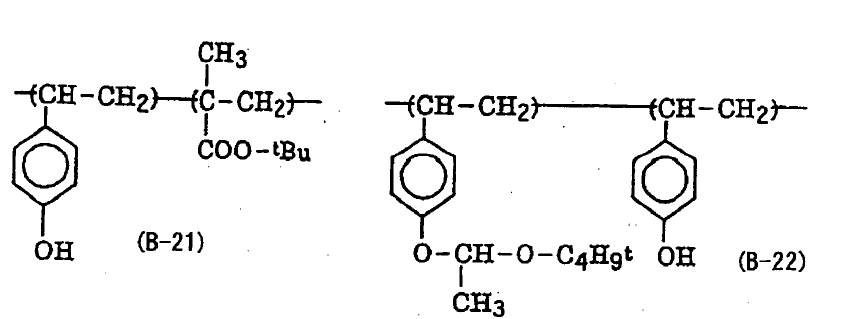

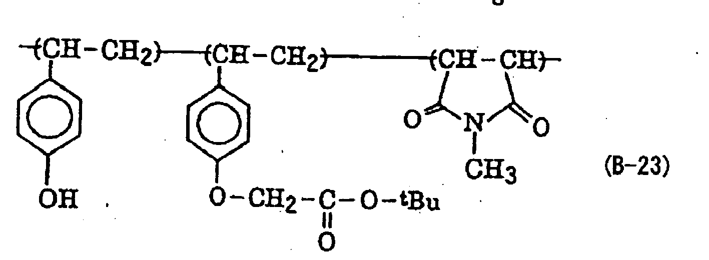

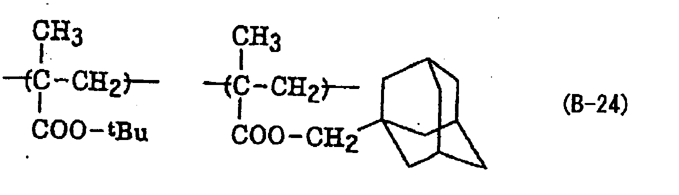

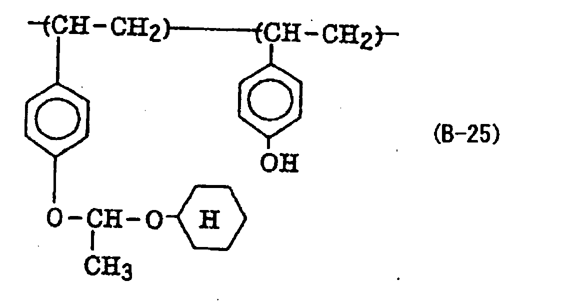

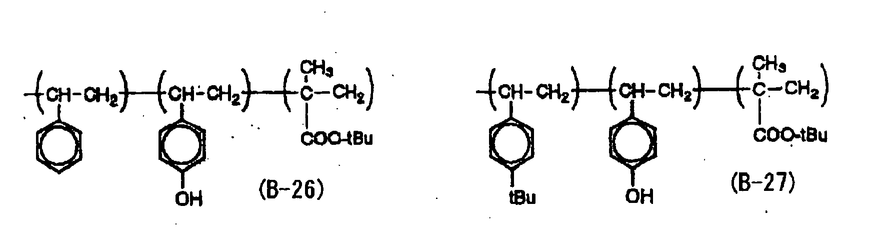

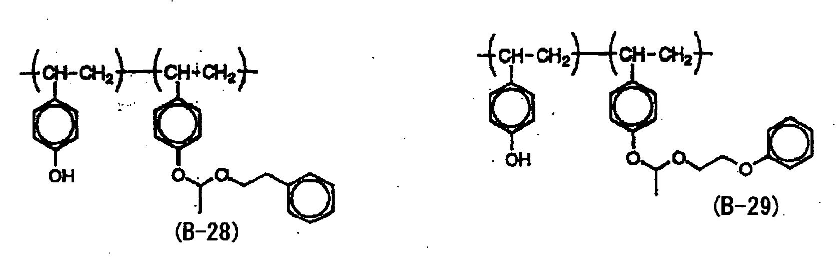

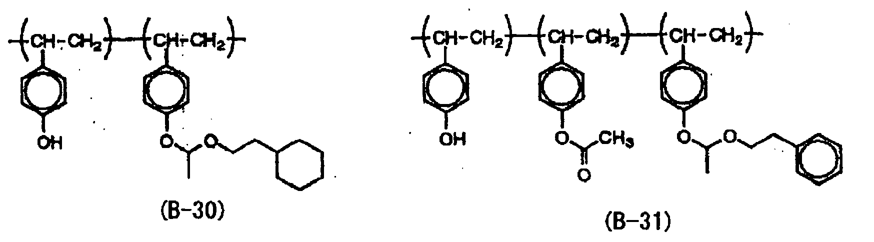

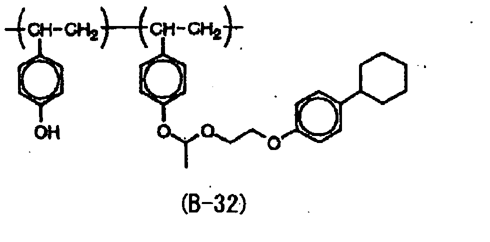

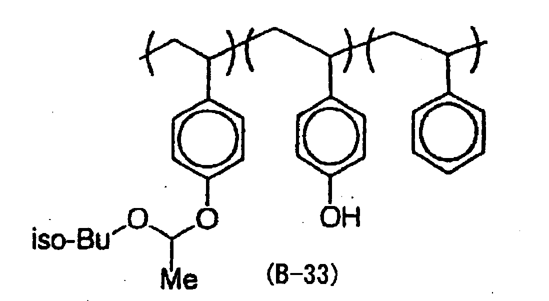

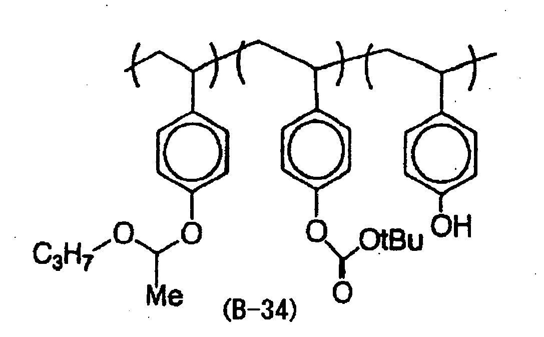

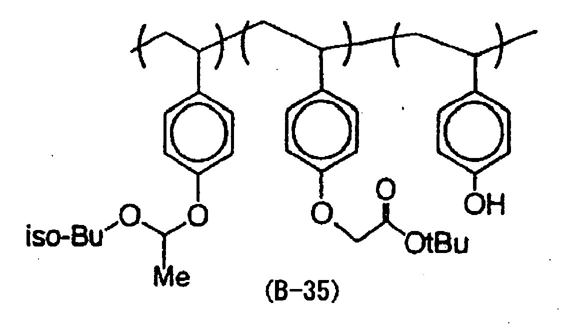

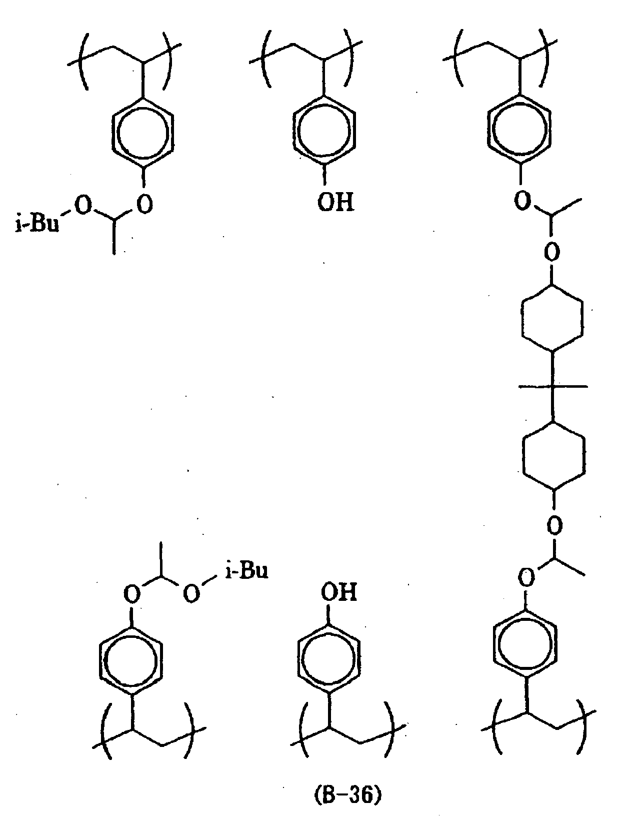

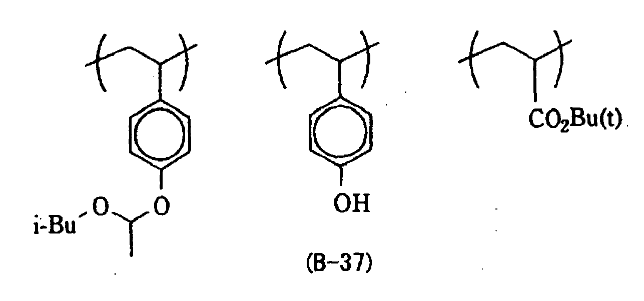

In view of the film shrinkage after PEB, adhesion to substrate, reduction of scumming, and standing wave on the pattern side wall, the content of the group capable of decomposing under the action of an acid, which is expressed by B/(B+S) using the number (B) of groups capable of decomposing under the action of an acid and contained in the resin and the number (S) of alkali-soluble groups not protected by a group capable of decomposing under the action of an acid, is preferably from 0.01 to 0.7, more preferably from 0.05 to 0.50, still more preferably from 0.05 to 0.40.

The weight average molecular weight (Mw) of the component (BP) is preferably from 2,000 to 200,000, more preferably from 5,000 to 100,000, still more preferably from 8,000 to 50,000.

The molecular weight distribution (Mw/Mn) is preferably from 1.0 to 4.0, more preferably from 1.0 to 2.0, still more preferably from 1.0 to 1.6.

The weight average molecular weight as used herein is defined by the polystyrene-reduced value according to gel permeation chromatography.

The polymers as the component (BP) may be used in combination of two or more thereof.

The amount added of the polymer as the component (BP) is suitably from 70 to 98 mass%, preferably from 80 to 96 mass%, based on the solid content of the positive resist composition. (BN) Alkali-soluble resin (hereinafter sometimes referred to as a "component (BN)" or a "resin of (BN)")

As for the alkali-soluble resin for use in the present invention, polymers having a phenol skeleton heretofore disclosed for resist can be widely used, such as phenol novolak resin, polyvinylphenol resin, copolymer having a structural unit derived from vinylphenol, and resin obtained by partially protecting or modifying a polyvinylphenol resin.

The resin as the component (BN) is preferably a resin having a repeating unit represented by formula (a): 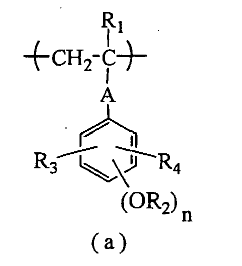 wherein R₁ represents a hydrogen atom, a halogen atom, a cyano group or an alkyl group,
R₂ represents a hydrogen atom, an alkyl group, a cycloalkyl group, an aryl group, an aralkyl group or an acyl,
R₃ and R₄, which be the same or different, each represents a hydrogen atom, a halogen atom, a cyano group, an alkyl group, a cycloalkyl group, an alkenyl group, an aralkyl group or an aryl group,
A represents a single bond, an alkylene, alkenylene, cycloalkylene or arylene group which may have a substituent, -O-, -SO₂-, -O-CO-R₅-, -CO-O-R₆- or -CO-N(R₇)-R₈-,
R₅, R₆ and R₈, which may be the same or different, each represents a single bond, an alkylene group, an alkenylene group, a cycloalkylene group, an arylene group, or a divalent group formed by combining at least one of these groups with at least one structure selected from the group consisting of an ether structure, an ester structure, an amide structure, a urethane structure and a ureido structure,
R₇ represents a hydrogen atom or an alkyl, cycloalkyl, aralkyl or aryl group which may have a substituent,
n represents an integer of 1 to 3, and
a plurality of R₂'s or a pair of R₂ and R₃ or R₄ may combine to form a ring.

The resin is more preferably a phenol resin having a repeating structural unit represented by formula (a).

The alkyl group of R₁ to R₄ and R₇ is, for example, an alkyl group having a carbon number of 1 to 8, and specific preferred examples thereof include a methyl group, an ethyl group, a propyl group, an n-butyl group, a sec-butyl group, a hexyl group, a 2-ethylhexyl group, an octyl group and a haloalkyl group (e.g., chloromethyl, chloroethyl, chloropropyl, chlorobutyl, bromomethyl, bromoethyl). The cycloalkyl group of R₂ to R₄ and R₇ may be monocyclic or polycyclic. Preferred examples of the monocyclic cycloalkyl group include a cycloalkyl group having a carbon number of 3 to 8, such as cyclopropyl group, cyclopentyl group and cyclohexyl group. Preferred examples of the polycyclic cycloalkyl group include an adamantyl group, a norbornyl group, an isoboronyl group, a dicyclopentyl group, an α-pinel group and a tricyclodecanyl group.

The alkenyl group of R₃ and R₄ is, for example, an alkenyl group having a carbon number of 2 to 8, and specific preferred examples thereof include a vinyl group, an allyl group, a butenyl group and a cyclohexenyl group.

The aryl group of R₂ to R₄ and R₇ is, for example, an aryl group having a carbon number of 6 to 15, and specific preferred examples thereof include a phenyl group, a tolyl group, a dimethylphenyl group, a 2,4,6-trimethylphenyl group, a naphthyl group and an anthryl group.

The aralkyl group of R₂ to R₄ and R₇ is, for example, an aralkyl group having a carbon number of 7 to 12, and specific preferred examples thereof include a benzyl group, a phenethyl group and a naphthylmethyl group.

The acyl group of R₂ is, for example, an acyl group having a carbon number of 1 to 8, and specific preferred examples thereof include a formyl group, an acetyl group, a propanoyl group, a butanoyl group, a pivaloyl group and benzoyl group.

The alkylene group of A, R₅, R₆ and R₈ is preferably an alkylene group having a carbon number of 1 to 8, which may have a substituent, such as methylene group, ethylene group, propylene group, butylene group, hexylene group and octylene group.

The alkenylene group of A, R₅, R₆ and R₈ is preferably an alkenylene group having a carbon number of 2 to 6, which may have a substituent, such as ethenylene group, propenylene group and butenylene group.

The cycloalkylene group of A, R₅, R₆ and R₈ is preferably a cycloalkylene group having a carbon number of 5 to 8, which may have a substituent, such as cyclopentylene group and cyclohexylene group.

The arylene group of A, R₅, R₆ and R₈ is preferably an arylene group having a carbon number of 6 to 12, which may have a substituent, such as phenylene group, tolylene group and naphthylene group.

Examples of the substituent substituted to these groups include those having active hydrogen, such as amino group, amido group, ureido group, urethane group, hydroxyl group and carboxyl group, a halogen atom (e.g., fluorine, chlorine, bromine, iodine), an alkoxy group (e.g., methoxy, ethoxy, propoxy, butoxy), a thioether group, an acyl group (e.g., acetyl, propanoyl, benzoyl), an acyloxy group (e.g., acetoxy, propanoyloxy, benzoyloxy), an alkoxycarbonyl group (e.g., methoxycarbonyl, ethoxycarbonyl, propoxycarbonyl), a cyano group and a nitro group. Among these, those having active hydrogen, such as amino group, hydroxyl group and carboxyl group, are preferred.

Examples of the ring formed by combining a plurality of R₂'s or combining a pair of R₂ and R₃ or R₄ include an oxygen atom-containing 4- to 7-membered ring such as benzofuran ring, benzodioxonol ring and benzopyran ring.

The resin (BN) for use in the present invention may be a resin comprising only the repeating unit represented by formula (a), but for the purpose of more enhancing the resist performance, another polymerizable monomer may be copolymerized.

Examples of the copolymerization monomer which can be used include a compound having one addition-polymerizable unsaturated bond selected from acrylic acid esters, acrylamides, methacrylic acid esters, methacrylamides, allyl compounds, vinyl ethers, vinyl esters, styrenes and crotonic acid esters.

Among these copolymerization components, preferred are a monomer having a carboxyl group, such as N-(carboxyphenyl)acrylamide and N-(carboxyphenyl)methacrylamide, and a monomer capable of enhancing the alkali solubility, such as maleimide.

The content of the another polymerizable monomer in the resin for use in the present invention is preferably 50 mol% or less, more preferably 30 mol% or less, based on all repeating units.

Specific examples of the resin having a repeating structural unit represented by formula (a) are set forth below, but the present invention is not limited thereto.

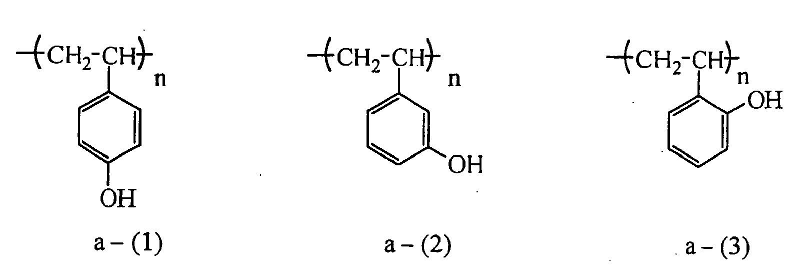

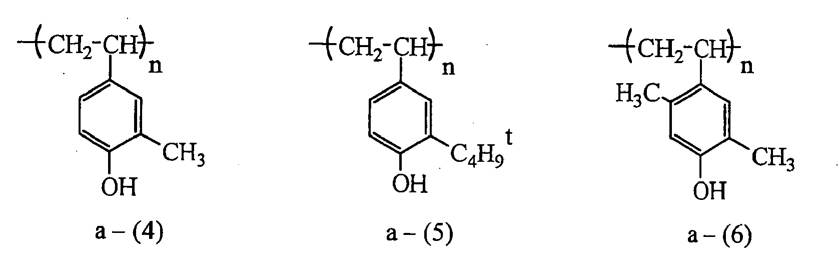

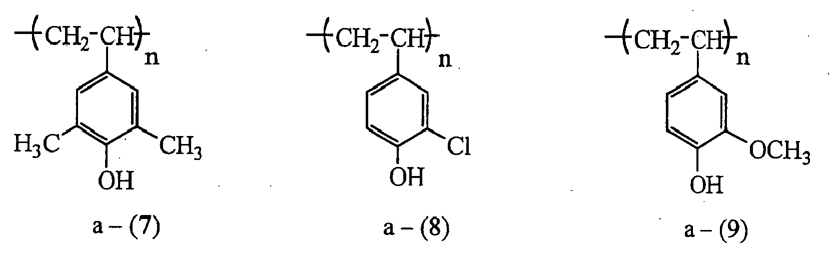

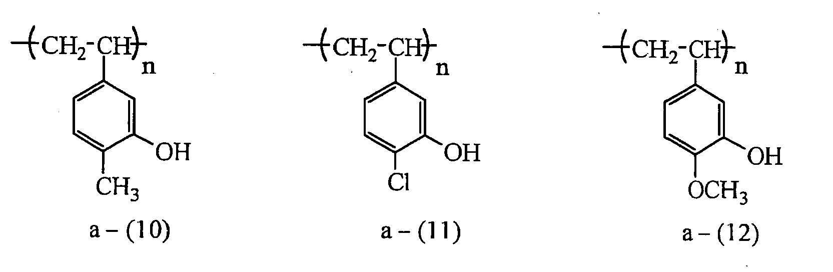

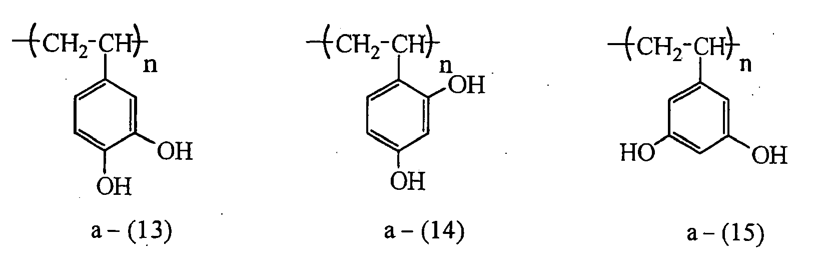

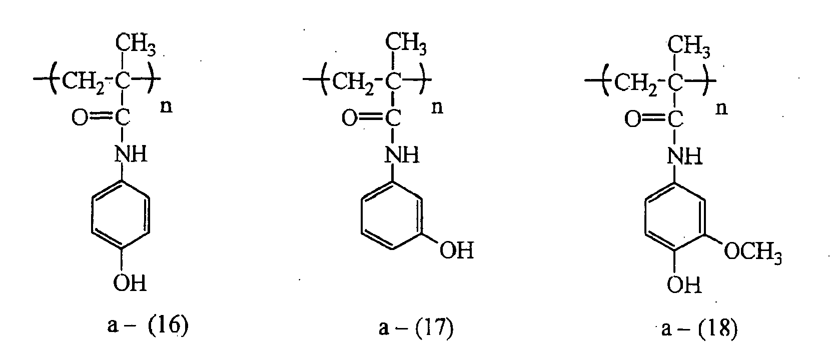

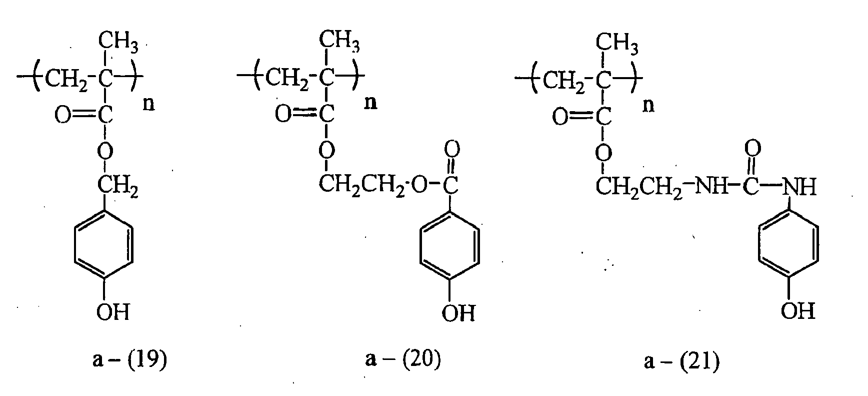

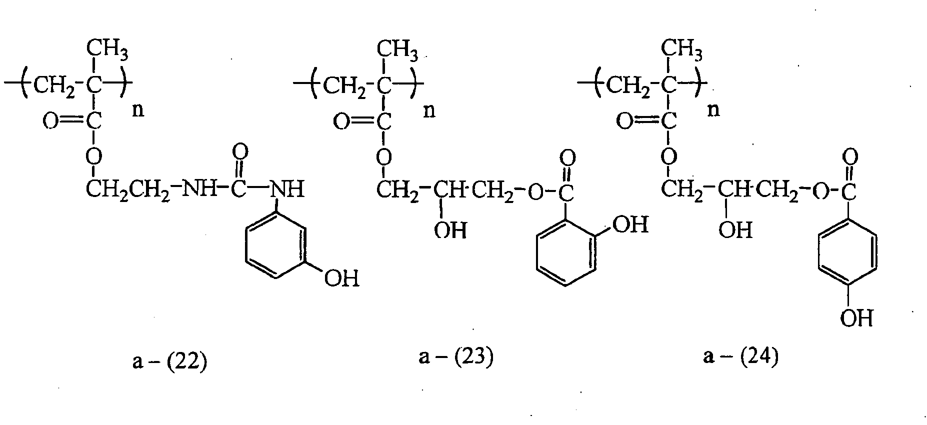

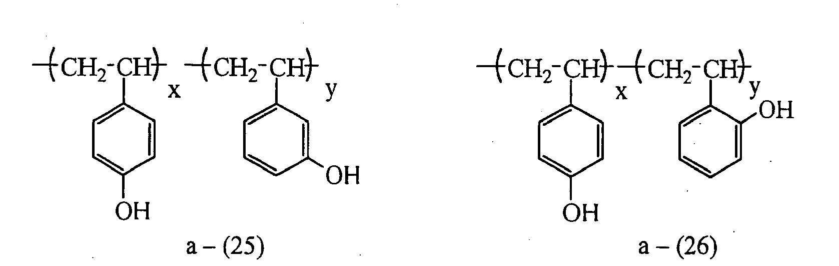

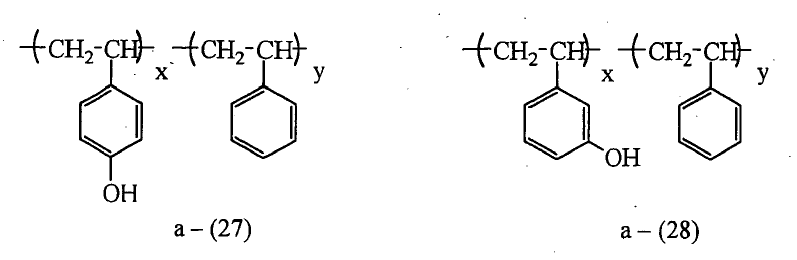

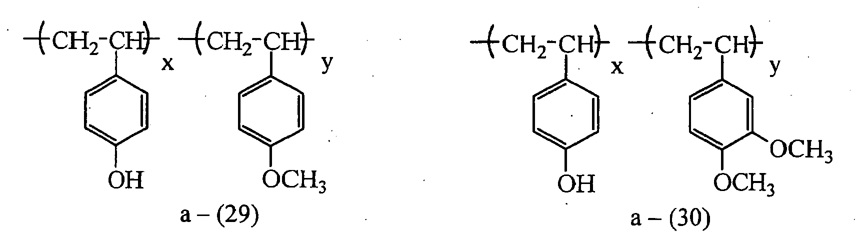

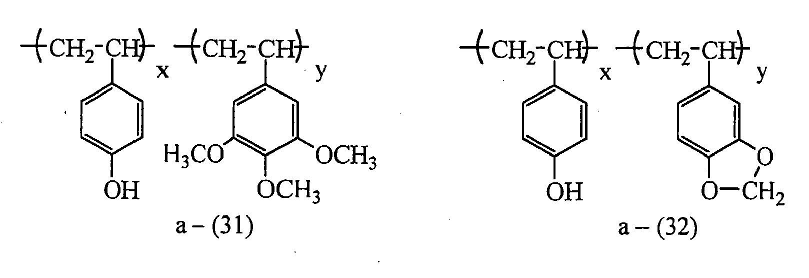

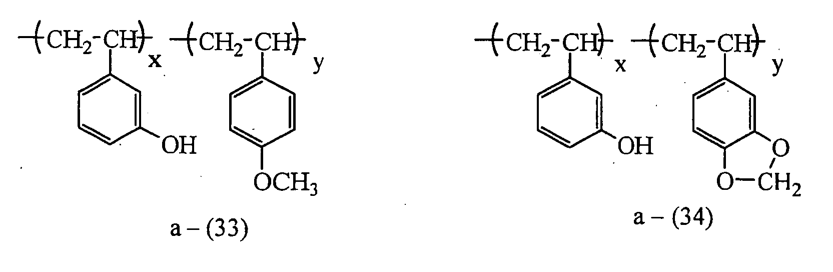

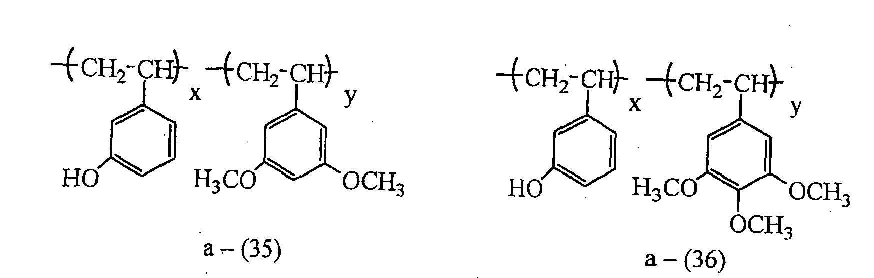

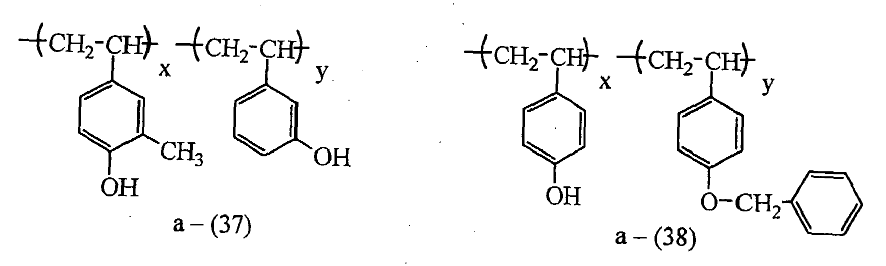

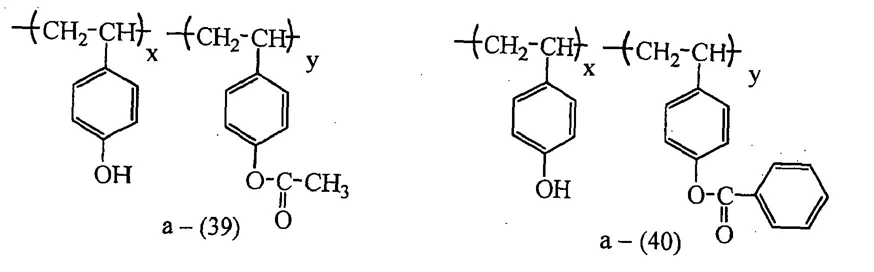

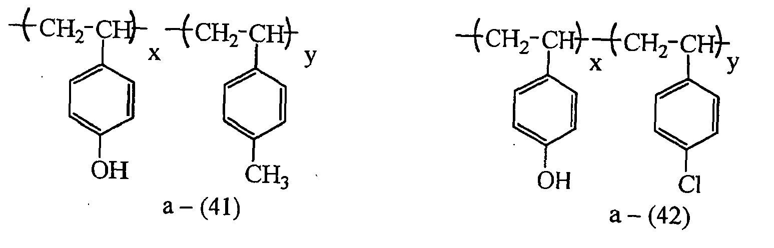

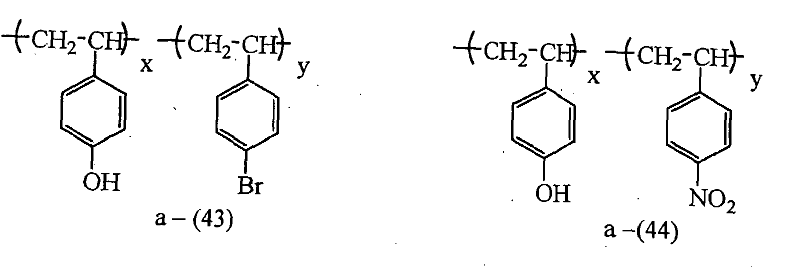

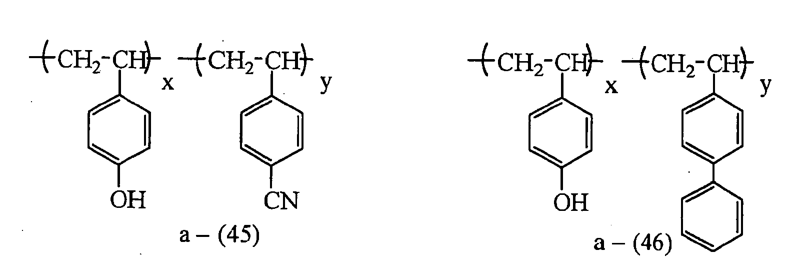

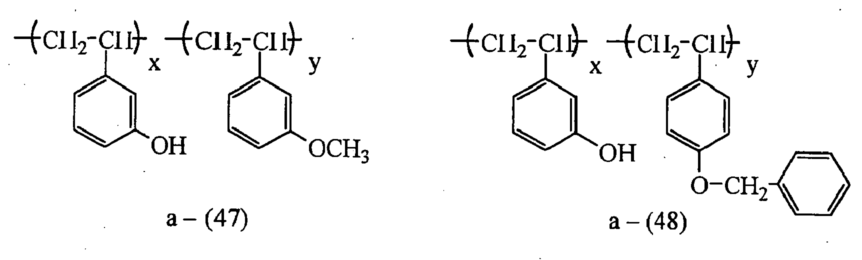

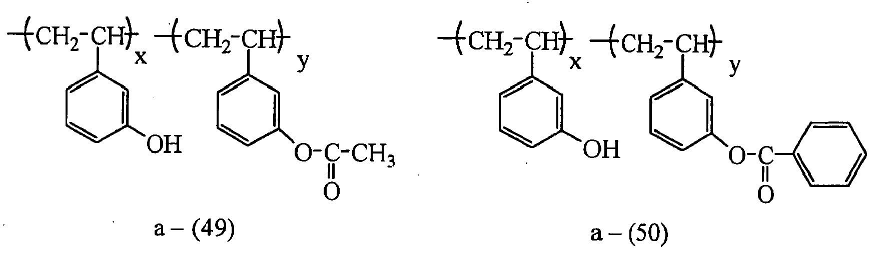

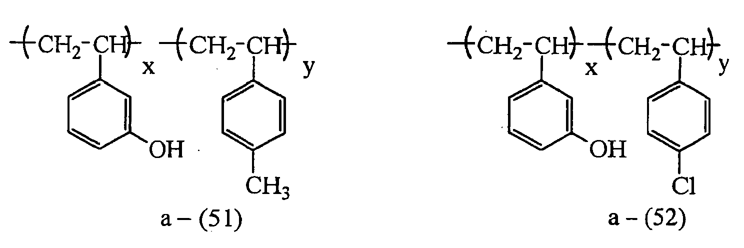

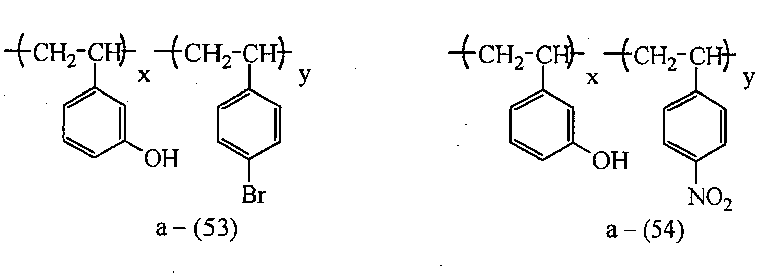

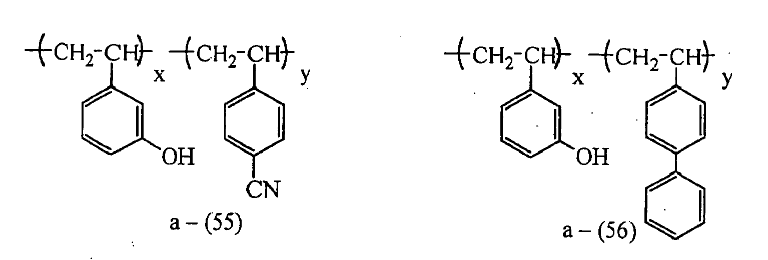

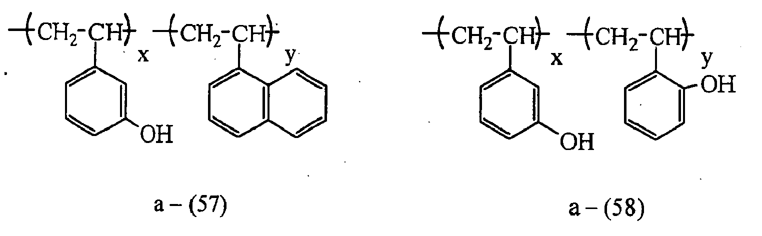

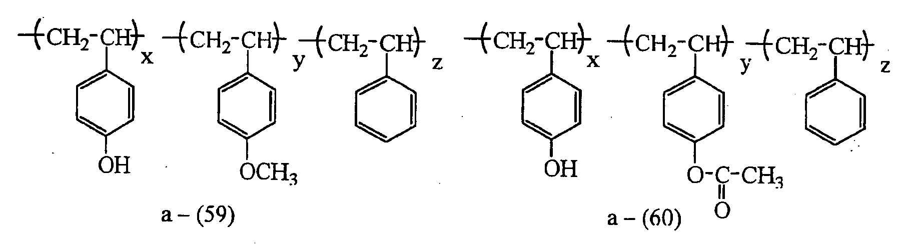

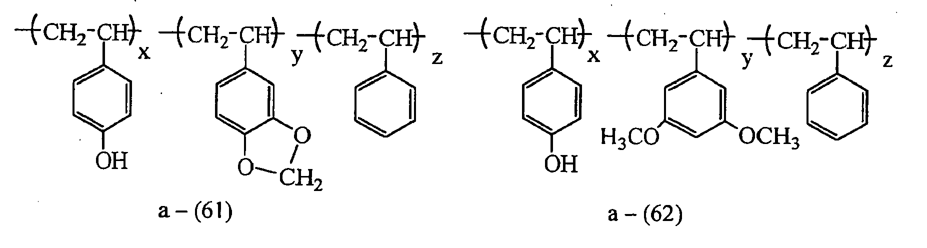

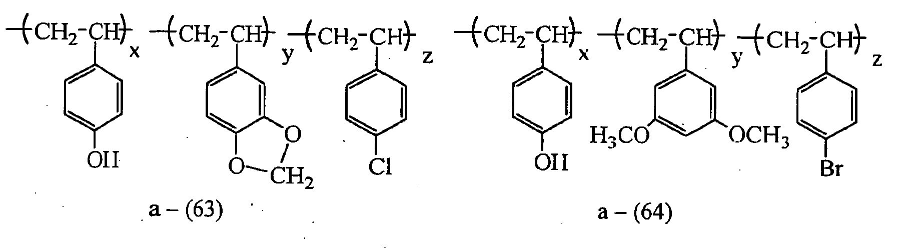

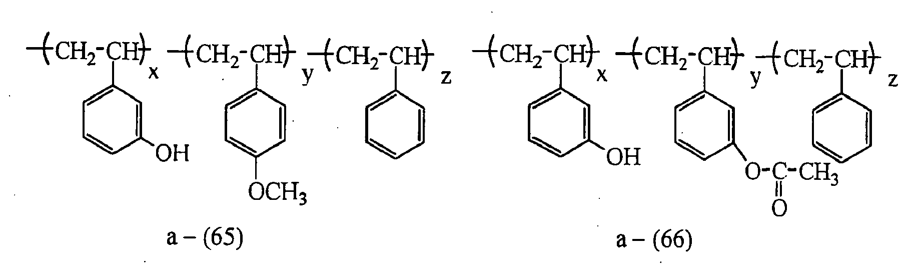

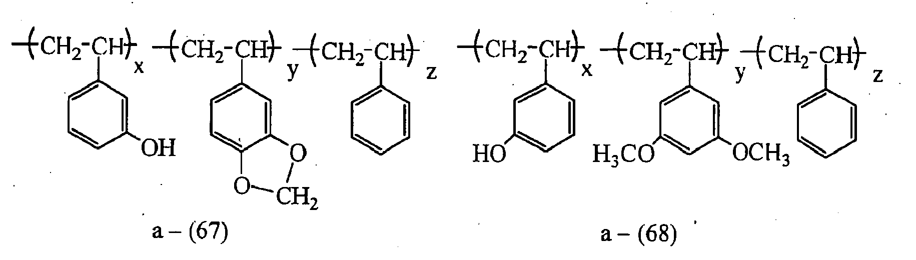

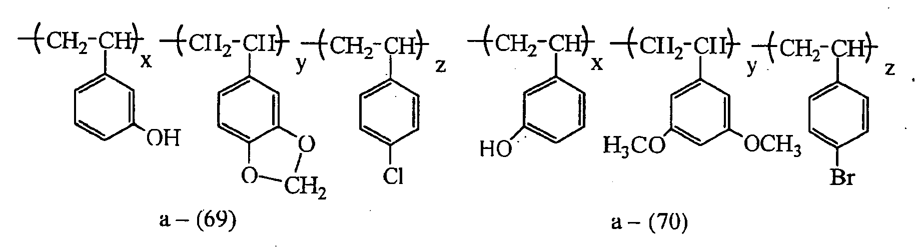

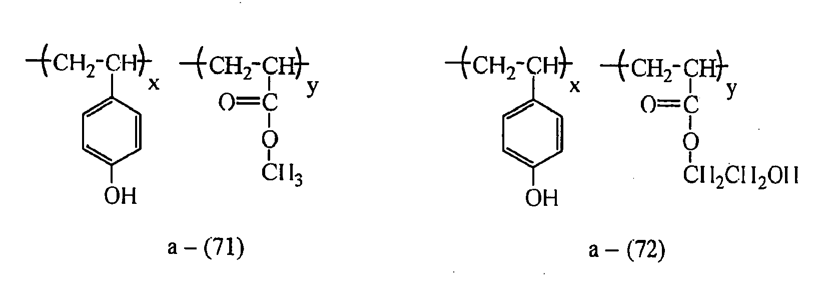

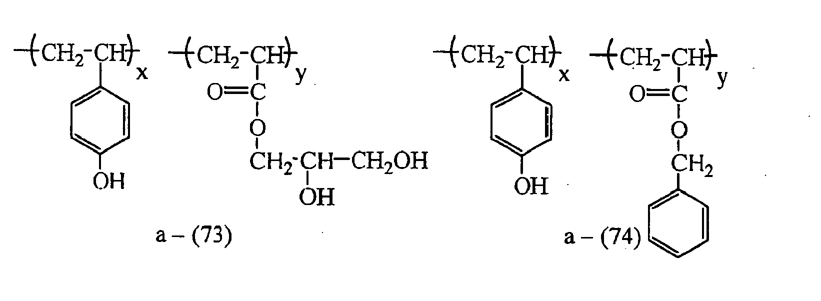

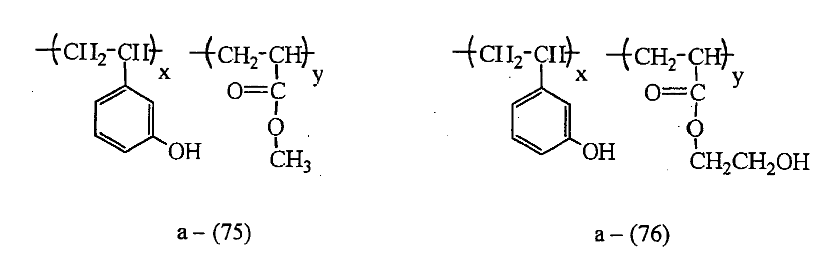

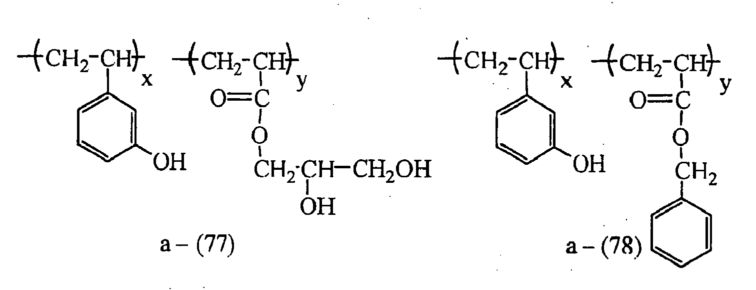

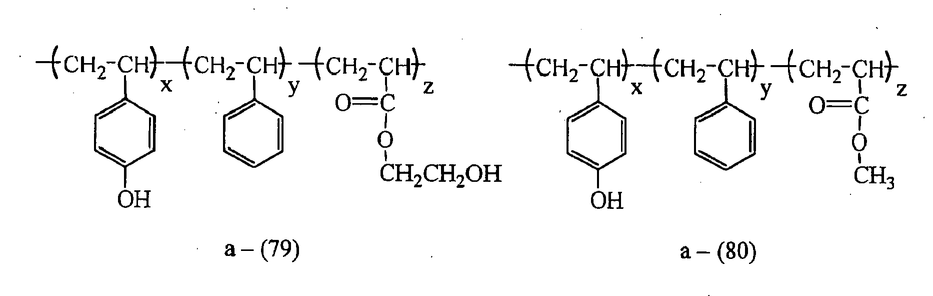

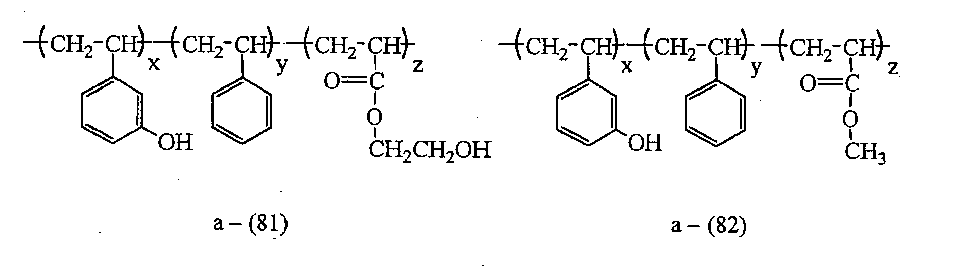

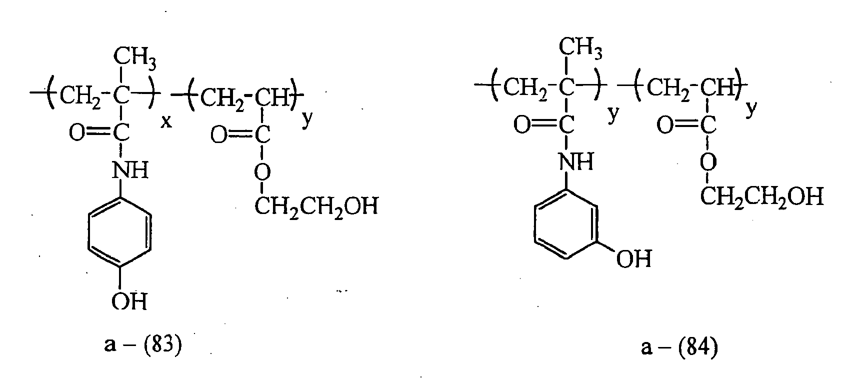

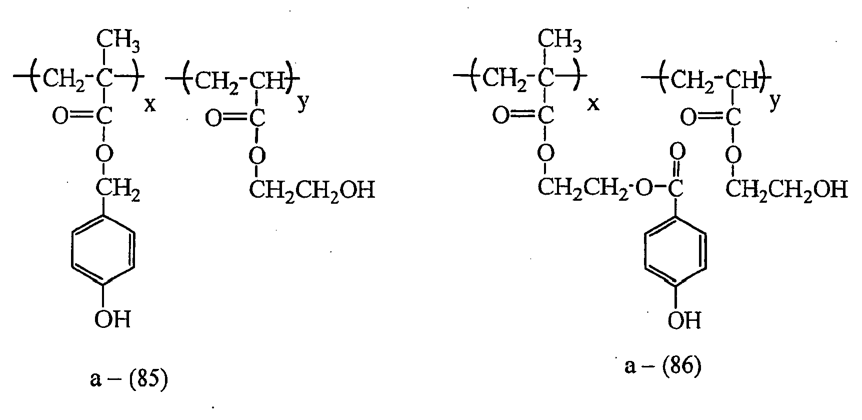

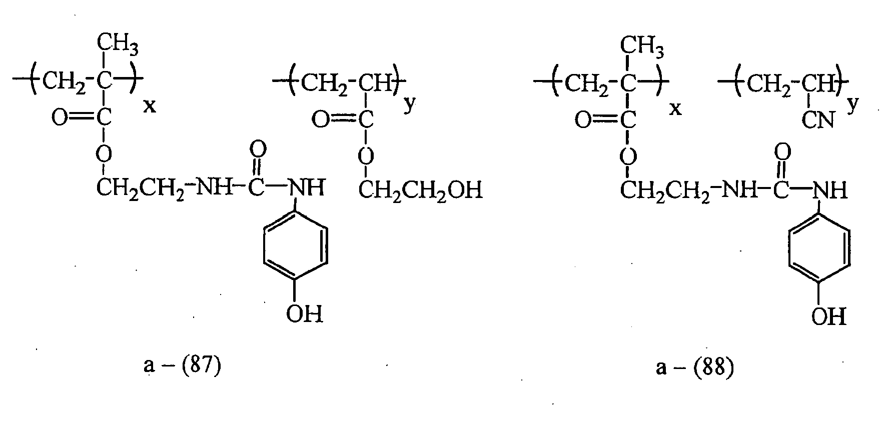

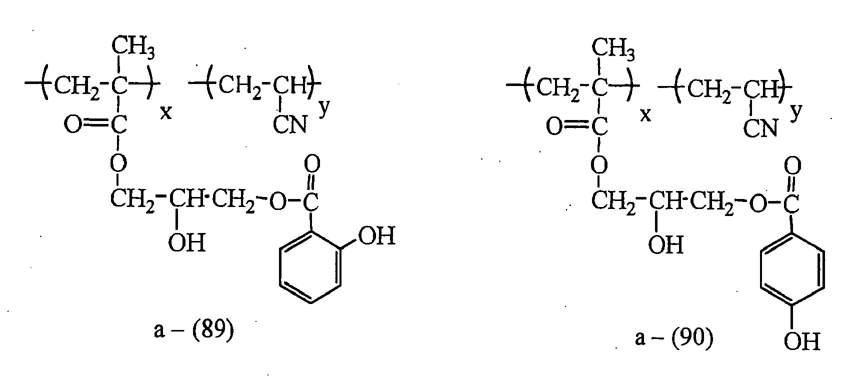

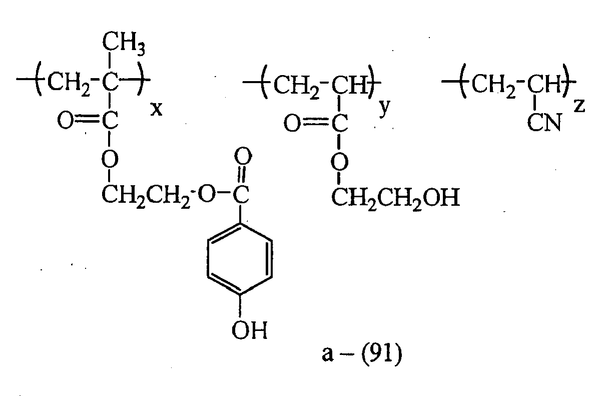

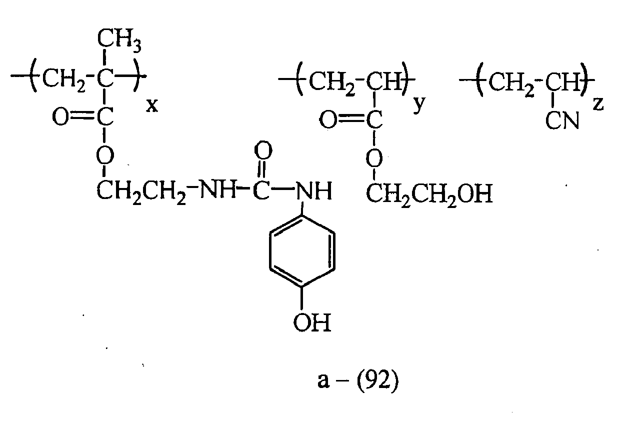

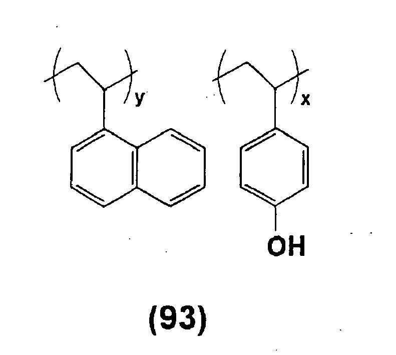

In these specific examples, n represents a positive integer, and x, y and z represent a molar ratio of the resin composition. In the case of a resin comprising two components, x=10 to 95 and y=5 to 90, preferably x=40 to 90 and y=10 to 60, and in the case of a resin comprising three components, x=10 to 90, y=5 to 85 and z=5 to 85, preferably x=40 to 80, y=10 to 50 and z=10 to 50.

The molecular weight of the resin of (BN) preferably having a structural unit represented by formula (a) is, in terms of the weight average molecular weight, preferably from 1,000 to 200,000, more preferably from 3,000 to 50,000. The molecular weight distribution is from 1 to 10, preferably from 1 to 3, more preferably from 1 to 1.5. As the molecular weight distribution is narrower, higher resolution, better resist profile, smoother side wall of resist pattern and more excellent roughness property are obtained.

The content of the repeating structural unit represented by formula (a) is from 5 to 100 mol%, preferably from 10 to 90 mol%, based on the resin having a repeating unit of formula (a).

The alkali-soluble resin containing a structural unit represented by formula (a) for use in the present invention can be synthesized by a method described in Macromolecules, 28(11), 3787-3789 (1995), Polym. Bull. (Berlin), 24(4), 385-389 (1990) or JP-A-8-286375. That is, the objective alkali-soluble resin can be obtained by radical polymerization or living anion polymerization.

One of such resins may be used or a plurality of these resins may be used as a mixture.

The weight average molecular weight as used herein is defined by the polystyrene-reduced value according to gel permeation chromatography.

The alkali dissolution rate of the alkali-soluble resin is preferably 20 Å/sec or more, more preferably 200 Å/sec or more, as measured (at 23°C) in 0.261N tetramethylammonium hydroxide (TMAH).

In the present invention, the alkali-soluble resin having a repeating unit represented by formula (a) may be used alone but may be used in combination with another alkali-soluble resin. As for the ratio of the resins used, the another alkali-soluble resin can be used in combination in an amount of maximally 100 parts by mass per 100 parts by mass of the alkali-soluble resin having a repeating unit represented by formula (a). Examples of the alkali-soluble resin which can be used in combination are described below.

For example, a novolak resin, a hydrogenated novolak resin, an acetone-pyrogallol resin, a styrene-maleic anhydride copolymer, a carboxyl group-containing methacrylic resin and a derivative thereof may be used, but the alkali-soluble resin which can be used in combination is not limited thereto.

The amount of the resin (BN) added is from 30 to 95 mass%, preferably from 40 to 90 mass%, more preferably from 50 to 80 mass%, based on the entire solid content of the composition.

### (C) Compound that crosslinks by the effect of an acid (sometimes referred to as a "component (C)" or a "crosslinking agent (C)")

The compound that crosslinks by the effect of an acid for use in the negative resist composition of the present invention (hereinafter, appropriately referred to as an "acid crosslinking agent" or simply as a "crosslinking agent") is a compound capable of crosslinking the alkali-soluble resin in the presence of an acid, for example, an acid generated upon irradiation of radiation. Such a crosslinking agent includes, for example, a compound containing one or more substituent (hereinafter, referred to as a "crosslinkable substituent") having a crosslinking reactivity with the alkali-soluble resin.

Specific examples of the crosslinkable substituent include (i) a hydroxyalkyl group and a derivative thereof, such as hydroxyalkyl group, alkoxyalkyl group and acetoxyalkyl group; (ii) a carbonyl group and a derivative thereof, such as formyl group and carboxyalkyl group; (iii) a substituent having a nitrogen-containing group, such as dimethylaminomethyl group, diethylaminomethyl group, dimethylolaminomethyl group, diethylolaminomethyl group and morpholinomethyl group; (iv) a glycidyl group-containing substituent such as glycidyl ether group, glycidyl ester group and glycidyl amino group; (v) an aromatic derivative such as arylcarbonyloxyalkyl group (e.g., benzyloxymethyl, benzoyloxymethyl) and arallcyloxyalkyl group; and (vi) a polymerizable multiple bond-containing substituent such as vinyl group and isopropenyl group. The crosslinkable substituent of the crosslinking agent for use in the present invention is preferably, for example, a hydroxyalkyl group or an alkoxyalkyl group, more preferably an alkoxymethyl group.

Examples of the crosslinking agent having the above-described crosslinkable substituent include (i) a methylol group-containing compound such as methylol group-containing melamine compound, methylol group-containing benzoguanamine compound, methylol group-containing urea compound, methylol group-containing glycoluril compound and methylol group-containing phenol compound; (ii) an alkoxyalkyl group-containing compound such as alkoxyalkyl group-containing melamine compound, alkoxyalkyl group-containing benzoguanamine compound, alkoxyalkyl group-containing urea compound, alkoxyalkyl group-containing glycoluril compound and alkoxyalkyl group-containing phenol compound; (iii) a carboxymethyl group-containing compound such as carboxymethyl group-containing melamine compound, carboxymethyl group-containing benzoguanamine compound, carboxymethyl group-containing urea compound, carboxymethyl group-containing glycoluril compound and carboxymethyl group-containing phenol compound; and (iv) an epoxy compound such as Bisphenol A-based epoxy compound, Bisphenol F-based epoxy compound, Bisphenol S-based epoxy compound, novolak resin-based epoxy compound, resol resin-based epoxy compound and poly(hydroxystyrene)-based epoxy compound.

As for the crosslinking agent, a resin imparted with a property as a crosslinking agent by introducing the above-described crosslinkable substituent into an acidic functional group of an alkali-soluble resin can also be used. In this case, the introduction ratio of the crosslinkable substituent is usually controlled to be from 5 to 60 mol%, preferably from 10 to 50 mol%, more preferably from 15 to 40 mol%, based on all acidic functional groups in the alkali-soluble resin. If the introduction ratio of the crosslinkable substituent is less than 5 mol%, a sufficient crosslinking reaction can be hardly brought about and this readily causes, for example, reduction in the residual film ratio and swelling phenomenon or meandering of the pattern, whereas if it exceeds 60 mol%, the alkali solubility of the alkali-soluble resin tends to decrease, giving rise to worsening of the developability.

The crosslinking agent for use in the resist composition of the present invention is preferably an alkoxymethylated urea compound or a resin thereof, or an alkoxymethylated glycoluril compound or a resin thereof.

Particularly preferred examples of the crosslinking agent (C1) include a compound represented by any one of formulae (4) to (6) and an alkoxymethylated melamine compound.

R_{5b} in formulae (4) to (6) each independently represents a hydrogen atom, an alkyl group (preferably having a carbon number of 1 to 5, more preferably from 1 to 3, such as methyl group, ethyl group or propyl group) or an acyl group (preferably having a carbon number of 2 to 6, more preferably from 2 to 4, such as acetyl group or propionyl group).

R_{6b} to R_{9b} in formula (4) each independently represents a hydrogen atom, a hydroxyl group, an alkyl group (preferably having a carbon number of 1 to 5, more preferably from 1 to 3, such as methyl group, ethyl group or propyl group) or an alkoxyl group (preferably a carbon number of 1 to 5, more preferably from 1 to 3, such as methoxy group, ethoxy group or propoxy group). X represents a single bond, a methylene group or an oxygen atom. X is preferably a single bond or a methylene group.

Incidentally, these groups each may further have a substituent such as alkyl group (e.g., methyl, ethyl), alkoxy group (e.g., methoxy, ethoxy), hydroxyl group or halogen atom.

Specific examples of the compounds represented by formulae (4) to (6) and the alkoxymethylated melamine compound are set forth below, but the present invention is limited thereto.

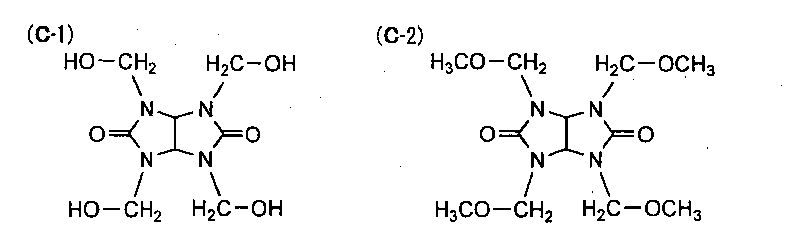

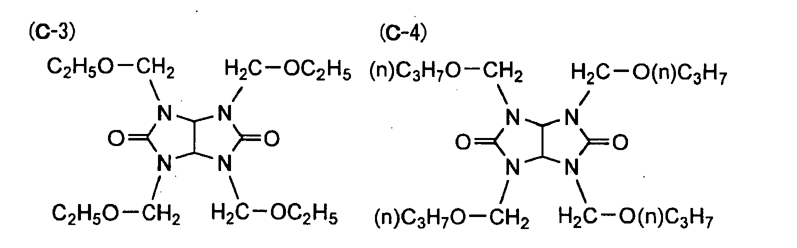

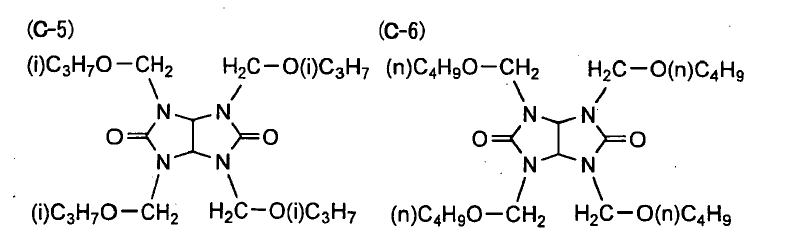

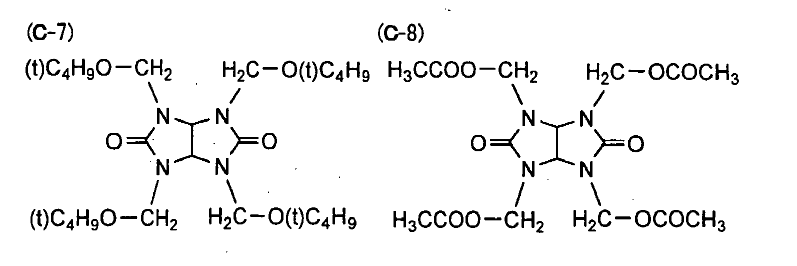

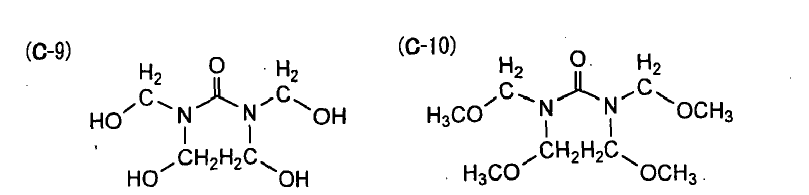

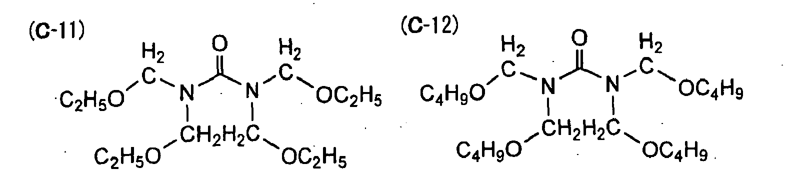

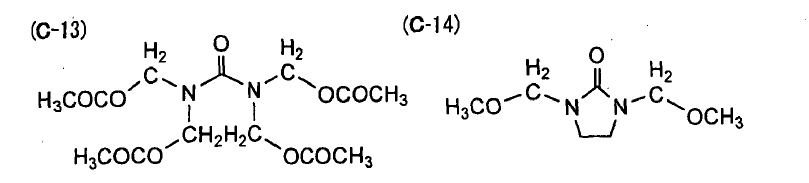

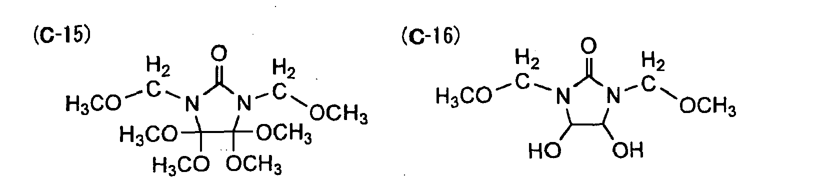

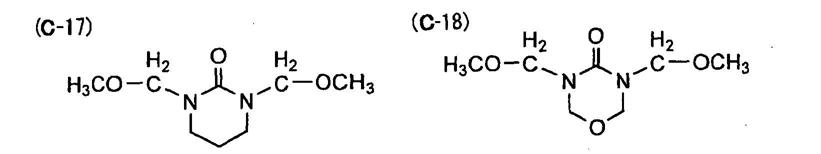

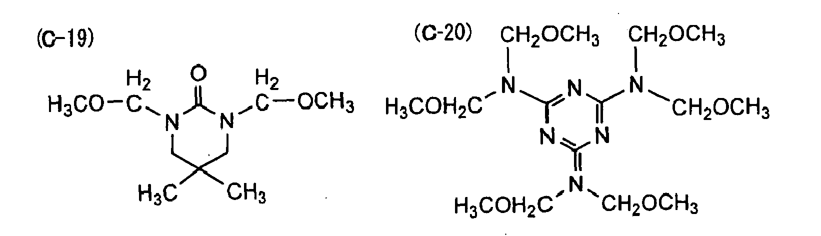

The crosslinking agent can be obtained, for example, by introducing a methylol group through a condensation reaction of a urea compound or glycoluril compound with formalin, etherifying the methylol group with a lower alcohol (e.g., methyl alcohol, ethyl alcohol, propyl alcohol, butyl alcohol), cooling the reaction solution, and recovering the precipitated compound or a resin thereof. The crosslinking agent is also available as a commercial product, for example, CYMEL (produced by Mitsui Cyanamid Co., Ltd.) or Nikarad (produced by Sanwa Chemical Co., Ltd.).

Particularly preferred examples of the crosslinking agent (C2) further include a compound which is a phenol derivative having from 1 to 6 benzene rings within the molecule and in which two or more hydroxymethyl groups and/or alkoxymethyl groups are present in the entire molecule and these groups are connected to at least any one of the benzene rings.

Among these, preferred is a phenol derivative having a molecular weight of 1,500 or less, containing from 1 to 6 benzene rings within the molecule and having two or more hydroxymethyl groups and/or alkoxymethyl groups in total, in which the hydroxymethyl groups and/or alkoxy methyl groups are connected concentrically to any one of those benzene rings or distributedly to the benzene rings.

The alkoxymethyl group connected to the benzene ring is preferably an alkoxymethyl group having a carbon number of 6 or less. Specific preferred examples thereof include a methoxymethyl group, an ethoxymethyl group, an n-propoxymethyl group, an i-propoxymethyl group, an n-butoxymethyl group, an i-butoxymethyl group, a sec-butoxymethyl group and a tert-butoxymethyl group. Furthermore, an alkoxy- substituted alkoxy group such as 2-methoxyethoxy group and 2-methoxy-1-propoxy group is also preferred. Among these phenol derivatives, the followings are particularly preferred. 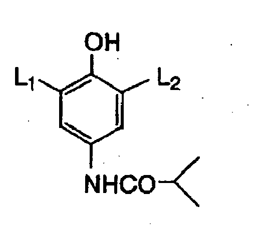 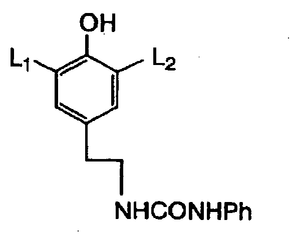 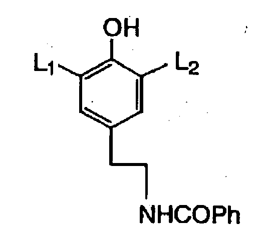 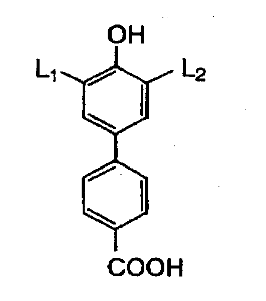 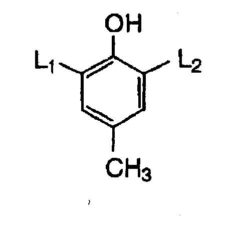 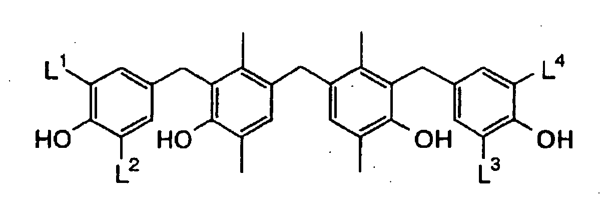 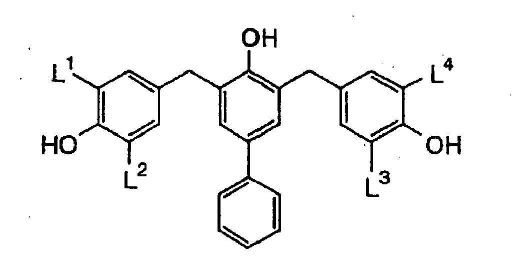 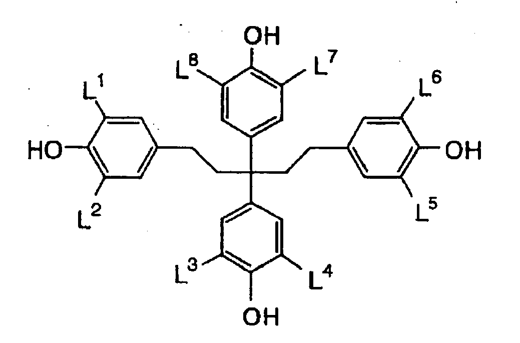 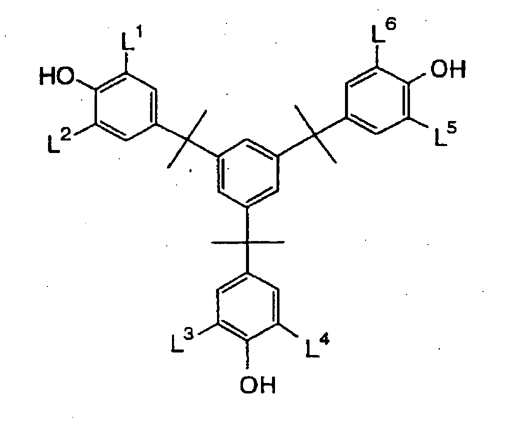 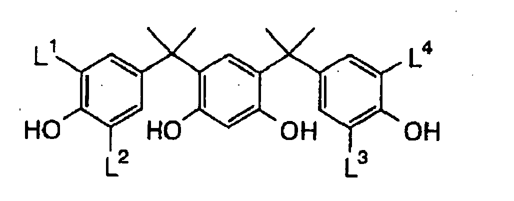 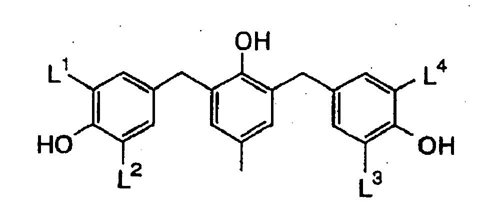 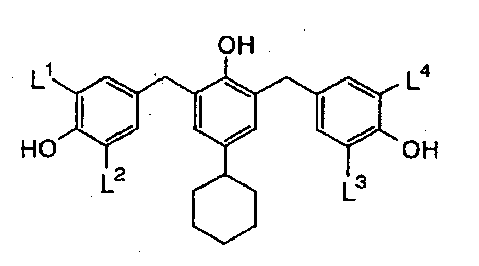 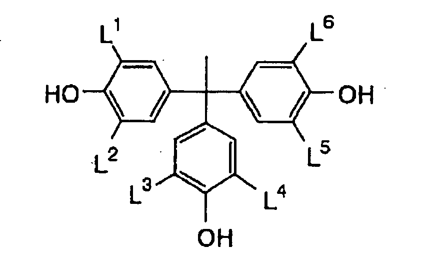 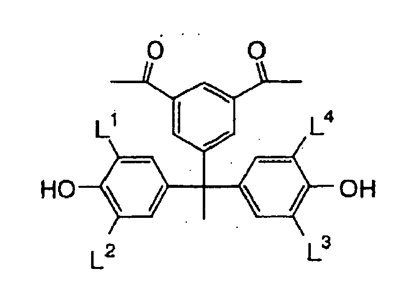 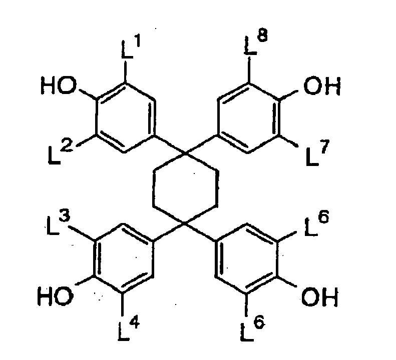 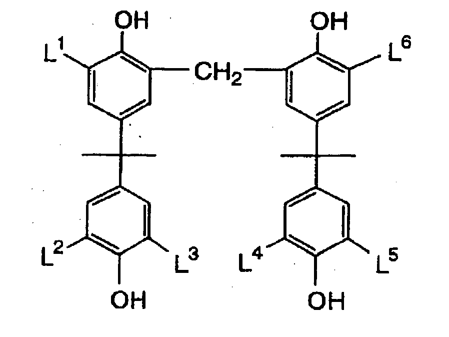 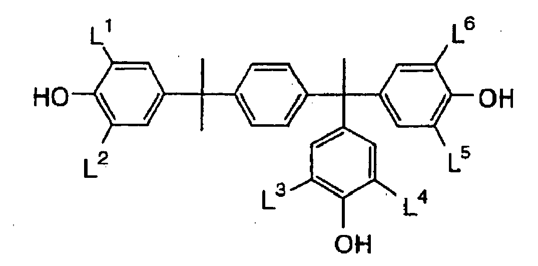 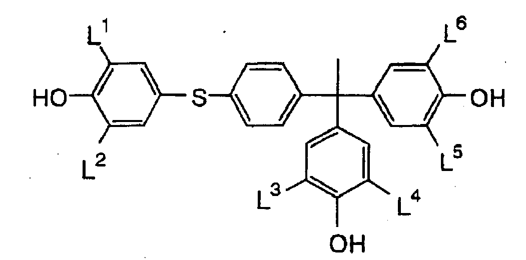 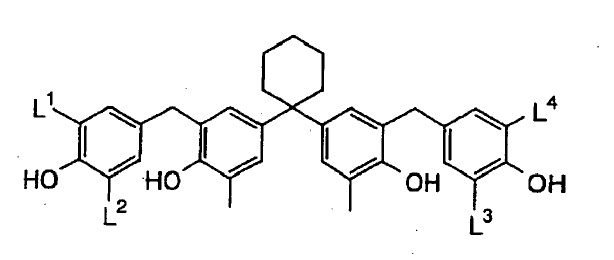 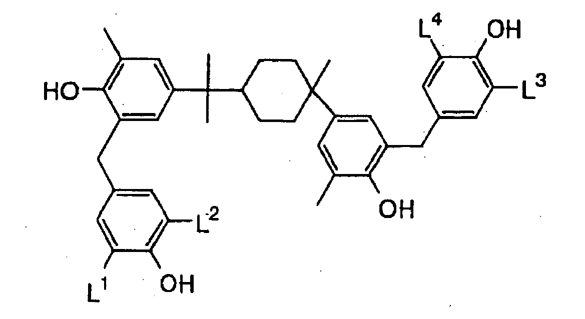 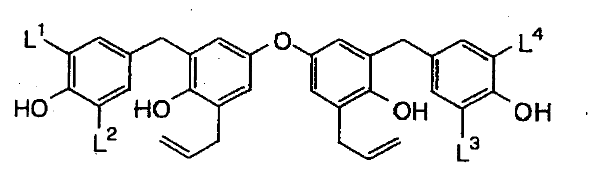 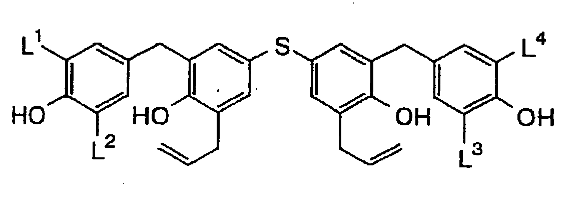 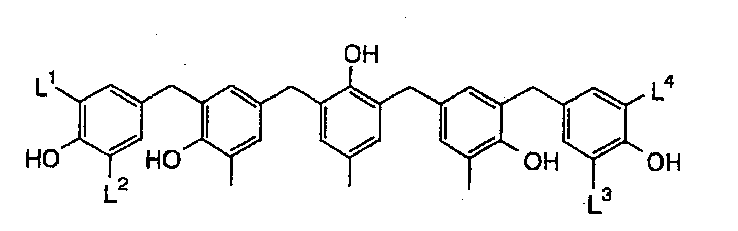 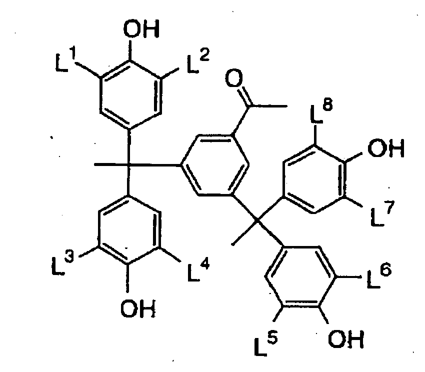 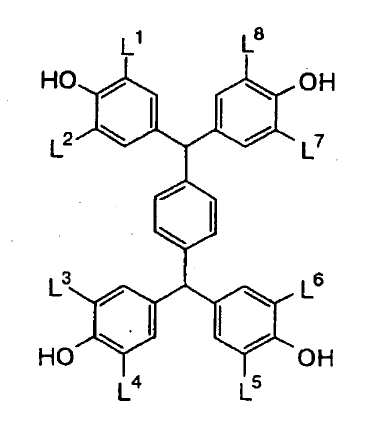 (wherein L¹ to L⁸, which may be the same or different, each represents a hydroxymethyl group, a methoxymethyl group or an ethoxymethyl group).

The phenol derivative having a hydroxymethyl group can be obtained by reacting a corresponding phenol compound not having a hydroxymethyl group (a compound when L¹ to L⁸ in the formulae above are a hydrogen atom) with formaldehyde in the presence of a base catalyst. At this time, the reaction is preferably performed at a temperature of 60°C or less so as to prevent occurrence of resinification or gelation. More specifically, the phenol derivative can be synthesized by the method described, for example, in JP-A-6-282067 and JP-A-7-64285.

The phenol derivative having an alkoxymethyl group can be obtained by reacting a corresponding phenol derivative having a hydroxymethyl group with an alcohol in the presence of an acid catalyst. At this time, the reaction is preferably performed at a temperature of 100°C or less so as to prevent occurrence of resinification or gelation. More specifically, the phenol derivative can be synthesized by the method described, for example, in EP-A-632003.

A phenol derivative having a hydroxymethyl group or an alkoxymethyl group is preferred in view of stability during storage, but a phenol derivative having an alkoxymethyl group is more preferred in view of stability during storage. One of the phenol derivatives having two or more hydroxymethyl groups or alkoxymethyl groups in total, in which these groups are connected concentrically to any one of the benzene rings or distributedly to the benzene rings, may be used alone, or two or more thereof may be used in combination.

In the present invention, in view of residual film ratio and resolving power, the crosslinking agent is used in an amount of 3 to 70 mass%, preferably from 5 to 50 mass%, based on the entire solid content of the resist composition.

Two or more of the compounds having an N-hydroxymethyl group, an N-alkoxymethyl group or an N-acyloxymethyl group, or two or more of the phenol derivatives having a hydroxymethyl group or an alkoxymethyl group may be used in combination. Other Components for Use in Resist Composition of the Present Invention:

The resist composition of the present invention may further contain, for example, an organic basic compound, a dye, a solvent, a fluorine-containing surfactant and/or silicon-containing surfactant, and another surfactant, if desired.
Organic Basic Compound:
The organic basic compound for use in the present invention is preferably an organic basic compound having basicity higher than that of phenol. Among such compounds, a nitrogen-containing basic compound is preferred.
The chemical environment of the nitrogen-containing basic compound is preferably a structure represented by any one of the following formulae (A) to (E):

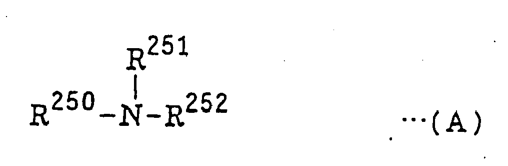

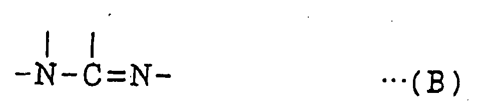

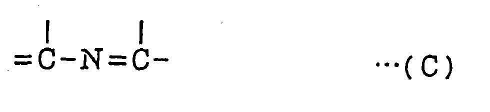

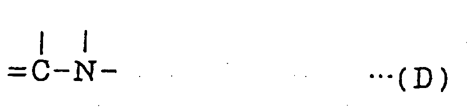

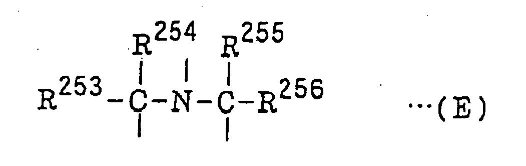

In these formulae, R²⁵⁰, R²⁵¹ and R²⁵², which may be the same or different, each represents a hydrogen atom, an alkyl group having a carbon number of 1 to 20, a cycloalkyl group having a carbon number of 1 to 20, or a substituted or unsubstituted aryl group having a carbon number of 6 to 20, and R²⁵¹ and R²⁵² may combine with each other to form a ring.

The alkyl group may be unsubstituted or may have a substituent, and the alkyl group having a substituent is preferably an aminoalkyl group having a carbon number of 1 to 6 or a hydroxyalkyl group having a carbon number of 1 to 6.

R²⁵³, R²⁵⁴, R²⁵⁵ and R²⁵⁶, which may be the same or different, each represents an alkyl group having a carbon number of 1 to 6.

The compound is more preferably a nitrogen-containing basic compound having two or more nitrogen atoms differing in the chemical environment within one molecule, still more preferably a compound containing both a substituted or unsubstituted amino group and a nitrogen atom-containing ring structure, or a compound having an alkylamino group.

Specific preferred examples thereof include a substituted or unsubstituted guanidine, a substituted or unsubstituted aminopyridine, a substituted or unsubstituted aminoalkylpyridine, a substituted or unsubstituted aminopyrrolidine, a substituted or unsubstituted indazole, an imidazole, a substituted or unsubstituted pyrazole, a substituted or unsubstituted pyrazine, a substituted or unsubstituted pyrimidine, a substituted or unsubstituted purine, a substituted or unsubstituted imidazoline, a substituted or unsubstituted pyrazoline, a substituted or unsubstituted piperazine, a substituted or unsubstituted aminomorpholine and a substituted or unsubstituted aminoalkylmorpholine. Preferred examples of the substituent include an amino group, an alkyl group, an alkoxy group, an acyl group, an acyloxy group, an aryl group, an aryloxy group, a nitro group, a hydroxyl group and a cyano group.

Particularly preferred examples of the compound include, but are not limited to, guanidine, 1,1-dimethylguanidine, 1,1,3,3-tetramethylguanidine, imidazole, 2-methylimidazole, 4-methylimidazole, N-methylimidazole, 2-phenylimidazole, 4,5-diphenylimidazole, 2,4,5-triphenylimidazole, 2-aminopyridine, 3-aminopyridine, 4-aminopyridine, 2-dimethylaminopyridine, 4-dimethylaminopyridine, 2-diethylaminopyridine, 2-(aminomethyl)pyridine, 2-amino-3-methylpyridine, 2-amino-4-methylpyridine, 2-amino-5-methylpyridine, 2-amino-6-methylpyridine, 3-aminoethylpyridine, 4-aminoethylpyridine, 3-aminopyrrolidine, piperazine, N-(2-aminoethyl)piperazine, N-(2-aminoethyl)piperidine, 4-amino-2,2,6,6-tetramethylpiperidine, 4-piperidinopiperidine, 2-iminopiperidine, 1-(2-aminoethyl)pyrrolidine, pyrazole, 3-amino-5-methylpyrazole, 5-amino-3-methyl-1-p-tolylpyrazole, pyrazine, 2-(aminomethyl)-5-methylpyrazine, pyrimidine, 2,4-diaminopyrimidine, 4,6-dihydroxypyrimidine, 2-pyrazoline, 3-pyrazoline, N-aminomorpholine and N-(2-aminoethyl)morpholine.

One of these organic basic compounds is used alone or two or more thereof are used in combination.

The ratio of the acid generator and the organic basic compound used in the positive resist composition is preferably (acid generator)/(organic basic compound) (by mol) = 2.5 to 300. The (acid generator)/(organic basic compound) (by mol) is more preferably from 5.0 to 200, still more preferably from 7.0 to 150.

The amount of the organic basic compound used is usually from 0.001 to 10 mass%, preferably from 0.01 to 5 mass%, based on the entire solid content of the negative resist composition.
Dye:
Suitable dyes include an oily dye and a basic dye. Specific examples thereof include Oil Yellow #101, Oil Yellow #103, Oil Pink #312, Oil Green BG, Oil Blue BOS, Oil Blue #603, Oil Black BY, Oil Black BS, Oil Black T-505 (all produced by Orient Chemical Industries Co., Ltd.), Crystal Violet (CI42555), Methyl Violet (CI42535), Rhodamine B (CI45170B), Malachite Green (CI42000) and Methylene Blue (CI52015).
Solvent:
The resist composition of the present invention is dissolved in a solvent which can dissolve the above-described components, and then coated on a support. Preferred examples of the solvent used here include ethylene dichloride, cyclohexanone, cyclopentanone, 2-heptanone, γ-butyrolactone, methyl ethyl ketone, ethylene glycol monomethyl ether, ethylene glycol monoethyl ether, 2-methoxyethyl acetate, ethylene glycol monoethyl ether acetate, propylene glycol monomethyl ether, propylene glycol monomethyl ether acetate, toluene, ethyl acetate, methyl lactate, ethyl lactate, methyl methoxypropionate, ethyl ethoxypropionate, methyl pyruvate, ethyl pyruvate, propyl pyruvate, N,N-dimethylformamide, dimethylsulfoxide, N-methylpyrrolidone and tetrahydrofuran. One of these solvents is used alone, or two or more thereof are used as a mixture.
In particular, the solvent is preferably propylene glycol monomethyl ether acetate or a mixed solvent of propylene glycol monomethyl ether acetate/propylene glycol monomethyl ether.
Fluorine-Containing and/or Silicon-Containing Surfactant:
The resist composition of the present invention preferably further contains any one fluorine-containing and/or silicon-containing surfactant (a fluorine-containing surfactant, a silicon-containing surfactant or a surfactant containing both a fluorine atom and a silicon atom), or two or more thereof.

When the resist composition of the present invention contains a fluorine-containing and/or silicon-containing surfactant, a resist pattern with good sensitivity and resolution and less failure of adhesion and development can be obtained on use of an exposure light source of 250 nm or less, particularly 220 nm or less.

Examples of the fluorine-containing and/or silicon-containing surfactant include surfactants described in JP-A-62-36663, JP-A-61-226746, JP-A-61-226745, JP-A-62-170950, JP-A-63-34540, JP-A-7-230165, JP-A-8-62834, JP-A-9-54432, JP-A-9-5988, JP-A-2002-277862 and U.S. Patents 5,405,720, 5,360,692, 5,529,881, 5,296,330, 5,436,098, 5,576,143, 5,294,511 and 5,824,451. The following commercially available surfactants each may also be used as it is.

Examples of the commercially available fluorine-containing and/or silicon-containing surfactant which can be used include a fluorine-containing or silicon-containing surfactant such as EFtop EF301 and EF303 (produced by Shin-Akita Kasei K.K.); Florad FC430 and 431 (produced by Sumitomo 3M Inc.); Megafac F171, F173, F176, F189 and R08 (produced by Dainippon Ink & Chemicals, Inc.); Surflon S-382, SC101, 102, 103, 104, 105 and 106 (produced by Asahi Glass Co., Ltd.); and Troysol S-366 (produced by Troy Chemical). In addition, a polysiloxane polymer KP-341 (produced by Shin-Etsu Chemical Co., Ltd.) may also be used as the silicon-containing surfactant.

Other than these known fluorine-containing and/or silicon-containing surfactants, a surfactant using a polymer having a fluoro-aliphatic group, which is derived from a fluoro-aliphatic compound produced by telomerization process (also called telomer process) or oligomerization process (also called oligomer process), may be used. The fluoro-aliphatic compound can be synthesized by the method described in JP-A-2002-90991.

The polymer having a fluoro-aliphatic group is preferably a copolymer of a fluoro-aliphatic group-containing monomer with (poly(oxyalkylene)) acrylate and/or (poly(oxyalkylene)) methacrylate, and the polymer may have an irregular distribution or may be a block copolymer. Examples of the poly(oxyalkylene) group include a poly(oxyethylene) group, a poly(oxypropylene) group and a poly(oxybutylene) group. This group may also be a unit having alkylenes differing in the chain length within the same chain, such as block-linked poly(oxyethylene, oxypropylene and oxyethylene) group and block-linked poly(oxyethylene and oxypropylene) group. Furthermore, the copolymer of a fluoro-aliphatic group-containing monomer with (poly(oxyalkylene)) acrylate (or methacrylate) may be not only a binary copolymer but also a ternary or higher copolymer obtained by simultaneously copolymerizing two or more different fluoro-aliphatic group-containing monomers or two or more different (poly(oxyalkylene)) acrylates (or methacrylates).

Examples thereof include a commercially available fluorine-containing and/or silicon-containing surfactant such as Megafac F-178, F-470, F-473, F-475, F-476 and F-472 (produced by Dainippon Ink & Chemicals, Inc.); a copolymer of an acrylate (or methacrylate) having C₆F₁₃ group and a (poly(oxyalkylene)) acrylate (or methacrylate); a copolymer of an acrylate (or methacrylate) having C₆F₁₃ group, a (poly(oxyethylene)) acrylate (or methacrylate) and a (poly-(oxypropylene)) acrylate (or methacrylate); a copolymer of an acrylate (or methacrylate) having C₈F₁₇ group and a (poly(oxyalkylene)) acrylate (or methacrylate); and a copolymer of an acrylate (or methacrylate) having C₈F₁₇ group, a (poly(oxyethylene)) acrylate (or methacrylate) and a (poly(oxypropylene)) acrylate (or methacrylate).

The amount of the fluorine-containing and/or silicon-containing surfactant used is preferably from 0.0001 to 2 mass%, more preferably from 0.001 to 1 mass%, based on the entire amount of the resist composition (excluding the solvent).
Another Surfactant:
Specific examples of another surfactant which can be used include a nonionic surfactant such as polyoxyethylene alkyl ethers (e.g., polyoxyethylene lauryl ether, polyoxyethylene stearyl ether, polyoxyethylene cetyl ether, polyoxyethylene oleyl ether), polyoxyethylene alkylaryl ethers (e.g., polyoxyethylene octylphenol ether, polyoxyethylene nonylphenol ether), polyoxyethylene polyoxypropylene block copolymers, sorbitan fatty acid esters (e.g., sorbitan monolaurate, sorbitan monopalmitate, sorbitan monostearate, sorbitan monooleate, sorbitan trioleate, sorbitan tristearate) and polyoxyethylene sorbitan fatty acid esters (e.g., polyoxyethylene sorbitan monolaurate, polyoxyethylene sorbitan monopalmitate, polyoxyethylene sorbitan monostearate, polyoxyethylene sorbitan trioleate, polyoxyethylene sorbitan tristearate).

The blending amount of this another surfactant is usually 2 parts by mass or less, preferably 1 part by mass or less, per 100 parts by mass of the solid content in the composition of the present invention.

In the production of a precision integrated circuit device, the step of forming a pattern on a resist film is performed by coating the resist composition of the present invention on a substrate (for example, transparent substrate such as silicon/silicon dioxide-coated substrate, glass substrate or ITO substrate) by an appropriate coating method such as spinner or coater, exposing the resist film through a predetermined mask, and then subjecting the resist film to heating, development, rinsing and drying, whereby a good resist pattern can be formed.

The resist composition of the present invention is not limited in the type of the exposure light source, but an electron beam, EUV (extreme ultraviolet) light and an X ray may also be suitably used.

In the present invention, a known inorganic or organic antireflection film may be used, if desired. Furthermore, an antireflection film may be used by coating it to underlie the resist layer.

The antireflection film used as the lower layer of the resist may be either an inorganic film such as titanium, titanium dioxide, titanium nitride, chromium oxide, carbon and amorphous silicon, or an organic film comprising a light absorbent and a polymer material. The former requires equipment for the film formation, such as vacuum vapor-deposition apparatus, CVD apparatus and sputtering apparatus. Examples of the organic antireflection film include a film comprising a diphenylamine derivative and formaldehyde-modified melamine resin condensate, an alkali-soluble resin and a light absorbent described in JP-B-7-69611, a reaction product of a maleic anhydride copolymer and a diamine-type light absorbent described in U.S. Patent 5,294,680, a film comprising a resin binder and a methylolmelamine-based heat crosslinking agent described in JP-A-6-118631, an acrylic resin-type antireflection film containing a carboxylic acid group, an epoxy group and a light absorbing group within the same molecule described in JP-A-6-118656, a film comprising methylolmelamine and a benzophenone-based light absorbent described in JP-A-8-87115, and a film obtained by adding a low molecular light absorbent to a polyvinyl alcohol resin described in JP-A-8-179509.

Also, the organic antireflection film may be a commercially available organic antireflection film such as DUV-30 Series and DUV-40 Series (produced by Brewer Science, Inc.); and AR-2, AR-3 and AR-5 (produced by Shipley Co., Ltd.).

The developer which can be used for the resist composition of the present invention is an aqueous solution of alkalis such as inorganic alkalis (e.g., sodium hydroxide, potassium hydroxide, sodium carbonate, sodium silicate, sodium metasilicate, aqueous ammonia), primary amines (e.g., ethylamine, n-propylamine), secondary amines (e.g., diethylamine, di-n-butylamine), tertiary amines (e.g., triethylamine, methyldiethylamine), alcohol amines (e.g., dimetylethanolamine, triethanolamine), quaternary ammonium salt (e.g., tetramethylammonium hydroxide, tetraethylammonium hydroxide, choline), and cyclic amines (e.g., pyrrole, piperidine). Furthermore, this aqueous solution of an alkali may be used after adding thereto an alcohol (e.g., isopropyl alcohol) and a surfactant (e.g., nonionic surfactant) each in an appropriate amount.

Among these alkali developers, preferred is an aqueous solution of a quaternary ammonium salt, and more preferred is an aqueous solution of tetramethylammonium hydroxide or choline.

### [Examples]

The present invention is described in greater detail below by referring to Examples, but the present invention is not limited thereto.

### (1) Synthesis of Compound (A1)

In a nitrogen atmosphere, 23.5 g (0.1mol) of p-dibromobenzene was added to 150 ml of dehydrated tetrahydrofuran (THF). After cooling the flask, 5.0 g of magnesium was added little by little with stirring and subsequently, 0.1 g of iodine was added. The obtained magnesium bromide form was reacted with 40 g of benzothiophene oxide, and the resulting reaction solution was added to an aqueous ammonium chloride solution and after extraction with ethyl acetate, mixed with an aqueous potassium tripropylbenzenesulfonate to effect a salt exchange reaction, whereby the objective material (BP-4) was obtained.

### (2) Synthesis of Acid-Decomposable Resin (BP)

### (2-1) Synthesis of Resin (B-21)

p-Acetoxystyrene (32.4 g) (0.2 mol) and 7.01 g (0.07 mol) of tert-butyl methacrylate were dissolved in 120 ml of butyl acetate and in a nitrogen stream, 0.033 g of azobisisobutyronitrile (AIBN) was added thereto with stirring at 80°C three times every 2.5 hours. The stirring was further continued for 5 hours, whereby the polymerization reaction was performed. The resulting reaction solution was poured in 1,200 ml of hexane to precipitate a white resin. The obtained resin was dried and then dissolved in 200 ml of methanol.

An aqueous solution containing 7.7 g (0.19 mol) of sodium hydroxide/50 ml of water was added to the solution obtained above, and the resulting solution was refluxed under heat for 1 hour, thereby effecting hydrolysis. The resulting hydrolysate was diluted by adding 200 ml of water and then neutralized with hydrochloric acid to precipitate a white resin. This resin was separated by filtration, washed with water, dried and then dissolved in 200 ml of tetrahydrofuran, and the resulting solution was added dropwise in 5 L of ultrapure water with vigorous stirring, thereby effecting reprecipitation. This reprecipitation operation was repeated 3 times. The obtained resin was dried in a vacuum drier at 120°C for 12 hours to obtain a poly(p-hydroxystyrene/tert-butyl methacrylate) copolymer.

### (2-2) Synthesis of Resin (B-3)

Poly(p-hydroxystyrene) (10 g) (VP-8000, produced by Nippon Soda Co., Ltd.) was dissolved in 50 ml of pyridine, and 3.63 g of di-tert-butyl dicarbonate was added dropwise thereto with stirring at room temperature.

After stirring for 3 hours at room temperature, the reaction solution was added dropwise to a solution containing 1 L of ion exchanged water/20 g of concentrated hydrochloric acid. The powder precipitated was filtered, washed with water and dried to obtain Resin (B-3).

### (2-3) Synthesis of Resin (B-32)

p-Cyclohexylphenol (83.1 g) (0.5 mol) was dissolved in 300 ml of toluene, and 150 g of 2-chloroethyl vinyl ether, 25 g of sodium hydroxide, 5 g of tetrabutylammonium bromide and 60 g of triethylamine were added thereto and allowed to react at 120°C for 5 hours. The resulting reaction solution was washed with water and the excess chloroethyl vinyl ether and toluene were distilled out. The obtained oil was purified by distillation under reduced pressure to obtain 4-cyclohexylphenoxyethyl vinyl ether.

Poly(p-hydroxystyrene) (20 g) (VP-8000, produced by Nippon Soda Co., Ltd.) and 6.5 g of 4-cyclohexylphenoxyethyl vinyl ether were dissolved in 80 ml of THF, and 0.01 g of p-toluenesulfonic acid was added thereto and allowed to react at room temperature for 18 hours. The resulting reaction solution was added dropwise in 5 L of distilled water with vigorous stirring, and the powder precipitated was filtered and dried to obtain Resin (B-32).

Other resins were synthesized in the same manner. The weight average molecular weight and molar ratio of repeating units of each resin used in the following Examples are shown below.

| Resin | Weight Average Molecular Weight | Molar Ratio* of Repeating Units |
|---|---|---|
| (B-3) | 8500 | 25/75 |
| (B-4) | 8500 | 25/75 |
| (B-21) | 12000 | 65/35 |
| (B-26) | 11500 | 15/60/25 |
| (B-28) | 15000 | 78/22 |
| (B-30) | 8000 | 80/20 |
| (B-31) | 15000 | 65/10/25 |
| (B-32) | 12000 | 82/18 |

| | | |
|---|---|---|
| * In the order of parenthesized repeating units from left to right in the resin structure shown above. | | |

### (3) Synthesis of Alkali-Soluble Resin of (BN)

### (3-1) Synthesis of Resin a-(29)

4-Acetoxystyrene (3.9 g (0.024 mol)) and 0.8 g (0.006 mol) of 4-methoxystyrene were dissolved in 30 ml of 1-methoxy-2-propanol and in a nitrogen stream, a 1-methoxy-2-propanol (70 ml) solution containing 50 mg of 2,2'-azobis(2,4-dimethylvaleronitrile) (V-65, trade name, produced by Wako Pure Chemical Industries, Ltd.) as the polymerization initiator, 9.1 g (0.056 mol) of 4-acetoxystyrene and 1.9 g (0.014 mol) of 4-methoxystyrene was added dropwise thereto with stirring at 70°C over 2 hours. After 2 hours, 50 mg of the initiator was additionally added and the reaction was allowed to proceed for another 2 hours. Thereafter, the temperature was raised to 90°C and stirring was continued for 1 hour. The resulting reaction solution was allowed to cool and then poured into 1 L of ion-exchanged water with vigorous stirring, thereby precipitating a white resin. The obtained resin was dried and then dissolved in 100 ml of methanol and after hydrolyzing the acetoxy group in the resin by adding an aqueous 25% tetramethylammonium hydroxide solution, the resulting solution was neutralized with an aqueous hydrochloric acid solution to precipitate a white resin. The obtained resin was washed with ion-exchanged water and dried under reduced pressure to obtain 11.6 g of Resin a-(29) of the present invention.

The molecular weight of the resin was measured by GPC and found to be 9,200 in terms of the weight average molecular weight (Mw, polystyrene-reduced), and the dispersity (Mw/Mn) was 2.2. Also, the compositional ratio was calculated by the NMR measurement and found to be x/y=80/20 by mol.

### (3-2) Synthesis of Resin a-(39)

Poly(4-hydroxystyrene) (12.0 g) (Mw: 10,500, Mw/Mn: 1.2) was dissolved in 100 ml of acetone, and 2.0 g of pyridine and then 1.3 g of acetic anhydride were added thereto. The reaction was allowed to proceed for 3 hours with stirring at 50°C, and the resulting reaction solution was poured into 1 L of ion-exchanged water with vigorous stirring, thereby precipitating a white resin. The obtained resin was dried under reduced pressure to obtain 12.2 g of Resin a-(39) of the present invention.

The molecular weight of the resin was measured by GPC and found to be 11,400 in terms of the weight average molecular weight (Mw, polystyrene-reduced), and the dispersity (Mw/Mn) was 1.2. Also, the compositional ratio was calculated by the NMR measurement and found to be x/y (4-hydroxystyrene/4-acetoxystyrene)=88/12 by mol.

### (3-3) Synthesis of Resin a-(91)

2-[(4'-Hydoxyphenyl)carbonyloxy]ethyl methacrylate (3.8 g (0.015 mol)), 1.0 g (0.009 mol) of 2-hydroxyethyl acrylate and 0.3 g (0.006 mol) of acrylonitrile were dissolved in 30 ml of 1-methoxy-2-propanol and in a nitrogen stream, a 1-methoxy-2-propanol (70 ml) solution containing 50 mg of 2,2'-azobis(2,4-dimethylvaleronitrile) (V-65, trade name, produced by Wako Pure Chemical Industries, Ltd.) as the polymerization initiator, 8.8 g (0.035 mol) of 2-[(4'-hydoxyphenyl)carbonyloxy]ethyl methacrylate, 2.4 g (0.021 mol) of 2-hydroxyethyl acrylate and 0.7 g (0.014 mol) of acrylonitrile was added dropwise thereto with stirring at 70°C over 2 hours. After 2 hours, 50 mg of the initiator was additionally added and the reaction was allowed to proceed for another 2 hours. Thereafter, the temperature was raised to 90°C and the stirring was continued for 1 hour. The resulting reaction solution was allowed to cool and poured into 1 L of ion-exchanged water with vigorous stirring, thereby precipitating a white resin. The obtained resin was dried under reduced pressure to obtain 15.8 g of Resin a-(91) of the present invention.

The molecular weight of the resin was measured by GPC and found to be 11,000 in terms of the weight average molecular weight (Mw, polystyrene-reduced), and the dispersity (Mw/Mn) was 1.5. Also, the compositional ratio was calculated by the NMR measurement and found to be x/y/z=60/30/10 by mol.

The resins of (BN) of the present invention were synthesized in the same manner.

### (4) Synthesis of Crosslinking Agent

### (4-1) Synthesis of Crosslinking Agent [HM-0]

p-Aminophenol (1 mol), sodium acetate (1 mol) and acetone (1 liter) were charged into a flask, and isobutyric chloride (1 mol) was added dropwise thereto under ice-cooling. After 5 hours, the reaction mixture was poured into ice water to precipitate crystals, and the crystals were collected by filtration to obtain HM-0-X at a yield of 80%.

The obtained HM-0-X (0.8 mol), KOH (0.8 mol), 500 ml of water and an aqueous 37% formalin solution (4.8 mol) were charged into a flask and after heating at 50°C for 5 hours, the reaction solution was neutralized with acetic acid and then subjected to concentration of the solvent under reduced pressure. The resulting oily product was dissolved in ethyl acetate/methanol (=1/1) and separated by SiO₂ column chromatography, as a result, the objective [HM-0] (L₁=L₂=CH₂OH) was obtained as a colorless crystal at a total yield of 50%.

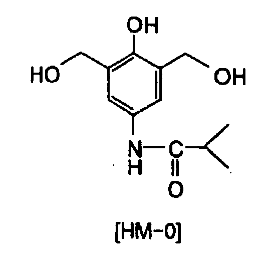

### (4-2) Synthesis of Crosslinking Agent [HM-1]

1 -[α-Methyl-α-(4-hydroxyphenyl)ethyl]-4-[α,α-bis(4-hydroxyphenyl)ethyl]benzene (20 g) (Trisp-PA, produced by Honshu Chemical Industry Co., Ltd.) was added to an aqueous 10% potassium hydroxide solution and dissolved with stirring. Subsequently, while stirring the resulting solution, 60 ml of an aqueous 37% formalin solution was gradually added thereto at room temperature over 1 hour. After further stirring at room temperature for 6 hours, the reaction solution was poured into an aqueous dilute sulfuric acid solution. The precipitate was collected by filtration, thoroughly washed with water and then recrystallized from 30 ml of methanol, whereby 20 g of a phenol derivative [HM-1] containing a hydroxymethyl group having a structure shown below was obtained as white powder. The purity was 92% (as determined by liquid chromatography).

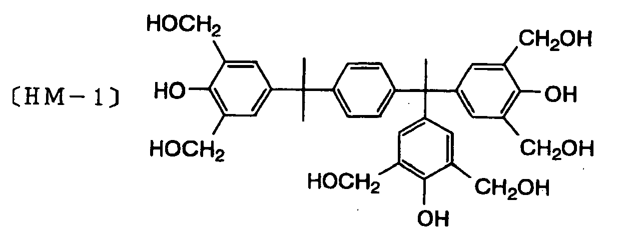

### (4-3) Synthesis of Crosslinking Agent [MM-1]

The phenol derivative [HM-1] having a hydroxymethyl group obtained above (20 g) was added to 1 liter of methanol and dissolved under heating with stirring. Subsequently, 1 ml of concentrated sulfuric acid was added to this solution, and the mixture was refluxed under heating for 12 hours. After the completion of reaction, the reaction solution was cooled and 2 g of potassium carbonate was added thereto. The resulting mixture was thoroughly concentrated, and 300 ml of ethyl acetate was added thereto. This solution was washed with water and concentrated and exsiccated, as a result, 22 g of a phenol derivative [MM-1] containing a methoxymethyl group having a structure shown below was obtained as a white solid. The purity was 90% (as determined by liquid chromatography).

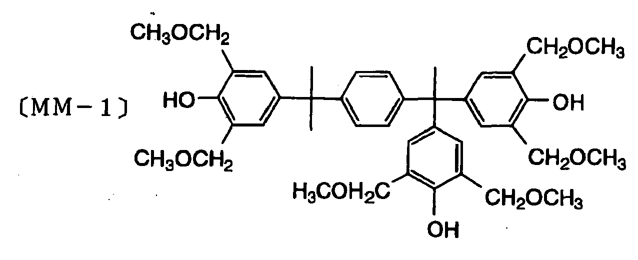

Examples 1 to 18 and Comparative Examples 1 to 5:
(1) Application of Resist Composition
The components shown in Table 3 each in the following amount were dissolved in 26.0 g (in total) of a solvent to prepare a resist composition solution. In Table 3, when a plurality of compounds are used for each component, the ratio is a ratio by mass.

| | |
|---|---|
| Acid-decomposable resin (BP) | 2,0 g |
| Acid generator | 0.20 g |
| Basic compound, if desired | 0.0040 g |
| Surfactant, if desired | 0.0020 g |

Each solution obtained was subjected to microfiltration through a membrane filter having a pore diameter of 0.1 µm to prepare a resist solution.
The obtained resist solution was coated on a 6-inch silicon wafer by using a spin coater, Mark 8, manufactured by Tokyo Electron Ltd. and baked at 110°C for 90 seconds to form a uniform film having a thickness of 0.30 µm.
(2) Formation and Evaluation of Resist Pattern

The thus-formed resist film was irradiated with an electron beam by using an electron beam image-drawing apparatus (HL750, manufactured by Hitachi, Ltd., acceleration voltage: 50 KeV). After the irradiation, the resist film was baked at 110°C for 90 seconds, dipped in an aqueous 2.38 mass% tetramethylammonium hydroxide (TMAH) solution for 60 seconds, rinsed with water for 30 seconds and dried. The obtained pattern was evaluated by the following methods.

### (2-1) Sensitivity

The minimum irradiation energy on resolving a 0.15 µm-line (line :space= 1:1) was defined as the sensitivity.

### (2-2) Resolving Power

The limiting resolving power (the line and space being separately resolved) at the irradiation amount where the above-described sensitivity was exhibited was defined as the resolving power.

### (2-3) Surface Roughness

A wafer sample irradiated with EUV light in an exposure amount corresponding to the sensitivity determined in the test above was developed for a development time in steps of 5 seconds from 1 to 60 seconds (with an aqueous 2.38 mass% tetramethylammonium hydroxide (TMAH) solution), and the surface roughness (Ra) was determined by observing each surface through AFM (atomic force microscope). The maximum value (nm) obtained was used as an index of the surface roughness.

### (2-4) Evaluation of Outgas

Each positive resist composition was coated to a thickness of 1,000 Å by a spin coater on a silicon wafer which was treated with hexamethyldisilazane (HMDS) at 23°C for 20 seconds, and then dried under heating at 120°C for 60 seconds on a vacuum contact-type hot plate. Thereafter, the wafer was exposed in open frame by using an EUV exposing machine (EUVES, manufactured by Litho Tech Japan Co., Ltd.) while stepwise changing the exposure amount and then, (film loss (%))=((initial film thickness) - (film thickness after exposure))/(initial film thickness) was calculated by measuring the film thickness and recorded. Subsequently, the wafer was heated at 110°C for 90 seconds, paddle-developed with an aqueous 0.262N TMAH solution, wished with pure water for 30 seconds and then spin-dried. At this time, the exposure amount necessary for resolving the resist film to the bottom is defined as Eth, and the (film loss) at an exposure amount three times Eth was used as an index of the outgas volume. A smaller value is better.

The evaluation results are shown in Table 1.

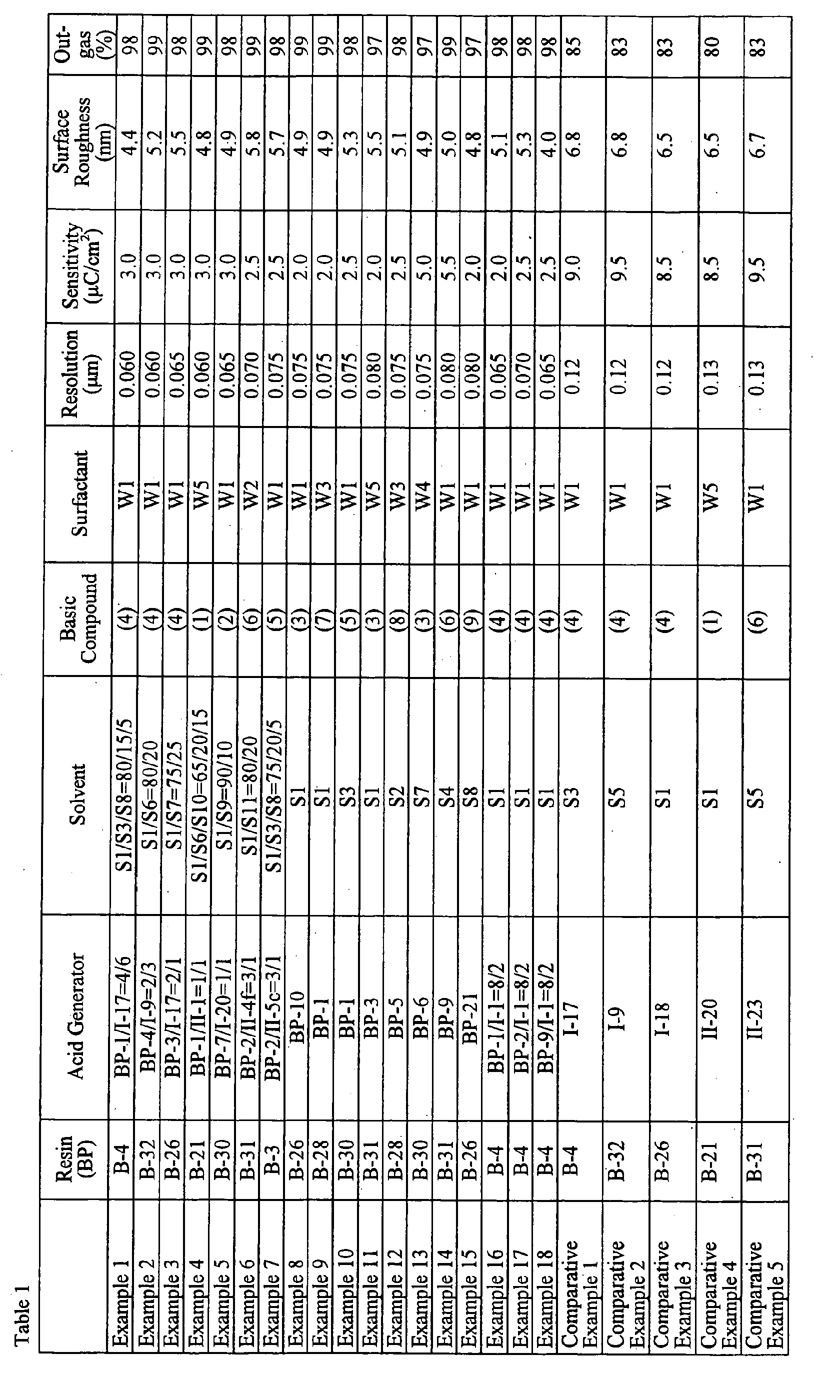

The abbreviations used in Table 1 indicate the followings.

The basic compounds are as follows.
(1): 1,8-Diazabicyclo[4.3.0]non-5-ene
(2): 2,6-Diisopropylaniline
(3): 4-Dimethylaminopyridine
(4): 2,4,5-Triphenylimidazole
(5): Piperazine
(6): 1,5-Diazabicyclo[4.3.0]non-5-ene
(7): 1,5-Diazabicyclo[2.2.2]octane
(8): Hexamethylenetetramine
(9): Phenylguanidine
   The surfactants are as follows.
W1: Megafac F 176 (produced by Dainippon Ink & Chemicals, Inc.) (fluorine-containing)
W2: Megafac R08 (produced by Dainippon Ink & Chemicals, Inc.) (fluorine- and silicon-containing)
W3: Polysiloxane polymer KP-341 (produced by Shin-Etsu Chemical Co., Ltd.)
W4: Polyoxyethylene phenyl ether
W5: Troysol S-366 (produced by Troy Chemical Industries, Inc.)
   The solvents are as follows.
S 1: Propylene glycol monomethyl ether acetate
S2: Propylene glycol monomethyl ether propionate
S3: Ethyl lactate
S4: Butyl acetate
S5: 2-Heptanone
S6: Propylene glycol monomethyl ether
S7: Ethoxyethyl propionate
S8: γ-Butyrolactone
S9: Ethylene carbonate
S10: Propylene carbonate
S11: Cyclohexanone

As apparent from Table 1, the positive resist composition of the present invention is excellent in the sensitivity and resolving power and reduced in the surface roughness and outgas. Examples 19 to 35 and Comparative Examples 6 to 10:

### (1) Application of Resist Composition

The components shown in Table 4 each in the following amount were dissolved in 18.0 g (in total) of a solvent to prepare a negative resist composition.

| | |
|---|---|
| Alkali-soluble resin (BN) | 2.0 g |
| Total amount of acid generator | 0.20 g |
| Total amount of crosslinking agent (C) | 0.35 g |
| Organic basic compound, if desired | 0.0080 g . |
| Surfactant, if desired | 0.0040 g |

Each sample solution was filtered through a 0.1-µm Teflon filter and coated on a silicon wafer treated with hexamethyldisilazane, by a spin coater, Mark 8, manufactured by Tokyo Electron Ltd. Subsequently, the coating was dried under heating on a vacuum contact-type hot plate at 110°C for 90 seconds to form a resist film having a thickness of 0.3 µm.

### (2) Formation of Resist Pattern

The thus-formed resist film was irradiated by using an electron beam image-drawing apparatus (HL750, manufactured by Hitachi, Ltd., acceleration voltage: 50 KeV). After the irradiation, each resist film was heated on a vacuum contact-type hot plate at 110°C for 60 seconds, dipped in an aqueous 2.38 mass% tetramethylammonium hydroxide (TMAH) solution for 60 seconds, rinsed with water for 30 seconds and dried. The cross-sectional shape of the obtained 0.15 µm (line: space) pattern was observed through a scanning electron microscope.

Also, the minimum irradiation energy on resolving a 0.20-µm line (line :space= 1:1) was defined as the sensitivity, and the limiting resolving power (the line and space being separately resolved) at this irradiation amount was defined as the resolving power. In the case where a 0.20-µm line (line: space= 1: 1) was not resolved, the resolving power as the limit was used for the resolving power.

The results of performance evaluation are shown in Table 2.

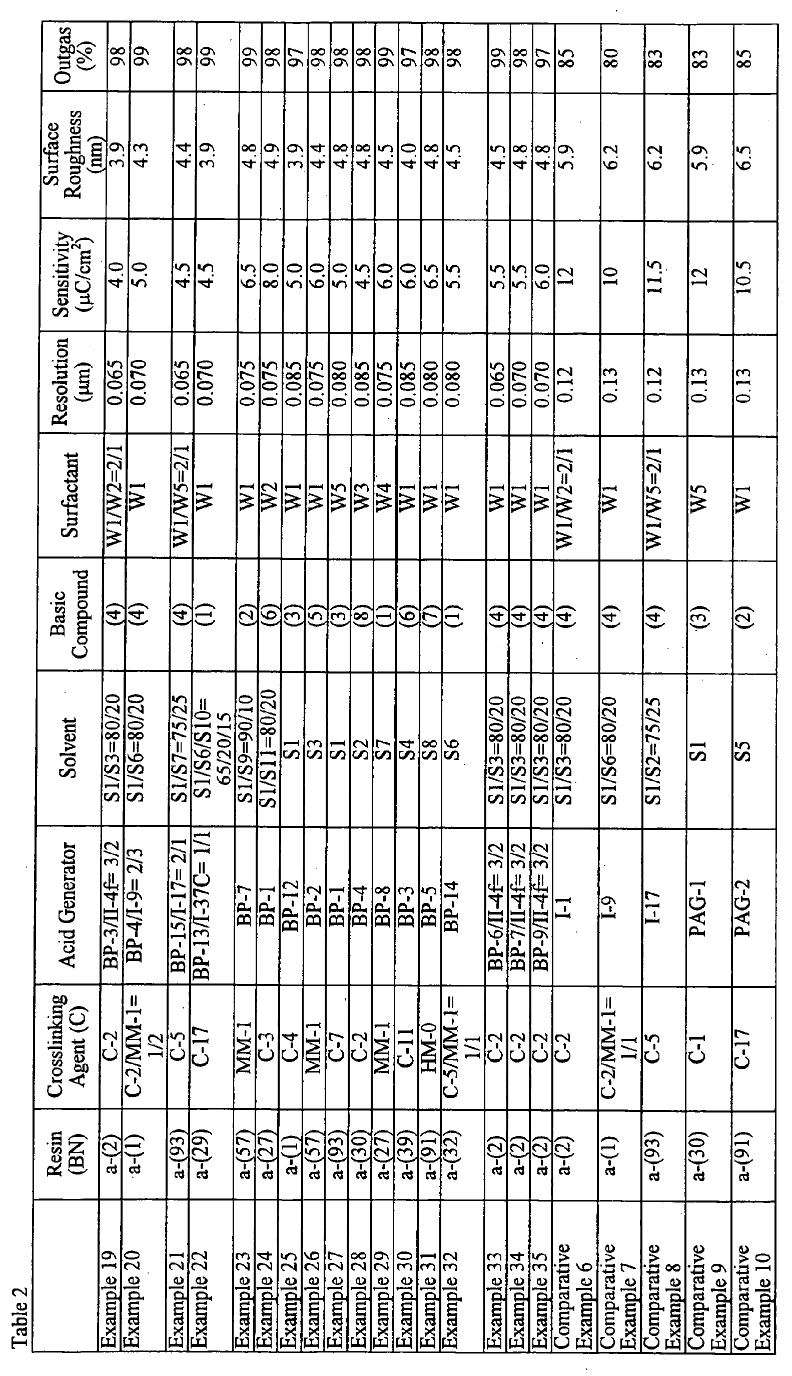

In Table 2, the composition (molar ratio) and molecular weight of each of Resins a-(1), a-(2), a-(3), a-(25), a-(27), a-(29), a-(30), a-(31), a-(32), a-(35), a-(39), a-(57), a-(91) and a-(93) are as follows.
a-(1) Mw=15,000, Mw/Mn=1.1
a-(2) Mw=9,000, Mw/Mn=1.2
a-(3) Mw=8,000, Mw/Mn=1.3
a-(25) x/y=70:30, Mw=16,000, Mw/Mn=1.5
a-(27) x/y=80:20, Mw=9,500, Mw/Mn=1.5
a-(29) x/y=80:20, Mw=9,200, Mw/Mn=2.2
a-(30) x/y=80:20, Mw=12,000, Mw/Mn=1.2
a-(31) x/y=90:10, Mw=8,500, Mw/Mn=1.3
a-(32) x/y=75:25, Mw=9,000, Mw/Mn=1.2
a-(35) x/y=75:25, Mw=20,000,Mw/Mn=2.1
a-(39) x/y=88:12, Mw=11,400, Mw/Mn=1.2
a-(57) x/y=95:5, Mw=5,000, Mw/Mn=1.2
a-(91) x/y/z=60:30:10, Mw=11,000, Mw/Mn=1.5
a-(93) x/y=85:15, Mw=9,300, Mw/Mn=1.1

The acid generators used in Table 2 are shown below.

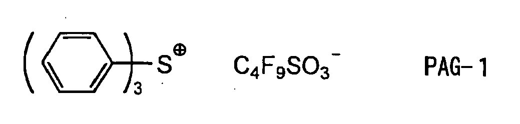

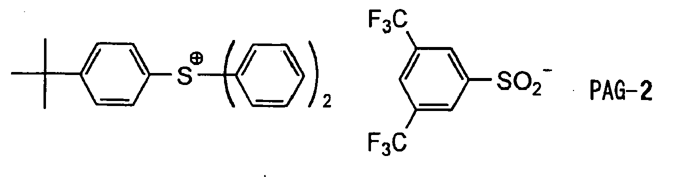

The organic basic compounds are as follows.
(1): 1,8-Diazabicyclo[4.3.0]non-5-ene
(2): 2,6-Diisopropylaniline
(3): 4-Dimethylaminopyridine
(4): 2,4,5-Triphenylimidazole
(5): Piperazine
(6): 1,5-Diazabicyclo[4.3.0]non-5-ene
(7): Phenylguanidine
(8): Hexamethylenetetramine
   The surfactants are as follows.
W1: Megafac F176 (produced by Dainippon Ink & Chemicals, Inc.) (fluorine-containing)
W2: Megafac R08 (produced by Dainippon Ink & Chemicals, Inc.) (fluorine- and silicon-containing)
W3: Polysiloxane polymer KP-341 (produced by Shin-Etsu Chemical Co., Ltd.)
W4: Polyoxyethylene triphenyl ether
W5: Troysol S-366 (produced by Troy Chemical Industries, Inc.)
   The solvents are as follows.
S 1: Propylene glycol monomethyl ether acetate
S2: Propylene glycol monomethyl ether propionate
S3: Ethyl lactate
S4: Butyl acetate
S5: 2-Heptanone
S6: Propylene glycol monomethyl ether
S7: Ethoxyethyl propionate
S8: γ-Butyrolactone
S9: Ethylene carbonate
S10: Propylene carbonate
S 11: Cyclohexanone

The results in Table 2 reveal that the composition of the present invention has excellent performance with high sensitivity, high resolving power and reduced outgas or surface roughness.

Also, the same effects were obtained in experiments using an X-ray image-drawing apparatus.
Examples 36 and 37 and Comparative Example 11:
Using each resist solution of Examples 1 and 2 and Comparative Example 1, a resist film was prepared in the same manner as in Examples 1 and 2 and Comparative Example 1 except for changing the thickness of the resist film to 0.25 µm. The obtained resist film was planarly exposed with EUV light (wavelength: 13 nm) while changing the exposure amount in 0.5-mJ steps from 0 to 5.0 mJ and baked at 110°C for 90 seconds. Thereafter, the dissolution rate at each exposure amount was measured by using an aqueous 2.38% tetramethylammonium hydroxide (TMAH) solution, and a sensitivity curve was obtained from the measured values. On the sensitivity curve, the exposure amount when the dissolution rate of resist was saturated was defined as the sensitivity. Also, the dissolution contrast (γ value) was calculated from the gradient in the straight line part of the sensitivity curve. As the γ value is larger, the dissolution contrast is better.

The results are shown in Table 3.

**Table 3**

| | Composition | Sensitivity (mJ/cm²) | γ Value | Outgas |
|---|---|---|---|---|
| Example 54 | same as in Example 1 | 3.0 | 10.0 | 96 |
| Example 55 | same as in Example 2 | 2.0 | 9.5 | 96 |
| Comparative Example 16 | same as in Comparative Example 1 | >5.0 | 70 | 73 |

It is seen from Table 3 that in the characteristic evaluation by irradiation of EUV light, the positive resist composition of the present invention is excellent with high sensitivity and reduced outgas in comparison to the composition of Comparative Example.

According to the present invention, a resist composition excellent in the sensitivity and resolving power and reduced in the outgas and surface roughness can be provided.

The entire disclosure of each and every foreign patent application from which the benefit of foreign priority has been claimed in the present application is incorporated herein by reference, as if fully set forth.

## Claims

1. A resist composition comprising (A) an acid generator represented by formula (1): 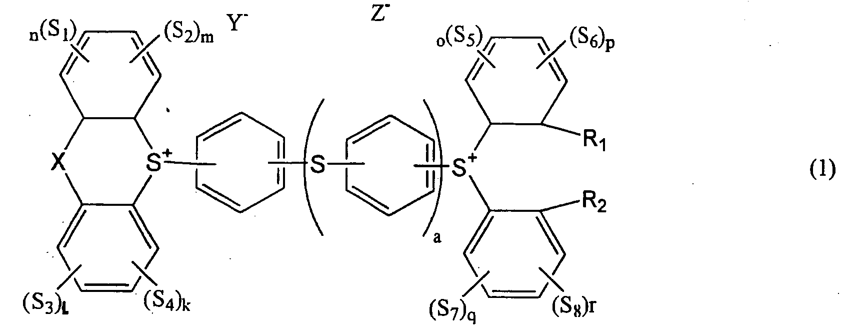 wherein S₁ to S₈ each independently represents a substituent;
a, n, m, I, k, o, p, q and r each independently represents an integer of 0 to 2;
X represents a single bond or a divalent linking group;
R₁ and R₂ each independently represents a hydrogen atom or a substituent, and R₁ and R₂ may combine with each other to represent a single bond or a divalent linking group; and
Y⁻ and Z⁻ each independently represents an organic sulfonate anion.

2. The resist composition according to claim 1, which is a positive resist composition, and the resist composition further comprising (BP) a polymer which is insoluble or sparingly soluble in an aqueous alkali solution but becomes soluble in an aqueous alkali solution under an action of an acid.

3. The resist composition according to claim 1, which is a negative resist composition, and the resist composition further comprising: (BN) an alkali-soluble resin; and (C) a crosslinking agent capable of crosslinking by an effect of an acid.

4. The resist composition according to claim 1, further comprising (A2) a compound having a structure represented by one of formulae (I) to (III), which generates an acid upon irradiation with one of an actinic ray and radiation: 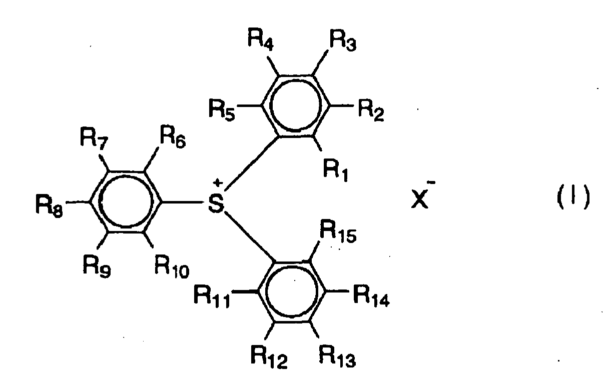 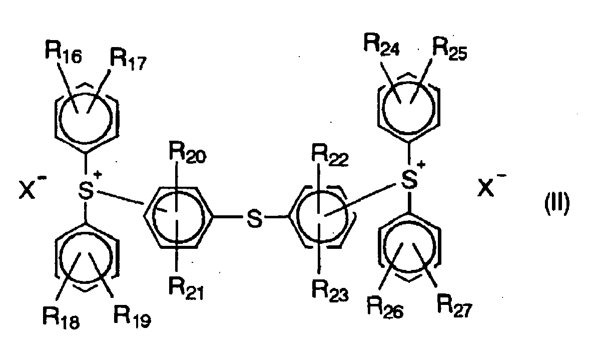 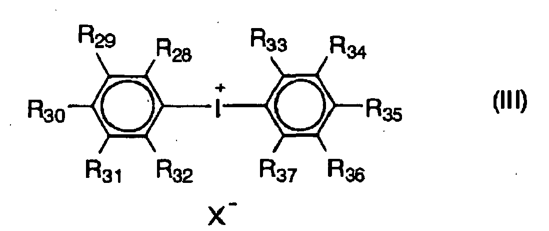 wherein R₁ to R₃₇, which may be the same or different, each independently represents a hydrogen atom, an alkyl group, an alkoxy group, a hydroxyl group, a halogen atom or an -S-R₃₈ group, and wherein R₃₈ represents an alkyl group or an aryl group; and
X⁻ represents an alkylsulfonate, a benzenesulfonate, a naphthalenesulfonate or an anthracenesulfonate anion each having at least one selected from the group consisting of
at least one fluorine atom,
an alkyl group substituted with at least one fluorine atom,
an alkoxy group substituted with at least one fluorine atom,
an acyl group substituted with at least one fluorine atom,
an acyloxy group substituted with at least one fluorine atom,
a sulfonyl group substituted with at least one fluorine atom,
a sulfonyloxy group substituted with at least one fluorine atom,
a sulfonylamino group substituted with at least one fluorine atom,
an aryl group substituted with at least one fluorine atom,
an aralkyl group substituted with at least one fluorine atom, and
an alkoxycarbonyl group substituted with at least one fluorine atom.

5. The resist composition according to claim 2, further comprising at least one of (A3) a compound capable of generating a fluorine-containing carboxylic acid upon irradiation with one of an actinic ray and radiation and (A4) a compound capable of generating a fluorine-free carboxylic acid upon irradiation with one of an actinic ray and radiation.

6. The resist composition according to claim 3, further comprising at least one of (A3) a compound capable of generating a fluorine-containing carboxylic acid upon irradiation with one of an actinic ray and radiation and (A4) a compound capable of generating a fluorine-free carboxylic acid upon irradiation with one of an actinic ray and radiation.

7. The resist composition according to claim 4, further comprising at least one of (A3) a compound capable of generating a fluorine-containing carboxylic acid upon irradiation with one of an actinic ray and radiation and (A4) a compound capable of generating a fluorine-free carboxylic acid upon irradiation with one of an actinic ray and radiation.

8. The resist composition according to claim 1, which is utilized with an electron beam, EUV or an X-ray.

9. A pattern forming method comprising:
forming a resist film from a resist composition according to claim 1; and
exposing and developing the resist film.
